(19) Europäisches Patentamt
European Patent Office
Office européen des brevets

(11) **EP 4 583 676 A1**

(12) **EUROPEAN PATENT APPLICATION**
published in accordance with Art. 153(4) EPC

(43) Date of publication:
**09.07.2025 Bulletin 2025/28**

(21) Application number: **23953271.6**

(22) Date of filing: **31.10.2023**

(51) International Patent Classification (IPC):
*H10K 59/121* (2023.01)   *H10K 59/50* (2023.01)
*H10K 59/80* (2023.01)   *G09F 9/33* (2006.01)

(86) International application number:
**PCT/CN2023/128430**

(87) International publication number:
**WO 2025/091234 (08.05.2025 Gazette 2025/19)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **BOE TECHNOLOGY GROUP CO., LTD.
Beijing 100015 (CN)**

(72) Inventors:
• ZHANG, Hao
**Beijing 100176 (CN)**
• HSIEH, Mingche
**Beijing 100176 (CN)**
• LIU, Libin
**Beijing 100176 (CN)**

(74) Representative: **Durán-Corretjer, S.L.P.
Còrsega, 329
(Paseo de Gracia/Diagonal)
08037 Barcelona (ES)**

(54) **DISPLAY SUBSTRATE AND DISPLAY APPARATUS**

(57)     Disclosed are a display substrate and a display apparatus. The display substrate includes a base substrate (100) and pixel units (P) arranged in an array provided on the base substrate (100). At least one pixel unit (P) includes a plurality of sub-pixels, and the plurality of sub-pixels include at least one peep-proof sub-pixel and at least one shared sub-pixel. At least one sub-pixel includes a pixel drive circuit and a light emitting device, and the pixel drive circuit is configured to drive the light emitting device to emit light. A display mode of the display substrate includes a first display mode and a second display mode, and a viewing angle range of the first display mode is smaller than a viewing angle range of the second display mode. In a state in which the display mode of the display substrate is the first display mode, the peep-proof sub-pixel emits light; and in a state in which the display mode of the display substrate is the second display mode, the shared sub-pixel emits light, or the peep-proof sub-pixel and the shared sub-pixel emit light.

P   VP1  VP2  VP3  SP1  SP2  SP3

FIG. 2

EP 4 583 676 A1

**Description**

Technical Field

The present disclosure relates to, but is not limited to, the field of display technologies, and more particularly, to a display substrate and a display apparatus.

Background

An Organic Light Emitting Diode (OLED for short) and a Quantum dot Light Emitting Diode (QLED for short) are active light emitting display devices and have advantages such as self-luminescence, a wide viewing angle, a high contrast ratio, low power consumption, an extremely high response speed, lightness and thinness, flexibility, and a low cost. With constant development of display technologies, a flexible display apparatus (Flexible Display) in which an OLED or a QLED is used as a light emitting device and signal control is performed through a Thin Film Transistor (TFT for short) has become a mainstream product in the field of display at present.

Summary

The following is a summary of subject matters described herein in detail. The summary is not intended to limit the protection scope of claims.

In a first aspect, the present disclosure provides a display substrate, including a base substrate and pixel units arranged in an array provided on the base substrate. At least one pixel unit includes a plurality of sub-pixels, and the plurality of sub-pixels include at least one peep-proof sub-pixel and at least one shared sub-pixel. At least one sub-pixel includes a pixel drive circuit and a light emitting device, and the pixel drive circuit is configured to drive the light emitting device to emit light. A display mode of the display substrate includes a first display mode and a second display mode, and a viewing angle range of the first display mode is smaller than a viewing angle range of the second display mode.

In a state in which the display mode of the display substrate is the first display mode, the peep-proof sub-pixel emits light; and in a state in which the display mode of the display substrate is the second display mode, the shared sub-pixel emits light, or the peep-proof sub-pixel and the shared sub-pixel emit light.

In an exemplary implementation mode, the plurality of sub-pixels in the at least one pixel unit include a first sub-pixel to a sixth sub-pixel.

A pixel drive circuit in the first sub-pixel to a pixel drive circuit in the sixth sub-pixel located in a same pixel unit are arranged in an array along a first direction and a second direction, or are arranged along a first direction, the first sub-pixel and the second sub-pixel emit light of a first color, the third sub-pixel and the fourth sub-pixel emit light of a second color, the fifth sub-pixel and the sixth sub-pixel emit a light of a third color, and the first direction intersects with the second direction.

One sub-pixel of the first sub-pixel and the second sub-pixel is a peep-proof sub-pixel, and the other sub-pixel of the first sub-pixel and the second sub-pixel is a shared sub-pixel; one sub-pixel of the third sub-pixel and the fourth sub-pixel is a peep-proof sub-pixel, and the other sub-pixel of the third sub-pixel and the fourth sub-pixel is a shared sub-pixel; and one sub-pixel of the fifth sub-pixel and the sixth sub-pixel is a peep-proof sub-pixel, and the other sub-pixel of the fifth sub-pixel and the sixth sub-pixel is a shared sub-pixel.

In an exemplary implementation mode, the light emitting device includes a first electrode. The display substrate is further provided with a pixel definition layer, and the pixel definition layer is provided with a pixel opening that exposes the first electrode.

For a peep-proof sub-pixel and a shared sub-pixel emitting light of a same color, an area of a first electrode in the peep-proof sub-pixel is equal to an area of a first electrode in the shared sub-pixel, and an area of a pixel opening that exposes the first electrode of the peep-proof sub-pixel is smaller than an area of a pixel opening that exposes the first electrode of the shared sub-pixel.

The pixel opening that exposes the first electrode of the peep-proof sub-pixel includes at least two sub-pixel openings, and the at least two sub-pixel openings are arranged along a first direction.

In an exemplary implementation mode, the light emitting device includes a first electrode.

For at least one pixel unit, a light emitting device of the first sub-pixel, a light emitting device of the second sub-pixel, a light emitting device of the third sub-pixel, and a light emitting device of the fourth sub-pixel are arranged along the second direction; a light emitting device of the fifth sub-pixel and a light emitting device of the sixth sub-pixel are arranged along the second direction; the light emitting device of the third sub-pixel and the light emitting device of the fifth sub-pixel are arranged along the first direction; and the light emitting device of the fourth sub-pixel and the light emitting device of the sixth sub-pixel are arranged along the first direction.

An area of a first electrode of the fifth sub-pixel and an area of a first electrode of the sixth sub-pixel are greater than an area of a first electrode of the third sub-pixel and an area of a first electrode of the fourth sub-pixel; and the area of the first electrode of the third sub-pixel and the area of the first electrode of the fourth sub-pixel are greater than an area of a first electrode of the first sub-pixel and an area of a first electrode of the second sub-pixel.

In an exemplary implementation mode, the display substrate further includes a drive structure layer, a light emitting structure layer, an encapsulation layer, and an optical structure layer sequentially stacked on the base substrate. The pixel drive circuit is provided on the drive structure layer, the light emitting device is provided on the light emitting structure layer, and the optical structure layer includes at least one of a light shielding structure layer and an optical device layer.

The optical device layer is located on a side of the light shielding structure layer close to the base substrate or away from the base substrate.

In an exemplary implementation mode, the light shielding structure layer includes a first light shielding layer, a light shielding base substrate layer, and a second light shielding layer. The first light shielding layer is located on a side of the light shielding base substrate layer close to the base substrate, and the second light shielding layer is located on a side of the light shielding base substrate layer away from the base substrate. The first light shielding layer includes a plurality of first light shielding structures, and the second light shielding layer includes a plurality of second light shielding structures. The light emitting structure layer includes an organic emitting layer of a light emitting device of at least one sub-pixel.

An orthographic projection of the first light shielding layer on the base substrate is at least partially overlapped with an orthographic projection of the second light shielding layer on the base substrate. The first light shielding structures and the second light shielding structures are located in a peep-proof sub-pixel region, and orthographic projections of the first light shielding structures and the second light shielding structures on the base substrate are partially overlapped with an orthographic projection of an organic emitting layer of at least one peep-proof sub-pixel on the base substrate. The peep-proof sub-pixel region is a region where the peep-proof sub-pixel is located.

In an exemplary implementation mode, the optical device layer includes an optical base substrate layer and a plurality of optical devices. The optical devices are located on a side of the optical base substrate layer close to or away from the base substrate, and configured to converge incident light. The light emitting structure layer includes an organic emitting layer of a light emitting device of at least one sub-pixel.

Orthographic projections of the optical devices on the base substrate are at least partially overlapped with an orthographic projection of an organic emitting layer of the peep-proof sub-pixel on the base substrate.

In an exemplary implementation mode, the display substrate further includes a plurality of signal lines and a plurality of anode connection lines. The pixel drive circuit is electrically connected with the plurality of signal lines and the plurality of anode connection lines, respectively.

In an exemplary implementation mode, the drive structure layer includes a semiconductor layer, a first conductive layer, a second conductive layer, a third conductive layer, a fourth conductive layer, and a fifth conductive layer sequentially stacked on the base substrate. The pixel drive circuit includes at least one transistor and at least one capacitor. The transistor includes an active pattern, a gate electrode, a first electrode, and a second electrode, and the capacitor includes a first electrode plate and a second electrode plate.

The semiconductor layer at least includes an active pattern of at least one transistor located in at least one sub-pixel.

The first conductive layer at least includes at least one signal line of the plurality of signal lines, and a gate electrode of at least one transistor and a first electrode plate of at least one capacitor located in at least one sub-pixel.

The second conductive layer at least includes at least one signal line of the plurality of signal lines, and a second electrode plate of at least one capacitor located in at least one sub-pixel.

The third conductive layer at least includes at least one signal line of the plurality of signal lines, and a first electrode and a second electrode of at least one transistor located in at least one sub-pixel.

The fourth conductive layer at least includes at least one signal line of the plurality of signal lines.

The fifth conductive layer at least includes at least one anode connection line of the plurality of anode connection lines.

In an exemplary implementation mode, for at least one pixel unit, the pixel drive circuit of the first sub-pixel, the pixel drive circuit of the third sub-pixel, and the pixel drive circuit of the fifth sub-pixel are arranged sequentially along the first direction; the pixel drive circuit of the second sub-pixel, the pixel drive circuit of the fourth sub-pixel, and the pixel drive circuit of the sixth sub-pixel are arranged sequentially along the first direction; the pixel drive circuit of the first sub-pixel and the pixel drive circuit of the second sub-pixel are arranged along the second direction; the pixel drive circuit of the third sub-pixel and the pixel drive circuit of the fourth sub-pixel are arranged along the second direction; and the pixel drive circuit of the fifth sub-pixel and the pixel drive circuit of the sixth sub-pixel are arranged along the second direction.

In an exemplary implementation mode, the plurality of signal lines include 2M reset signal lines, 2M scan signal lines, 2M light emitting signal lines, 2M first initial signal lines, 2M second initial signal lines, 3N first power supply lines, and 3N data signal lines, wherein M is a total number of rows of pixel units, N is a total number of columns of pixel units.

At least one signal line of the reset signal lines, the scan signal lines, the light emitting signal lines, the first initial signal lines, and the second initial signal lines extends at least partially along the first direction; at least one signal line of the first power supply lines and the data signal lines extends at least partially along the second direction; and line widths of the first power supply lines are greater than line widths of the data signal lines.

A pixel unit in an i-th row and a j-th column is electrically connected with a (2i-1)-th scan signal line, a 2i-th scan signal line, a (2i-1)-th reset signal line, a 2i-th reset signal line, a (2i-1)-th light emitting signal line, a 2i-th light emitting signal line, a (2i-1)-th first initial signal line, a 2i-th first initial signal line, a (2i-1)-th second initial signal line, a 2i-th second initial signal line, a (3j-2)-th first power supply line, a (3j-1)-th first power supply line, a 3j-th first power supply line, a (3j-2)-th data signal line, a (3j-1)-th data signal line, and a 3j-th data signal line, respectively, wherein $1 \leq i \leq M$ and $1 \leq j \leq N$.

In an exemplary implementation mode, for at least one pixel unit, pixel structures of pixel drive circuits of at least two sub-pixels of the first sub-pixel to the sixth sub-pixel are at least partially the same.

In an exemplary implementation mode, in the pixel unit in the i-th row and the j-th column, at least one sub-pixel of the first sub-pixel, the third sub-pixel, and the fifth sub-pixel is electrically connected with the (2i-1)-th scan signal line, the (2i-1)-th light emitting signal line, the (2i-1)-th reset signal line, the (2i-1)-th first initial signal line, and the (2i-1)-th second initial signal line, respectively; at least one sub-pixel of the second sub-pixel, the fourth sub-pixel, and the sixth sub-pixel is electrically connected with the 2i-th scan signal line, the 2i-th light emitting signal line, the 2i-th reset signal line, the 2i-th first initial signal line, and the 2i-th second initial signal line, respectively; at least one sub-pixel of the first sub-pixel and the second sub-pixel is further electrically connected with the (3j-2)-th first power supply line and the (3j-2)-th data signal line, respectively; at least one sub-pixel of the third sub-pixel and the fourth sub-pixel is further electrically connected with the (3j-1)-th first power supply line and the (3j-1)-th data signal line, respectively; and at least one sub-pixel of the fifth sub-pixel and the sixth sub-pixel is further electrically connected with the 3j-th first power supply line and the 3j-th data signal line, respectively.

In an exemplary implementation mode, orthographic projections of a first initial signal line, a second initial signal line, a reset signal line, a scan signal line, and a light emitting signal line connected with a same sub-pixel on the base substrate are sequentially arranged along the second direction.

An orthographic projection of a k-th data signal line on the base substrate is located between an orthographic projection of a k-th first power supply line on the base substrate and an orthographic projection of a (k+1)-th first power supply line on the base substrate, wherein $1 \leq k \leq 3N$.

In an exemplary implementation mode, the at least one transistor includes a node reset transistor, a drive transistor, and a compensation transistor; and a second electrode of the node reset transistor and a first electrode of the compensation transistor are of an integral structure and are electrically connected with a gate electrode of the drive transistor.

An orthographic projection of a first power supply line on the base substrate is at least partially overlapped with an orthographic projection of the integral structure of the second electrode of the node reset transistor and the first electrode of the compensation transistor in a sub-pixel connected with the first power supply line on the base substrate.

In an exemplary implementation mode, a first power supply line includes a first sub-power supply line and a second sub-power supply line connected with each other. The first sub-power supply line and the second sub-power supply line extend along the second direction, and an orthographic projection of the first sub-power supply line on the base substrate is at least partially overlapped with an orthographic projection of the second sub-power supply line on the base substrate.

The light emitting signal lines are located on the first conductive layer, the first initial signal lines and the second initial signal lines are located on the second conductive layer, the reset signal lines and the scan signal lines are located on the third conductive layer, the first sub-power supply line is located on the fourth conductive layer, the second sub-power supply line is located on the fifth conductive layer, and the data signal lines are located on the fourth conductive layer or the fifth conductive layer.

In an exemplary implementation mode, the plurality of signal lines include 2M reset signal lines, 2M scan signal lines, 2M light emitting signal lines, 2M first initial signal lines, 2M second initial signal lines, 4N first power supply lines, and 6N data signal lines, wherein M is a total number of rows of pixel units, and N is a total number of columns of pixel units.

At least one signal line of the reset signal lines, the scan signal lines, the light emitting signal lines, the first initial signal lines, and the second initial signal lines extends at least partially along the first direction, and at least one signal line of the first power supply lines and the data signal lines extends at least partially along the second direction.

A pixel unit in an i-th row and a j-th column is electrically connected with a (2i-1)-th scan signal line, a 2i-th scan signal line, a (2i-1)-th reset signal line, a 2i-th reset signal line, a (2i-1)-th light emitting signal line, a 2i-th light emitting signal line, a (2i-1)-th first initial signal line, a 2i-th first initial signal line, a (2i-1)-th second initial signal line, a 2i-th second initial signal line, a (4j-3)-th first power supply line, a (4j-2)-th first power supply line, a (4j-1)-th first power supply line, a 4j-th first power supply line, a (6j-5)-th data signal line, a (6j-4)-th data signal line, a (6j-3)-th data signal line, a (6j-2)-th data signal line, a (6j-1)-th data signal line, and a 6j-th data signal line, respectively, wherein $1 \leq i \leq M$ and $1 \leq j \leq N$.

In an exemplary implementation mode, for at least one pixel unit, pixel structures of pixel drive circuits of at least two sub-pixels of the first sub-pixel, the third sub-pixel, and the fifth sub-pixel are at least partially the same; pixel structures of pixel drive circuits of at least two sub-pixels of the second sub-pixel, the fourth sub-pixel, and the sixth sub-pixel are at least partially the same; and a pixel structure of the pixel drive circuit of the first sub-pixel is at least partially mirror symmetrical to a pixel structure of the pixel drive circuit of the second sub-pixel.

In an exemplary implementation mode, in the pixel unit in the i-th row and the j-th column, at least one sub-pixel of the first sub-pixel, the third sub-pixel, and the fifth sub-pixel is electrically connected with the (2i-1)-th scan signal line, the (2i-1)-th light emitting signal line, the (2i-1)-th reset signal line, the (2i-1)-th first initial signal line, and the (2i-1)-th second initial signal line, respectively; at least one sub-pixel of the second sub-pixel, the fourth sub-pixel, and the sixth sub-pixel is electrically connected with the 2i-th scan signal line, the 2i-th light emitting signal line, the 2i-th reset signal line, the 2i-th first initial signal line, and the 2i-th second initial signal line, respectively; the first sub-pixel is further electrically connected with the (6j-4)-th data signal line and the (4j-2)-th first power supply line; the second sub-pixel is further electrically connected with the (6j-5)-th data signal line and the (4j-3)-th first power supply line; the third sub-pixel is further electrically connected with the (6j-2)-th data signal line and the (4j-1)-th first power supply line, respectively; the fourth sub-pixel is further electrically connected with the (6j-3)-th data signal line and the (4j-2)-th first power supply line, respectively; the fifth sub-pixel is further electrically connected with the 6j-th data signal line and the 4j-th first power supply line, respectively; and the sixth sub-pixel is further electrically connected with the (6j-1)-th data signal line and the (4j-1)-th first power supply line, respectively.

In an exemplary implementation mode, orthographic projections of a first initial signal line, a second initial signal line, a reset signal line, a scan signal line, and a light emitting signal line connected with a same sub-pixel on the base substrate are sequentially arranged along the second direction.

For at least one pixel unit, orthographic projections of two data signal lines connected with two sub-pixels arranged along the second direction on the base substrate are located between orthographic projections of two first power supply lines connected with the two sub-pixels on the base substrate.

In an exemplary implementation mode, the at least one transistor includes a node reset transistor, a drive transistor, and a compensation transistor. A second electrode of the node reset transistor and a first electrode of the compensation transistor are of an integral structure and are electrically connected with a gate electrode of the drive transistor. The capacitor further includes a third electrode plate, the third electrode plate is electrically connected with the second electrode plate and located on the fourth conductive layer.

For at least one sub-pixel, an orthographic projection of the third electrode plate on the base substrate is at least partially overlapped with an orthographic projection of the integral structure of the second electrode of the node reset transistor and the first electrode of the compensation transistor on the base substrate.

Orthographic projections of third electrode plates of two sub-pixels arranged along the second direction on the base substrate are located between orthographic projections of two data signal lines connected with the two sub-pixels arranged along the second direction on the base substrate.

In an exemplary implementation mode, the light emitting signal lines are located on the first conductive layer, the first initial signal lines and the second initial signal lines are located on the second conductive layer, the reset signal lines and the scan signal lines are located on the third conductive layer, and the data signal lines and the first power supply lines are located on the fourth conductive layer.

In an exemplary implementation mode, for at least one pixel unit, the pixel drive circuit of the first sub-pixel, the pixel drive circuit of the second sub-pixel, the pixel drive circuit of the third sub-pixel, the pixel drive circuit of the fourth sub-pixel, the pixel drive circuit of the fifth sub-pixel, and the pixel drive circuit of the sixth sub-pixel are sequentially arranged along the first direction.

In an exemplary implementation mode, the plurality of signal lines include 2M reset signal lines, 2M scan signal lines, 2M light emitting signal lines, M first initial signal lines, M second initial signal lines, 4N first power supply lines, and 6N data signal lines, wherein M is a total number of rows of pixel units, and N is a total number of columns of pixel units.

At least one signal line of the reset signal lines, the scan signal lines, the light emitting signal lines, the first initial signal lines, and the second initial signal lines extends at least partially along the first direction, and at least one signal line of the first power supply lines and the data signal lines extends at least partially along the second direction.

A pixel unit in an i-th row and a j-th column is electrically connected with a (2i-1)-th scan signal line, a 2i-th scan signal line, a (2i-1)-th reset signal line, a 2i-th reset signal line, a (2i-1)-th light emitting signal line, a 2i-th light emitting signal line, an i-th first initial signal line, an i-th second initial signal line, a (4j-3)-th first power supply line, a (4j-2)-th first power supply line, a (4j-1)-th first power supply line, a 4j-th first power supply line, a (6j-5)-th data signal line, a (6j-4)-th data signal line, a (6j-3)-th data signal line, a (6j-2)-th data signal line, a (6j-1)-th data signal line, and a 6j-th data signal line, respectively, wherein 1≤i≤M and 1≤j≤N.

In an exemplary implementation mode, for at least one pixel unit, pixel structures of pixel drive circuits of adjacent sub-pixels are at least partially symmetrical with respect to a virtual straight line extending along the second direction.

In an exemplary implementation mode, in the pixel unit in the i-th row and the j-th column, at least one sub-pixel of the first sub-pixel to the sixth sub-pixel is electrically connected with the (2i-1)-th scan signal line, the 2i-th scan signal line, the (2i-1)-th reset signal line, the 2i-th reset signal line, the (2i-1)-th light emitting signal line, the 2i-th light emitting signal line, the i-th first initial signal line, and the i-th second initial signal line, respectively; the first sub-pixel is further electrically connected with the (6j-5)-th data signal line and the (4j-3)-th first power supply line, respectively; the second sub-pixel is further electrically connected with the (6j-4)-th data signal line and the (4j-2)-th first power supply line, respectively; the third sub-pixel is further electrically connected with the (6j-3)-th data signal line and the (4j-2)-th first power supply line, respectively; the fourth sub-pixel is further electrically connected with the (6j-2)-th data signal line and the (4j-1)-th first power supply line, respectively; the fifth sub-pixel is further electrically connected with the (6j-1)-th data signal line and the (4j-1)-th first power supply line, respectively; and the sixth sub-pixel is further electrically connected with the 6j-th data signal line and the 4j-th first power supply line, respectively.

In an exemplary implementation mode, the at least one transistor includes a first light emitting transistor, a second light emitting transistor, a node reset transistor, an anode reset transistor, a writing transistor, a compensation transistor, and a drive transistor.

The first light emitting transistor and the writing transistor are respectively electrically connected with a first electrode of the drive transistor; the second light emitting transistor is respectively electrically connected with a second electrode of the drive transistor and a first electrode of the light emitting device; the anode reset transistor is electrically connected with the first electrode of the light emitting device; the compensation transistor is respectively electrically connected with a gate electrode and a second electrode of the drive transistor; and the node reset transistor is electrically connected with the gate electrode of the drive transistor.

For the pixel unit in the i-th row and the j-th column, a gate electrode of the first light emitting transistor in at least one sub-pixel is electrically connected with the (2i-1)-th light emitting signal line; a gate electrode of the second light emitting transistor is electrically connected with the 2i-th light emitting signal line; a gate electrode of the writing transistor is electrically connected with the (2i-1)-th scan signal line; a gate electrode of the compensation transistor is electrically connected with the 2i-th scan signal line, a gate electrode of the node reset transistor is electrically connected with the (2i-1)-th reset signal line; and a gate electrode of the anode reset transistor is electrically connected with the 2i-th reset signal line.

In an exemplary implementation mode, for a pixel unit in the i-th row, orthographic projections of the (2i-1)-th light emitting signal line, the (2i-1)-th scan signal line, the 2i-th scan signal line, the (2j-1)-th reset signal line, the i-th first initial signal line, the 2i-th light emitting signal line, the 2i-th reset signal line, and the i-th second initial signal line on the base substrate are sequentially arranged along the second direction.

For at least one pixel unit, orthographic projections of data signal lines connected with an x-th sub-pixel and an (x+1)-th sub-pixel on the base substrate are located between orthographic projections of first power supply lines connected with the x-th sub-pixel and the (x+1)-th sub-pixel on the base substrate, wherein $1 \leq x \leq 6$ and x is an odd number.

In an exemplary implementation mode, an odd-numbered scan signal line includes a first sub-scan signal line and a second sub-scan signal line connected with each other. The first sub-scan signal line and the second sub-scan signal line extend along the first direction, and an orthographic projection of the first sub-scan signal line on the base substrate is at least partially overlapped with an orthographic projection of the second sub-scan signal line on the base substrate.

The first sub-scan signal line is located on the first conductive layer, and the second sub-scan signal line is located on the third conductive layer.

In an exemplary implementation mode, an even-numbered reset signal line includes a first sub-reset signal line and a second sub-reset signal line connected with each other. The first sub-reset signal line and the second sub-reset signal line extend along the first direction, and an orthographic projection of the first sub-reset signal line on the base substrate is at least partially overlapped with an orthographic projection of the second sub-reset signal line on the base substrate.

The first sub-reset signal line is located on the first conductive layer, and the second sub-reset signal line is located on the third conductive layer.

In an exemplary implementation mode, the light emitting signal lines are located on the first conductive layer, the first initial signal lines and the second initial signal lines are located on the second conductive layer, an even-numbered scan signal line and an odd-numbered reset signal line are located on the third conductive layer, and the data signal lines and the first power supply lines are located on the fourth conductive layer.

In an exemplary implementation mode, the plurality of signal lines include a plurality of first initial signal lines and a plurality of second initial signal lines. The display substrate further includes at least one connection line of a first initial connection line and a second initial connection line.

The first initial connection line extends along the second direction and is located between adjacent pixel units, and the first initial connection line is electrically connected with the plurality of first initial signal lines.

The second initial connection line extends along the second direction and is located between adjacent pixel units, and the second initial connection line is electrically connected with the plurality of second initial signal lines.

The first initial connection line and the second initial connection line are located on the fourth conductive layer or the fifth conductive layer.

In an exemplary implementation mode, the display substrate further includes a first multiplexing control signal line, a second multiplexing control signal line, 6N data signal lines, 3N data electrical power supply lines, and a data multiplexing circuit. The data multiplexing circuit includes N sub-multiplexing circuits, wherein N is a total number of columns of pixel units.

An n-th sub-multiplexing circuit is electrically connected with three data electrical power supply lines, the first multiplexing control signal line, the second multiplexing control signal line, and six data signal lines connected with a pixel unit in an n-th column, respectively, and is configured to provide a signal of at least one data electrical power supply line to at least one data signal line under signal control of the first multiplexing control signal line and the second multiplexing control signal line, wherein $1 \leq n \leq N$.

In an exemplary implementation mode, the n-th sub-multiplexing circuit includes a first multiplexing transistor to a sixth multiplexing transistor.

A gate electrode of the first multiplexing transistor is electrically connected with the first multiplexing control signal line, a first electrode of the first multiplexing transistor is electrically connected with a data signal line connected with one sub-pixel of a first sub-pixel and a second sub-pixel in the pixel unit in the n-th column, and a second electrode of the first multiplexing transistor is electrically connected with a first data electrical power supply line of the three data electrical power supply lines connected with the n-th multiplexing sub-circuit.

A gate electrode of the second multiplexing transistor is electrically connected with the first multiplexing control signal line, a first electrode of the second multiplexing transistor is electrically connected with a data signal line connected with one of a third sub-pixel and a fourth sub-pixel in the pixel unit in the n-th column, and a second electrode of the second multiplexing transistor is electrically connected with a second data electrical power supply line of the three data electrical power supply lines connected with the n-th multiplexing sub-circuit.

A gate electrode of the third multiplexing transistor is electrically connected with the first multiplexing control signal line, a first electrode of the third multiplexing transistor is electrically connected with a data signal line connected with one of a fifth sub-pixel and a sixth sub-pixel in the pixel unit in the n-th column, and a second electrode of the third multiplexing transistor is electrically connected with a third data electrical power supply line of the three data electrical power supply lines connected with the n-th multiplexing sub-circuit.

A gate electrode of the fourth multiplexing transistor is electrically connected with the second multiplexing control signal line, a first electrode of the fourth multiplexing transistor is electrically connected with a data signal line connected with the other sub-pixel of the first sub-pixel and the second sub-pixel in the pixel unit in the n-th column, and a second electrode of the fourth multiplexing transistor is electrically connected with the first data electrical power supply line of the three data electrical power supply lines connected with the n-th multiplexing sub-circuit.

A gate electrode of the fifth multiplexing transistor is electrically connected with the second multiplexing control signal line, a first electrode of the fifth multiplexing transistor is electrically connected with a data signal line connected with the other sub-pixel of the third sub-pixel and the fourth sub-pixel in the pixel unit in the n-th column, and a second electrode of the fifth multiplexing transistor is electrically connected with the second data electrical power supply line of the three data electrical power supply lines connected with the n-th multiplexing sub-circuit.

A gate electrode of the sixth multiplexing transistor is electrically connected with the second multiplexing control signal line, a first electrode of the sixth multiplexing transistor is electrically connected with a data signal line connected with the other sub-pixel of the fifth sub-pixel and the sixth sub-pixel in the pixel unit in the n-th column, and a second electrode of the sixth multiplexing transistor is electrically connected with the third data electrical power supply line of the three data electrical power supply lines connected with the n-th multiplexing sub-circuit.

In a second aspect, the present disclosure further provides a display apparatus, including the display substrate described above.

Other aspects may be comprehended after drawings and detailed description are read and understood.

Brief Description of Drawings

Accompany drawings are used to provide understanding of technical solutions of the present disclosure, and form a part of the specification. The accompany drawings and embodiments of the present disclosure are adopted to explain the technical solutions of the present disclosure, and do not form limitations on the technical solution of the present disclosure.

FIG. 1A is a schematic diagram of a structure of a display apparatus.
FIG. 1B is a schematic diagram of an equivalent circuit of a pixel drive circuit.
FIG. 1C is a working timing diagram of a pixel drive circuit.
FIG. 2 is a schematic diagram of a structure of a display substrate provided by an embodiment of the present disclosure.
FIG. 3 is a first schematic diagram of a structure of a display substrate provided by an embodiment of the present disclosure.
FIG. 4 is a schematic diagram of a portion of film layers in FIG. 3.

FIG. 5 is a second schematic diagram of a structure of a display substrate provided by an embodiment of the present disclosure.

FIG. 6 is a schematic diagram of a portion of film layers in FIG. 5.

FIG. 7 is a third schematic diagram of a structure of a display substrate provided by an embodiment of the present disclosure.

FIG. 8 is a schematic diagram of a portion of film layers in FIG. 7.

FIG. 9 is a fourth schematic diagram of a structure of a display substrate provided by an embodiment of the present disclosure.

FIG. 10 is a schematic diagram of a portion of film layers in FIG. 9.

FIG. 11A is a schematic diagram of a structure of a display substrate provided by an exemplary implementation mode.

FIG. 11B is a schematic diagram of a structure of a display substrate provided by another exemplary implementation mode.

FIG. 12A is a schematic diagram of a structure of a data multiplexing circuit in a display substrate.

FIG. 12B is an equivalent circuit diagram of a sub-multiplexing circuit.

FIG. 13 is a schematic diagram of a pattern of a semiconductor layer in the display substrate provided in FIGs. 3 and 5.

FIG. 14 is a schematic diagram of a pattern of a semiconductor layer in the display substrate provided in FIG. 7.

FIG. 15 is a schematic diagram of a pattern of a semiconductor layer in the display substrate provided in FIG. 9.

FIG. 16 is a schematic diagram of a pattern of a first conductive layer in the display substrate provided in FIGs. 3 and 5.

FIG. 17 is a schematic diagram of the display substrate provided in FIGs. 3 and 5 after a pattern of a first conductive layer is formed.

FIG. 18 is a schematic diagram of a pattern of a first conductive layer in the display substrate provided in FIG. 7.

FIG. 19 is a schematic diagram of the display substrate provided in FIG. 7 after a pattern of a first conductive layer is formed.

FIG. 20 is a schematic diagram of a pattern of a first conductive layer in the display substrate provided in FIG. 9.

FIG. 21 is a schematic diagram of the display substrate provided in FIG. 9 after a pattern of a first conductive layer is formed.

FIG. 22 is a schematic diagram of a pattern of a second conductive layer in the display substrate provided in FIGs. 3 and 5.

FIG. 23 is a schematic diagram of the display substrate provided in FIGs. 3 and 5 after a pattern of a second conductive layer is formed.

FIG. 24 is a schematic diagram of a pattern of a second conductive layer in the display substrate provided in FIG. 7.

FIG. 25 is a schematic diagram of the display substrate provided in FIG. 7 after a pattern of a second conductive layer is formed.

FIG. 26 is a schematic diagram of a pattern of a second conductive layer in the display substrate provided in FIG. 9.

FIG. 27 is a schematic diagram of the display substrate provided in FIG. 9 after a pattern of a second conductive layer is formed.

FIG. 28 is a schematic diagram of the display substrate provided in FIGs. 3 and 5 after a third insulation layer is formed.

FIG. 29 is a schematic diagram of the display substrate provided in FIG. 7 after a third insulation layer is formed.

FIG. 30 is a schematic diagram of the display substrate provided in FIG. 9 after a third insulation layer is formed.

FIG. 31 is a schematic diagram of a pattern of a second conductive layer in the display substrate provided in FIGs. 3 and 5.

FIG. 32 is a schematic diagram of the display substrate provided in FIGs. 3 and 5 after a pattern of a second conductive layer is formed.

FIG. 33 is a schematic diagram of a pattern of a second conductive layer in the display substrate provided in FIG. 7.

FIG. 34 is a schematic diagram of the display substrate provided in FIG. 7 after a pattern of a second conductive layer is formed.

FIG. 35 is a schematic diagram of a pattern of a second conductive layer in the display substrate provided in FIG. 9.

FIG. 36 is a schematic diagram of the display substrate provided in FIG. 9 after a pattern of a second conductive layer is formed.

FIG. 37 is a schematic diagram of the display substrate provided in FIGs. 3 and 5 after a first planarization layer is formed.

FIG. 38 is a schematic diagram of the display substrate provided in FIG. 7 after a first planarization layer is formed.

FIG. 39 is a schematic diagram of the display substrate provided in FIG. 9 after a first planarization layer is formed.

FIG. 40 is a schematic diagram of a pattern of a fourth conductive layer in the display substrate provided in FIG. 3.

FIG. 41 is a schematic diagram of the display substrate provided in FIG. 3 after a pattern of a fourth conductive layer is formed.

FIG. 42 is a schematic diagram of a pattern of a fourth conductive layer in the display substrate provided in FIG. 5.

FIG. 43 is a schematic diagram of the display substrate provided in FIG. 5 after a pattern of a fourth conductive layer is formed.

FIG. 44 is a schematic diagram of a pattern of a fourth conductive layer in the display substrate provided in FIG. 7.

FIG. 45 is a schematic diagram of the display substrate provided in FIG. 7 after a pattern of a fourth conductive layer is formed.

FIG. 46 is a schematic diagram of a pattern of a fourth conductive layer in the display substrate provided in FIG. 9.

FIG. 47 is a schematic diagram of the display substrate provided in FIG. 9 after a pattern of a fourth conductive layer is formed.

FIG. 48 is a schematic diagram of the display substrate provided in FIG. 3 after a second planarization layer is formed.

FIG. 49 is a schematic diagram of the display substrate provided in FIG. 5 after a second planarization layer is formed.

FIG. 50 is a schematic diagram of the display substrate provided in FIG. 7 after a second planarization layer is formed.

FIG. 51 is a schematic diagram of the display substrate provided in FIG. 9 after a second planarization layer is formed.

FIG. 52 is a schematic diagram of a pattern of a fifth conductive layer in the display substrate provided in FIG. 3.

FIG. 53 is a schematic diagram of the display substrate provided in FIG. 3 after a pattern of a fifth conductive layer is formed.

FIG. 54 is a schematic diagram of a pattern of a fifth conductive layer in the display substrate provided in FIG. 5.

FIG. 55 is a schematic diagram of the display substrate provided in FIG. 5 after a pattern of a fifth conductive layer is formed.

FIG. 56 is a schematic diagram of a pattern of a fifth conductive layer in the display substrate provided in FIG. 7.

FIG. 57 is a schematic diagram of the display substrate provided in FIG. 7 after a pattern of a fifth conductive layer is formed.

FIG. 58 is a schematic diagram of a pattern of a fifth conductive layer in the display substrate provided in FIG. 9.

FIG. 59 is a schematic diagram of the display substrate provided in FIG. 9 after a pattern of a fifth conductive layer is formed.

FIG. 60 is a schematic diagram of the display substrate provided in FIG. 3 after a third planarization layer is formed.

FIG. 61 is a schematic diagram of the display substrate provided in FIG. 5 after a third planarization layer is formed.

FIG. 62 is a schematic diagram of the display substrate provided in FIG. 7 after a third planarization layer is formed.

FIG. 63 is a schematic diagram of the display substrate provided in FIG. 9 after a third planarization layer is formed.

FIG. 64 is a schematic diagram of a pattern of a sixth conductive layer in the display substrate provided in FIGs. 3 and 5.

FIG. 65 is a schematic diagram of the display substrate provided in FIG. 3 after a pattern of a sixth conductive layer is formed.

FIG. 66 is a schematic diagram of the display substrate provided in FIG. 5 after a pattern of a sixth conductive layer is formed.

FIG. 67 is a schematic diagram of a pattern of a sixth conductive layer in the display substrate provided in FIG. 7.

FIG. 68 is a schematic diagram of the display substrate provided in FIG. 7 after a pattern of a sixth conductive layer is formed.

FIG. 69 is a schematic diagram of a pattern of a sixth conductive layer in the display substrate provided in FIG. 9.

FIG. 70 is a schematic diagram of the display substrate provided in FIG. 9 after a pattern of a sixth conductive layer is formed.

FIG. 71 is a schematic diagram of the display substrate provided in FIG. 3 after a pixel definition layer is formed.

FIG. 72 is a schematic diagram of the display substrate provided in FIG. 5 after a pixel definition layer is formed.

FIG. 73 is a schematic diagram of the display substrate provided in FIG. 7 after a pixel definition layer is formed.

FIG. 74 is a schematic diagram of the display substrate provided in FIG. 9 after a pixel definition layer is formed.

Detailed Description

To make objectives, technical solutions, and advantages of the present disclosure clearer, the embodiments of the present disclosure will be described in detail below with reference to the accompany drawings. It is to be noted that implementation modes may be implemented in multiple different forms. Those of ordinary skills in the art may easily understand such a fact that modes and contents may be transformed into various forms without departing from the purpose and scope of the present disclosure. Therefore, the present disclosure should not be explained as being limited to contents recorded in following implementation modes only. The embodiments and features in the embodiments of the present disclosure may be randomly combined with each other if there is no conflict. In order to keep following description of the embodiments of the present disclosure clear and concise, detailed description of part of known functions and known components are omitted in the present disclosure. The drawings in the embodiments of the present disclosure relate only to structures involved in the embodiments of the present disclosure, and other structures may be referred to conventional designs.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagrams only, and one mode of the present disclosure is not limited to shapes, numerical values, or the like shown in the drawings.

Ordinal numerals "first", "second", "third", etc., in the specification are set not to form limits in numbers but only to avoid confusion between constituent elements.

In the specification, for convenience, expressions "central", "above", "below", "front", "back", "vertical", "horizontal", "top", "bottom", "inside", "outside", etc., indicating directional or positional relationships are used to illustrate positional relationships between the constituent elements with reference to the drawings, not to indicate or imply that a referred apparatus or element must have a specific orientation and be structured and operated with the specific orientation but only to easily and simply describe the present specification, and thus should not be understood as limitations on the present disclosure. The positional relationships between the constituent elements may be changed as appropriate according to a direction according to which each constituent element is described. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be a fixed connection, or a detachable connection, or an integral connection; it may be a mechanical connection or an electrical connection; it may be a direct connection, or an indirect connection through middleware, or internal communication inside two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode" are interchangeable in the specification.

In the specification, an "electrical connection" includes a case that constituent elements are connected together through an element with a certain electrical action. An "element with a certain electrical action" is not particularly limited as long as electrical signals between the connected constituent elements may be sent and received. Examples of the "element with the certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive film" sometimes. Similarly, an "insulation film" may be replaced with an "insulation layer" sometimes.

In the specification, "disposed in a same layer" refers to a structure formed by patterning two (or more than two) structures through a same patterning process, and their materials may be the same or different. For example, materials of precursors for forming multiple structures disposed in a same layer are the same, and final materials may be the same or different.

A triangle, rectangle, trapezoid, pentagon, or hexagon, etc. in the specification is not strictly defined, and it may be an approximate triangle, rectangle, trapezoid, pentagon, or hexagon, etc. There may be some small deformations caused by tolerance, and there may be a chamfer, an arc edge, and deformation, etc.

In the present disclosure, "about" refers to that a boundary is not defined so strictly and numerical values within a range of process and measurement errors are allowed.

An "integral structure" in the embodiments of the present disclosure may refer to a structure formed by two (or more) structures which are connected with each other and formed through a same deposition process and are patterned through a same patterning process, and their materials may be the same or different.

With development of the society and enrichment of material conditions, while display devices provide people with many conveniences, privacy leakage is always inevitable, which cannot meet needs of users.

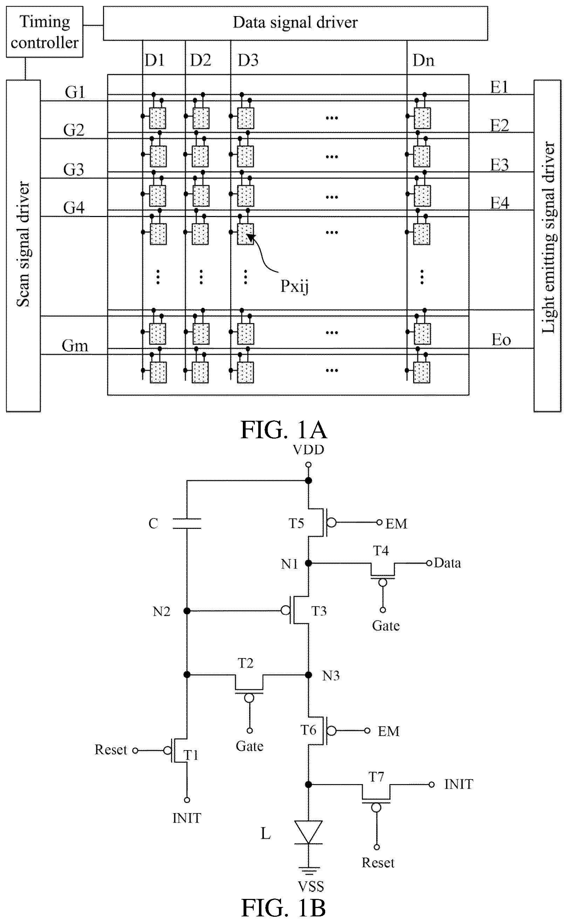

FIG. 1A is a schematic diagram of a structure of a display apparatus. As shown in FIG. 1A, the display apparatus may include a timing controller, a data signal driver, a scan signal driver, a light emitting signal driver, and a pixel array. The timing controller is connected with the data signal driver, the scan signal driver, and the light emitting signal driver, respectively. The data signal driver is connected with a plurality of data signal lines (D1 to Dn), respectively. The scan signal driver is connected with a plurality of scan signal lines (S1 to Sm), respectively. The light emitting signal driver is connected with a plurality of light emitting signal lines (E1 to Eo), respectively. The pixel array may include a plurality of sub-pixels Pxij, wherein i and j may be natural numbers. At least one sub-pixel Pxij may include a circuit unit and a light emitting device connected with the circuit unit. The circuit unit may include a pixel drive circuit, and the pixel drive circuit may be connected with a scan signal line, a light emitting signal line, and a data signal line respectively.

In an exemplary implementation mode, the timing controller may provide a gray scale value and a control signal suitable for a specification of the data signal driver to the data signal driver, may provide a clock signal, and a scan start signal, etc., suitable for a specification of the scan signal driver to the scan signal driver, and may provide a clock signal, and an emission stop signal, etc., suitable for a specification of the light emitting signal driver to the light emitting signal driver. The data signal driver may generate data voltages to be provided to data signal lines D1, D2, D3, ..., and Dn using the gray scale value and the control signal received from the timing controller. For example, the data signal driver may sample the gray scale value using a clock signal and apply a data voltage corresponding to the gray scale value to the data signal lines D1 to Dn by taking a pixel row as a unit, wherein n may be a natural number. The scan signal driver may generate scan signals to be provided to scan signal lines S1, S2, S3, ..., and Sm by receiving a clock signal, a scan start signal, and the like from the timing controller. For example, the scan signal driver may sequentially provide scan signals with on-level pulses to the scan signal lines S1 to Sm. For example, the scan signal driver may be constructed in a form of a shift register and may generate a scan signal in a manner in which the scan start signal provided in a form of an on-level pulse is transmitted to a next-stage circuit sequentially under control of the clock signal, wherein m may be a natural number. The light emitting signal driver may generate an emission signal to be provided to light emitting signal lines E1, E2, E3, ..., and Eo by receiving the clock signal, the emission stop signal, and the like from the timing controller. For example, the light emitting signal driver may sequentially provide an emission signal with an off-level pulse to the light emitting signal lines E1 to Eo. For example, the light emitting signal driver may be constructed in a form of a shift register and may generate an emission signal in a manner of transmitting sequentially the emission stop signal provided in a form of an off-level pulse to a next-stage circuit under control of the clock signal, wherein o may be a natural number.

In an exemplary implementation mode, the light emitting device may be an Organic Light Emitting Diode (OLED), including a first electrode (anode), an organic emitting layer, and a second electrode (cathode), which are stacked.

In an exemplary implementation mode, the organic emitting layer may include an Emitting Layer (EML), and any one or more of following: a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation mode, one or more of hole injection layers, hole transport layers, electron block layers, hole block layers, electron transport layers, and electron injection layers of all sub-pixels may be connected together to form a common layer. Emitting layers of adjacent sub-pixels may be overlapped slightly, or may be isolated.

FIG. 1B is a schematic diagram of an equivalent circuit of a pixel drive circuit. In an exemplary implementation mode, the pixel drive circuit may have a structure of 3T1C, 4T1C, 5T1C, 5T2C, 6T1C, 7T1C, or 8T1C. As shown in FIG. 1B, the pixel drive circuit may include seven transistors (a first transistor T1 to a seventh transistor T7), and one capacitor C. The pixel drive circuit may be connected with seven signal segments (a data signal terminal Data, a scan signal terminal Gate, a reset signal terminal Reset, a light emitting signal terminal EM, a first initial signal terminal INIT1, an anode initial signal terminal INIT2, a first power supply terminal VDD, and a second power supply terminal VSS).

In an exemplary implementation mode, the pixel drive circuit may include a first node N1, a second node N2, and a third node N3. The first node N1 is respectively connected with a first electrode of the third transistor T3, a second electrode of the fourth transistor T4, and a second electrode of the fifth transistor T5; the second node N2 is respectively connected with a second electrode of the first transistor, a first electrode of the second transistor T2, a gate electrode of the third transistor T3, and a second terminal of the capacitor C; and the third node N3 is respectively connected with a second electrode of the second transistor T2, a second electrode of the third transistor T3, and a first electrode of the sixth transistor T6.

In an exemplary implementation mode, a first terminal of the capacitor C is connected with the first power supply terminal VDD, and a second terminal of the capacitor C is connected with the second node N2, that is, the second terminal of the capacitor C is connected with a gate electrode of the third transistor T3.

A gate electrode of the first transistor T1 is connected with the reset signal terminal Reset, a first electrode of the first transistor T1 is connected with the first initial signal terminal INIT1, and a second electrode of the first transistor is connected with the second node N2. The first transistor T1 may be referred to as a node reset transistor. When a scan signal with an on-level is applied to the reset signal terminal Reset, the first transistor T1 transmits an initialization voltage to the gate electrode of the third transistor T3 to initialize a charge amount of the gate electrode of the third transistor T3.

A gate electrode of the second transistor T2 is connected with the scan signal terminal Gate, a first electrode of the second transistor T2 is connected with the second node N2, and a second electrode of the second transistor T2 is connected with the third node N3. The second transistor may be referred to as a compensation transistor. When a scan signal with an on-level is applied to the scan signal terminal Gate, the second transistor T2 enables the gate electrode of the third transistor T3 to be connected with the second electrode of the third transistor T3.

The gate electrode of the third transistor T3 is connected with the second node N2, namely, the gate electrode of the third transistor T3 is connected with the second terminal of the capacitor C, a first electrode of the third transistor T3 is connected with the first node N1, and the second electrode of the third transistor T3 is connected with the third node N3. The third transistor T3 may be referred to as a drive transistor, and the third transistor T3 determines a magnitude of a drive current flowing between the first power supply terminal VDD and the second power supply terminal VSS according to a potential difference between the gate electrode and the first electrode of the third transistor T3.

A gate electrode of the fourth transistor T4 is connected with the scan signal terminal Gate, a first electrode of the fourth transistor T4 is connected with the data signal terminal Data, and a second electrode of the fourth transistor T4 is connected with the first node N1. The fourth transistor T4 may be referred to as a writing transistor. When a scan signal with an on-level is applied to the scan signal terminal Gate, the fourth transistor T4 enables a data voltage of the data signal terminal Data to be input to the pixel drive circuit.

A gate electrode of the fifth transistor T5 is connected with the light emitting signal terminal EM, a first electrode of the fifth transistor T5 is connected with the first power supply terminal VDD, and a second electrode of the fifth transistor T5 is connected with the first node N1. A gate electrode of the sixth transistor T6 is connected with the light emitting signal terminal EM, a first electrode of the sixth transistor T6 is connected with the third node N3, and a second electrode of the sixth transistor T6 is connected with a first electrode of the light emitting device. The fifth transistor T5 may be referred to as a first light emitting transistor, and the sixth transistor T6 may be referred to as a second light emitting transistor. When a light emitting signal with an on-level is applied to the light emitting signal terminal EM, the fifth transistor T5 and the sixth transistor T6 enable the light emitting device to emit light by forming a drive current path between the first power supply terminal VDD and the second power supply terminal VSS.

A gate electrode of the seventh transistor T7 is connected with the reset signal terminal Reset, a first electrode of the seventh transistor T7 is connected with the second initial signal terminal INIT2, and a second electrode of the seventh transistor T7 is connected with the first electrode of the light emitting device. The seventh transistor T71 may be referred to as an anode reset transistor. When a scan signal with an on-level is applied to the reset signal terminal Reset, the seventh transistor T7 transmits an initialization voltage to the first electrode of the light emitting device so as to initialize a charge amount accumulated in the first electrode of the light emitting device or release a charge amount accumulated in the first electrode of the light emitting device.

In an exemplary implementation mode, a second electrode of the light emitting device is connected with the second power supply terminal VSS, a signal of the second power supply terminal VSS is a low-level signal, and a signal of the first power supply terminal VDD is a high-level signal continuously provided. The scan signal terminal Gate is a scan signal terminal in a pixel drive circuit of a current display row, and the reset signal terminal Reset is a scan signal terminal in a pixel drive circuit of a previous display row. A reset signal terminal Reset of the current display row is a same signal terminal as a scan signal terminal Gate in the pixel drive circuit of the previous display row, which may reduce signal terminals of the display substrate and achieve a narrow bezel of the display substrate.

Transistors may be divided into N-type transistors and P-type transistors according to characteristics of the transistors. When a transistor is a P-type transistor, its turn-on voltage is a low-level voltage (e.g., 0 V, -5 V, -10 V, or another suitable voltage), and its turn-off voltage is a high-level voltage (e.g., 5 V, 10 V, or another suitable voltage). When a transistor is an N-type transistor, its turn-on voltage is a high-level voltage (e.g., 5 V, 10 V, or another suitable voltage), and its turn-off voltage is a low-level voltage (e.g., 0 V, -5 V, -10 V, or another suitable voltage).

In an exemplary implementation mode, the first transistor T1 to the seventh transistor T7 may be P-type transistors, or may be N-type transistors. Use of a same type of transistors in a pixel drive circuit may simplify a process flow, reduce a process difficulty of a display panel, and improve a product yield. In some possible implementation modes, the first transistor T1 to the seventh transistor T7 may include a P-type transistor and an N-type transistor.

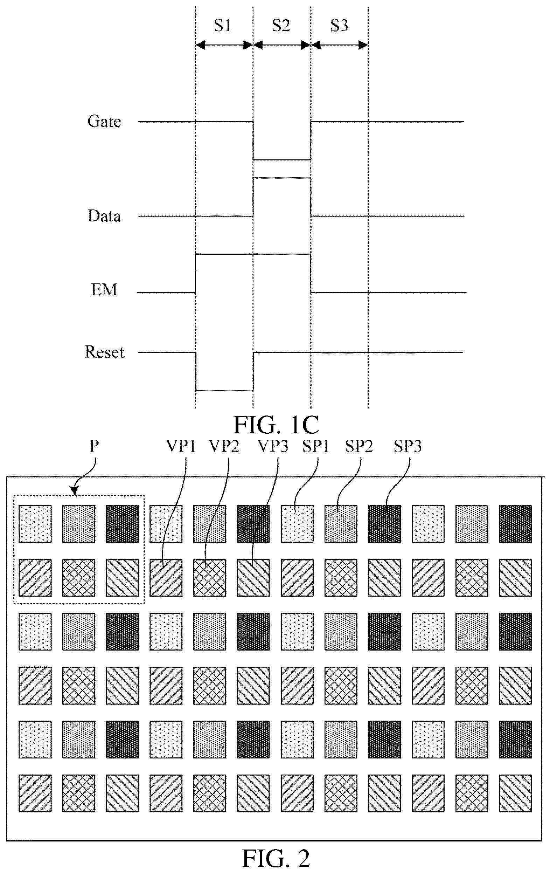

FIG. 1C is a working timing diagram of a pixel drive circuit. An exemplary embodiment of the present disclosure will be described below through a working process of the pixel drive circuit exemplified in FIG. 1B. The pixel drive circuit in FIG. 1B includes seven transistors (a first transistor T1 to a seventh transistor T7) and one capacitor C, and the seven transistors are all P-type transistors.

In an exemplary implementation mode, the working process of the pixel drive circuit may include following stages.

In a first stage S1, which is referred to as a reset stage, a signal of the reset signal terminal Reset is a low-level signal, and signals of the scan signal terminal Gate and the light emitting signal terminal EM are high-level signals. The signal of the reset signal terminal Reset is a low-level signal, so that the first transistor T1 is turned on, a signal of the first initial signal terminal INIT1 is provided to the second node N2 to initialize (reset) the capacitor C and clear an original charge in the capacitor, the seventh transistor T7 is turned on, and an initial voltage of the second initial signal terminal INIT2 is provided to the first electrode of a light emitting device L to initialize (reset) the first electrode of the light emitting device L and clear a pre-stored voltage therein, thereby completing initialization. The signals of the scan signal terminal Gate and the light emitting signal terminal EM are high-level signals, so that the second transistor T2, the fourth transistor T4, the fifth transistor T5, and the sixth transistor T6, and the light emitting device L does not emit light in this stage.

In a second stage S2, which is referred to as a data writing stage or a threshold compensation stage, a signal of the scan signal terminal Gate is a low-level signal, signals of the reset signal terminal Reset and the light emitting signal terminal EM are high-level signals, and the data signal terminal Data outputs a data voltage. In this stage, the second terminal of the capacitor C is at a low level, so that the third transistor T3 is turned on. The signal of the scan signal terminal Gate is a low-level signal, so that the second transistor T2 and the fourth transistor T4 are turned on. The second transistor T2 and the fourth transistor T4 are turned on, so that the data voltage output by the data signal terminal Data is provided to the second node N2 through the first node N1, the turned-on third transistor T3, the third node N3, and the turned-on second transistor T2, and the capacitor C is charged with a difference between the data voltage output by the data signal terminal Data and a threshold voltage of the third transistor T3. A voltage at the second terminal (the second node N2) of the capacitor C is Vd-IVthI, wherein Vd is the data voltage output by the data signal terminal Data, and Vth is the threshold voltage of the third transistor T3. The signals of the reset signal terminal Reset and the light emitting signal terminal EM are high-level signals, so that the first transistor T1, the fifth transistor T5, the sixth transistor T6, and the seventh transistor T7 are turned off.

In a third stage S3, which is referred to as a light emitting stage, a signal of the light emitting signal terminal EM is a low-level signal, and signals of the scan signal terminal Gate and the reset signal terminal Reset are both high-level signals. The signal of the light emitting signal terminal EM is a low-level signal, so that the fifth transistor T5 and the sixth transistor T6 are turned on, and a power supply voltage outputted by the first power supply terminal VDD provides a drive voltage to the first electrode of the light emitting device L through the turned-on fifth transistor T5, the third transistor T3, and the sixth transistor T6, to drive the light emitting device L to emit light.

In a drive process of the pixel drive circuit, a drive current flowing through the third transistor T3 (drive transistor) is determined by a voltage difference between the gate electrode and the first electrode of the third transistor T3. The voltage of the second node N2 is Vdata-|Vth|, so the drive current of the third transistor T3 is as follows.

$$I = K*(Vgs\text{-}Vth)^2 = K*[(Vdd\text{-}Vd+|Vth|)\text{-}Vth]^2 = K*(Vdd\text{-}Vd)^2$$

Herein, I is the drive current flowing through the third transistor T3, i.e., a drive current for driving the light emitting device L, K is a constant, Vgs is the voltage difference between the gate electrode and the first electrode of the third transistor T3, Vth is the threshold voltage of the third transistor T3, Vd is the data voltage output by the data signal terminal Data, and Vdd is the power voltage output by the first power supply terminal VDD.

It may be seen from a derivation result of the above current formula that in the light emitting stage, the drive current of the third transistor T3 is not affected by the threshold voltage of the third transistor T3. Therefore, an influence of the threshold voltage of the third transistor T3 on the drive current is eliminated, which may ensure uniformity of display brightness of a display product, and improve an overall display effect of the display product.

FIG. 2 is a schematic diagram of a structure of a display substrate provided by an embodiment of the present disclosure. As shown in FIG. 2, the display substrate provided by the embodiment of the present disclosure may include a base substrate and pixel units P arranged in an array disposed on the base substrate. At least one pixel unit P includes a plurality of sub-pixels, and the plurality of sub-pixels include at least one peep-proof sub-pixel and at least one shared sub-pixel. At least one sub-pixel includes a pixel drive circuit and a light emitting device, and the pixel drive circuit is configured to drive the light emitting device to emit light. A display mode of the display substrate includes a first display mode and a second display mode, and a viewing angle range of the first display mode is smaller than a viewing angle range of the second display mode. In a state in which the display mode of the display substrate is the first display mode, the peep-proof sub-pixel emits light; and in a state in which the display mode of the display substrate is the second display mode, the shared sub-pixel emits light, or the peep-proof sub-pixel and the shared sub-pixel emit light. FIG. 2 is illustrated by taking a case in which the pixel unit includes three peep-proof sub-pixels VP1, VP2, and VP3, and three shared sub-pixels SP1, SP2, and SP3 as an example.

In an exemplary implementation mode, the first display mode may be referred to as a peep-proof mode and the second display mode may be referred to as a sharing mode.

In an exemplary implementation mode, the base substrate may be a flexible base substrate, or a rigid base substrate.

A display substrate provided by an embodiment of the present disclosure includes a base substrate and pixel units arranged in an array disposed on the base substrate. At least one pixel unit includes a plurality of sub-pixels, and the plurality of sub-pixels include at least one peep-proof sub-pixel and at least one shared sub-pixel. At least one sub-pixel includes a pixel drive circuit and a light emitting device, and the pixel drive circuit is configured to drive the light emitting device to emit light. A display mode of the display substrate includes a first display mode and a second display mode, and a viewing angle range of the first display mode is smaller than a viewing angle range of the second display mode. In a state in which the display mode of the display substrate is the first display mode, the peep-proof sub-pixel emits light; and in a state in which the display mode of the display substrate is the second display mode, the shared sub-pixel emits light, or the peep-proof sub-pixel and the shared sub-pixel emit light. According to the display substrate provided by the embodiment of the present disclosure, the pixel unit includes a peep-proof sub-pixel and a shared sub-pixel, and different sub-pixels are controlled to emit light in different display modes to achieve peep-proof display and normal display of the display substrate, thereby satisfying a user's needs.

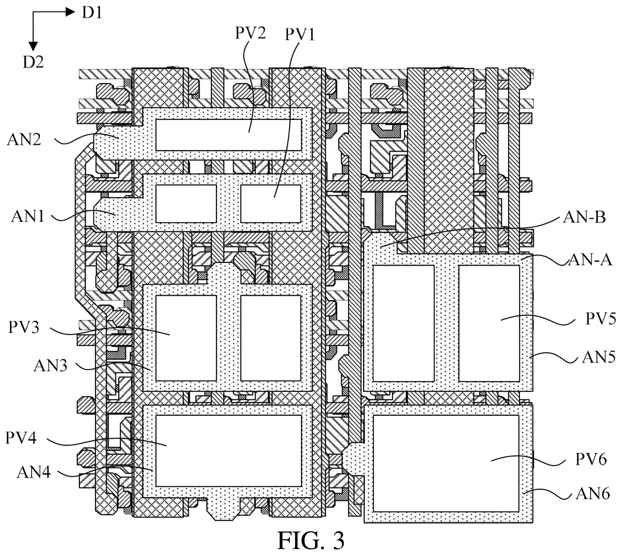

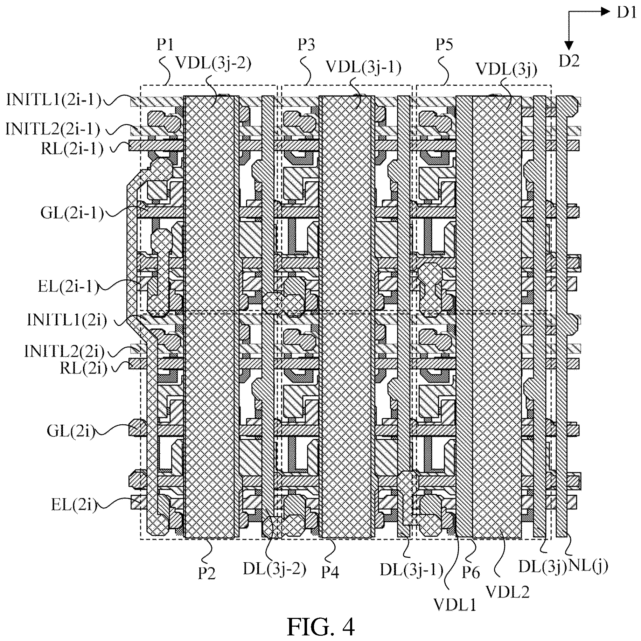

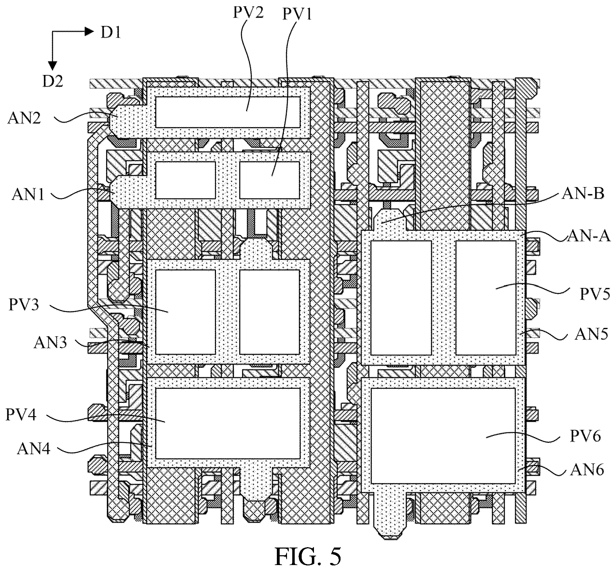

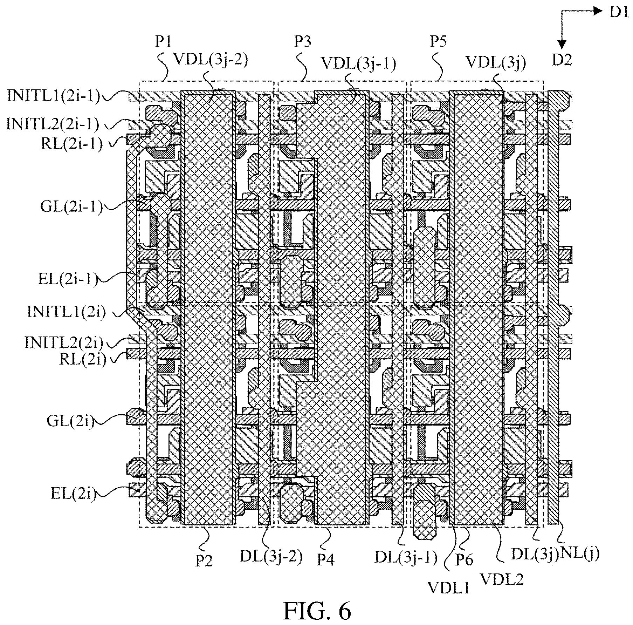

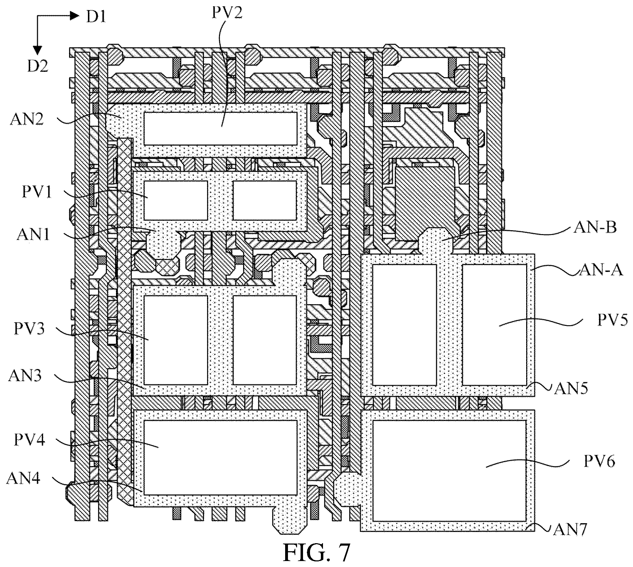

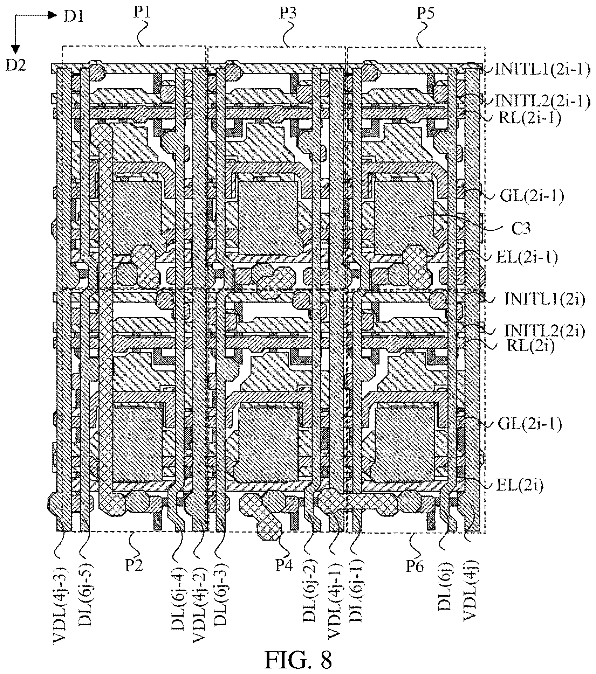

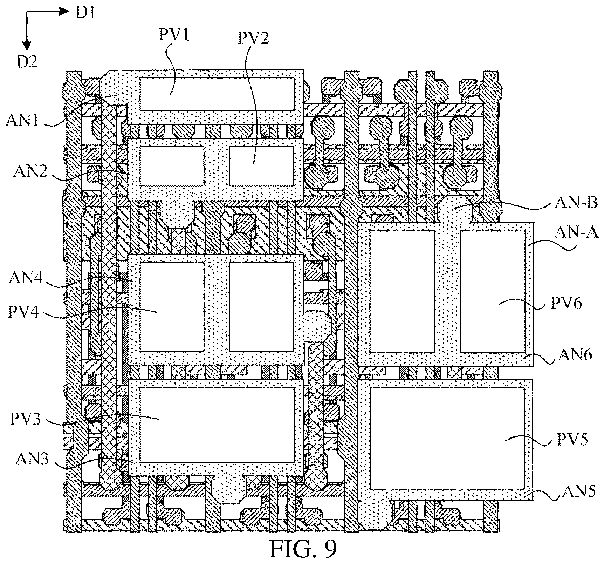

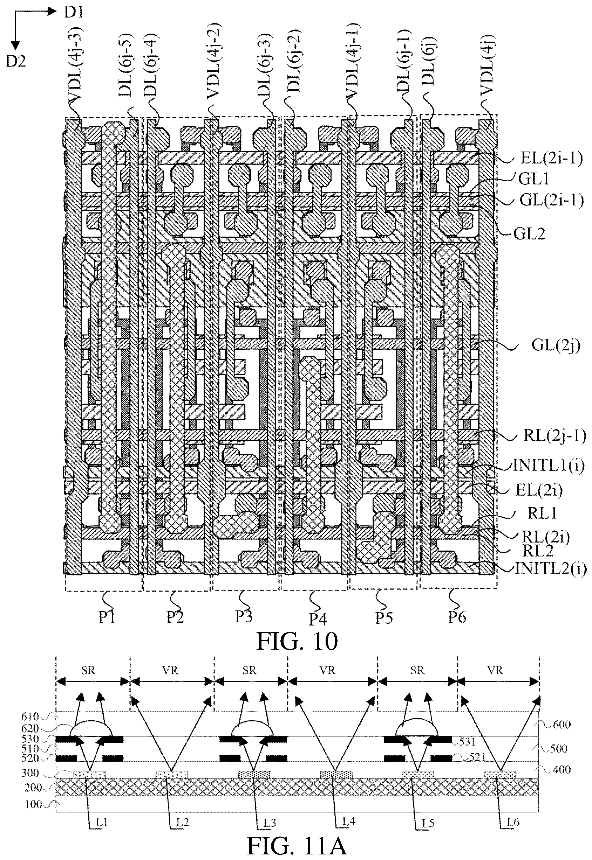

FIG. 3 is a first schematic diagram of a structure of a display substrate provided by an embodiment of the present disclosure, FIG. 4 is a schematic diagram of a portion of film layers in FIG. 3, FIG. 5 is a second schematic diagram of a structure of a display substrate provided by an embodiment of the present disclosure, FIG. 6 is a schematic diagram of a portion of film layers in FIG. 5, FIG. 7 is a third schematic diagram of a structure of a display substrate provided by an embodiment of the present disclosure, FIG. 8 is a schematic diagram of a portion of film layers in FIG. 7, FIG. 9 is a fourth schematic diagram of a structure of a display substrate provided by an embodiment of the present disclosure, and FIG. 10 is a schematic diagram of a portion of film layers in FIG. 9. As shown in FIGs. 3 to 10, a plurality of sub-pixels in at least one pixel unit include a first sub-pixel to a sixth sub-pixel. FIGs. 3 to 10 are illustrated by taking a pixel unit located in an i-th row and a j-th column of the display substrate as an example.

In an exemplary implementation mode, as shown in FIGs. 3 to 10, a pixel drive circuit P1 in the first sub-pixel to a pixel drive circuit P6 in the sixth sub-pixel located in a same pixel unit are arranged in an array along a first direction D1 and a second direction D2, or are arranged along a first direction D1. The first direction D1 intersects with the second direction D2.

In an exemplary implementation mode, the first sub-pixel and the second sub-pixel emit light of a first color, the third sub-pixel and the fourth sub-pixel emit light of a second color, and the fifth sub-pixel and the sixth sub-pixel emit light of a third color. In an exemplary implementation mode, the first color, the second color, and the third color are one of red, blue, and green, respectively, and colors are different. FIGs. 3 to 10 are illustrated by taking a case in which the first color is green, the second color is red, and the third color is green as an example.

As shown in FIGs. 3 to 10, one sub-pixel of the first sub-pixel and the second sub-pixel is a peep-proof sub-pixel, and the other sub-pixel of the first sub-pixel and the second sub-pixel is a shared sub-pixel; one sub-pixel of the third sub-pixel and the fourth sub-pixel is a peep-proof sub-pixel, and the other sub-pixel of the third sub-pixel and the fourth sub-pixel is a shared sub-pixel; and one sub-pixel of the fifth sub-pixel and the sixth sub-pixel is a peep-proof sub-pixel, and the other sub-pixel of the fifth sub-pixel and the sixth sub-pixel is a shared sub-pixel. FIGs. 3, 5, and 7 are illustrated by taking a case in which the first sub-pixel, the third sub-pixel, and the fifth sub-pixel are peep-proof sub-pixels, and the second sub-pixel, the fourth sub-pixel, and the sixth sub-pixel are shared sub-pixels as an example. FIG. 9 is illustrated by taking a case in which the first sub-pixel, the third sub-pixel, and the fifth sub-pixel are shared sub-pixels, and the second sub-pixel, the fourth sub-pixel, and the sixth sub-pixel are peep-proof sub-pixels as an example.

In an exemplary implementation mode, as shown in FIGs. 3, 5, 7, and 9, a light emitting device includes a first electrode, the display substrate is further provided with a pixel definition layer, and the pixel definition layer is provided with a pixel opening that exposes the first electrode. FIGs. 3, 5, 7, and 9 are illustrated by taking a case in which one pixel unit includes a first electrode AN1 of the first sub-pixel to a first electrode AN6 of the sixth sub-pixel, and the pixel definition layer includes a first pixel opening PV1 to a sixth pixel opening PV6 as an example. The first pixel opening PV1 is a pixel opening that exposes the first electrode AN1 of the first sub-pixel, the second pixel opening PV2 is a pixel opening that exposes the first electrode AN2 of the second sub-pixel, the third pixel opening PV3 is a pixel opening that exposes the first electrode AN3 of the third sub-pixel, the fourth pixel opening PV4 is a pixel opening that exposes the first electrode AN4 of the fourth sub-pixel, the fifth pixel opening PV5 is a pixel opening that exposes the first electrode AN5 of the fifth sub-pixel, and the sixth pixel opening PV6 is a pixel opening that exposes the first electrode AN6 of the sixth sub-pixel.

In an exemplary implementation mode, for a peep-proof sub-pixel and a shared sub-pixel emitting light of a same color, an area of a first electrode in the peep-proof sub-pixel is equal to an area of a first electrode in the shared sub-pixel, and an area of a pixel opening that exposes the first electrode of the peep-proof sub-pixel is smaller than an area of a pixel opening that exposes the first electrode of the shared sub-pixel. The area of the pixel opening that exposes the first electrode of the peep-proof sub-pixel is smaller than the area of the pixel opening that exposes the first electrode of the shared sub-pixel, which may ensure that a viewing angle range of light emitted by the peep-proof sub-pixel is smaller, while a viewing angle range of light emitted by the shared sub-pixel is greater, thereby achieving peep-proof display and shared display.

For a display panel provided in FIGs. 3, 5, 7, and 9, an area of the first electrode AN1 of the first sub-pixel is equal to an area of the first electrode AN2 of the second sub-pixel, an area of the first electrode AN3 of the third sub-pixel is equal to an area of the first electrode AN4 of the fourth sub-pixel, and an area of the first electrode AN5 of the fifth sub-pixel is equal to an area of the first electrode AN6 of the sixth sub-pixel. For the display panel provided in FIGs. 3, 5, and 7, an area of the first pixel opening PV1 is smaller than an area of the second pixel opening PV2, an area of the third pixel opening PV3 is smaller than an area of the fourth pixel opening PV4, and an area of the fifth pixel opening PV5 is smaller than an area of the sixth pixel opening PV6. For a display panel provided in FIG. 9, an area of the first pixel opening PV1 is greater than an area of the second pixel opening PV2, an area of the third pixel opening PV3 is greater than an area of the fourth pixel opening PV4, and an area of the fifth pixel opening PV5 is greater than an area of the sixth pixel opening PV6.

In an exemplary implementation mode, the area of the pixel opening that exposes the first electrode of the peep-proof sub-pixel is smaller than the area of the pixel opening that exposes the first electrode of the shared sub-pixel, which may be achieved by providing that the pixel opening that exposes the first electrode of the peep-proof sub-pixel includes at least two sub-pixel openings, and the at least two sub-pixel openings are arranged along the first direction D1. As shown in FIGs. 3, 5, and 7.

In an exemplary implementation mode, as shown in FIGs. 3, 5, and 7, any one of the first pixel opening PV1, the third pixel opening PV3, and the fifth pixel opening PV5 includes at least two sub-pixel openings, and the at least two sub-pixel openings are arranged in the first direction D1. FIGs. 3, 5, and 7 are illustrated by taking a case in which the pixel opening that exposes the first electrode of the peep-proof sub-pixel includes two sub-pixel openings as an example. As shown in FIG. 9, any one of the second pixel opening PV2, the fourth pixel opening PV4, and the sixth pixel opening PV6 includes at least two sub-pixel openings, and the at least two sub-pixel openings are arranged in the first direction D1. FIG. 9 is illustrated by taking a case in which the pixel opening that exposes the first electrode of the peep-proof sub-pixel includes two sub-pixel openings as an example.

In an exemplary implementation mode, as shown in FIGs. 3, 5, 7, and 9, for at least one pixel unit, a light emitting device of the first sub-pixel, a light emitting device of the second sub-pixel, a light emitting device of the third sub-pixel, and a light emitting device of the fourth sub-pixel are arranged sequentially in the second direction D2; the light emitting device of the fifth sub-pixel and the light emitting device of the sixth sub-pixel are arranged in the second direction D2; the light emitting device of the third sub-pixel and the light emitting device of the fifth sub-pixel are arranged in the first direction D1; and the light emitting device of the fourth sub-pixel and the light emitting device of the sixth sub-pixel are arranged in the first direction D1. An area of the first electrode AN5 of the fifth sub-pixel and an area of the first electrode AN6 of the sixth sub-pixel are greater than an area of the first electrode AN3 of the third sub-pixel and an area of the first electrode AN4 of the fourth sub-pixel; and the area of the first electrode AN3 of the third sub-pixel and the area of the first electrode AN4 of the fourth sub-pixel are greater than an area of the first electrode AN1 of the first sub-pixel and an area of the first electrode AN2 of the second sub-pixel. FIGs. 3, 5, and 7 are illustrated by taking a case in which the light emitting device of the second sub-pixel, the light emitting device of the first sub-pixel, the light emitting device of the third sub-pixel, and the light emitting device of the fourth sub-pixel are arranged sequentially in the second direction as an example. FIG. 9 is illustrated by taking a case in which the light emitting device of the first sub-pixel, the light emitting device of the second sub-pixel, the light emitting device of the third sub-pixel, and the light emitting device of the fourth sub-pixel are arranged sequentially in the second direction as an example.

In an exemplary implementation mode, a first electrode of a light emitting device of at least one sub-pixel may include an anode main body portion AN-A and an anode connection portion AN-B connected with each other, and the anode connection portion AN-B is electrically connected with a pixel drive circuit connected with the light emitting device.

In an exemplary implementation mode, a shape of the anode main body portion AN-A may be a rectangular shape, and corners of the rectangular shape may be provided with arc-shaped chamfers.

In an exemplary implementation mode, a shape of the anode connection portion AN-B may be a block.

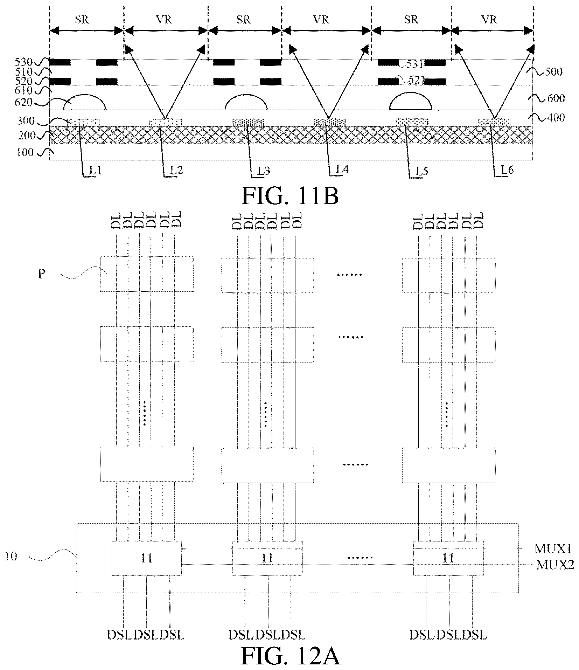

FIG. 11A is a schematic diagram of a structure of a display substrate provided by an exemplary implementation mode, and FIG. 11B is a schematic diagram of a structure of a display substrate provided by another exemplary implementation mode. As shown in FIGs. 11A and 11B, in an exemplary implementation mode, the display substrate may further include a drive structure layer 200, a light emitting structure layer 300, an encapsulation layer 400, and an optical structure layer sequentially stacked on a base substrate 100. A pixel drive circuit may be provided on the drive structure layer, and a light emitting device may be provided on the light emitting structure layer. The optical structure layer includes at least one of a light shielding structure layer 500 and an optical device layer 600. The optical device layer 600 is located on a side of the light shielding structure layer 500 close to or away from the base substrate 100. FIG. 11A is illustrated by taking a case in which the optical device layer 600 is located on a side of the light shielding structure layer 500 away from the base substrate 100 as an example. FIG. 11B is illustrated by taking a case in which the optical device layer 600 is located on a side of the light shielding structure layer 500 close to the base substrate 100 as an example.

In an exemplary implementation mode, the light emitting structure layer may include a first electrode, a pixel definition layer, an organic emitting layer, and a second electrode. The first electrode is connected with the pixel drive circuit through a via, the organic emitting layer is connected with the first electrode, and the second electrode is connected with the organic emitting layer. The organic emitting layer emits light of a corresponding color when driven by the first electrode and the second electrode.

In an exemplary implementation mode, the encapsulation structure layer may include a first encapsulation layer, a second encapsulation layer, and a third encapsulation layer that are stacked. The first encapsulation layer and the third encapsulation layer may be made of an inorganic material, and the second encapsulation layer may be made of an organic material. The second encapsulation layer is provided between the first encapsulation layer and the third encapsulation layer, which may be ensured that external water vapor cannot enter the light emitting structure layer.

In an exemplary implementation mode, the display substrate may further include a touch structure layer (not shown in the figure), which may be located between the optical structure layer and the encapsulation layer, or may be located on a side of the optical structure layer away from the base substrate.

In an exemplary implementation mode, the touch structure layer may include a first touch insulation layer, a first touch metal layer, a second touch insulation layer, a second touch metal layer, and a touch protective layer stacked sequentially. The first touch metal layer may include a plurality of bridge electrodes, the second touch metal layer may include a plurality of first touch electrodes and second touch electrodes, and a first touch electrode or a second touch electrode may be connected with a bridge electrode through a via.

In an exemplary implementation mode, as shown in FIGs. 11A and 11B, the light shielding structure layer 500 includes a first light shielding layer 520, a light shielding base substrate layer 510, and a second light shielding layer 530. The first light shielding layer 520 is located on a side of the light shielding base substrate layer 510 close to the base substrate 100, and the second light shielding layer 530 is located on a side of the light shielding base substrate layer 510 away from the base substrate 100. The first light shielding layer 520 includes a plurality of first light shielding structures 521, and the second light shielding layer 530 includes a plurality of second light shielding structures 531. FIGs. 11A and 11B are illustrated by taking a light emitting device L1 of the first sub-pixel to a light emitting device L6 of the sixth sub-pixel in a pixel unit as an example. In FIGs. 11A and 11B, the first sub-pixel, the third sub-pixel, and the fifth sub-pixel are peep-proof sub-pixels, and the second sub-pixel, the fourth sub-pixel, and the sixth sub-pixel are shared sub-pixels.

In an exemplary implementation mode, the light emitting structure layer may include an organic emitting layer of a light emitting device of at least one sub-pixel.

In an exemplary implementation mode, as shown in FIGs. 11A and 11B, an orthographic projection of the first light shielding layer 520 on the base substrate 100 is at least partially overlapped with an orthographic projection of the second light shielding layer 530 on the base substrate 100. A first light shielding structure 521 and a second light shielding structure 531 are located in a peep-proof sub-pixel region SR, and orthographic projections of the first light shielding structure 521 and the second light shielding structure 531 on the base substrate 100 are partially overlapped with an orthographic projection of an organic emitting layer of at least one peep-proof sub-pixel on the base substrate. The peep-proof sub-pixel region SR is a region where a peep-proof sub-pixel is located.

In an exemplary implementation mode, the display substrate further includes a shared sub-pixel region VR, and the first light shielding structure 521 and the second light shielding structure 531 are not located in the shared sub-pixel region VR in order to ensure a relatively large viewing angle range of shared display.

In an exemplary implementation mode, as shown in FIGs. 11A and 11B, the optical device layer 600 includes an optical base substrate layer 610 and a plurality of optical devices 620. The optical devices 620 are located on a side of the optical base substrate layer 610 close to or away from the base substrate 100, and configured to converge incident light. Orthographic projections of the optical devices 620 on the base substrate 100 are at least partially overlapped with an orthographic projection of the organic emitting layer of the peep-proof sub-pixel on the base substrate 100.

In an exemplary implementation mode, the display substrate may further include a plurality of signal lines and a plurality of anode connection lines. The pixel drive circuit is electrically connected with a plurality of signal lines and a plurality of anode connection lines, respectively.

In an exemplary implementation mode, the drive structure layer may include a semiconductor layer, a first conductive layer, a second conductive layer, a third conductive layer, a fourth conductive layer, and a fifth conductive layer sequentially stacked on the base substrate. The pixel drive circuit includes at least one transistor and at least one capacitor. The transistor includes an active pattern, a gate electrode, a first electrode, and a second electrode, and the capacitor includes a first electrode plate and a second electrode plate.

In an exemplary implementation mode, the semiconductor layer may at least include an active pattern of at least one transistor located in at least one sub-pixel.

In an exemplary implementation mode, the first conductive layer may at least include at least one signal line of the plurality of signal lines, and a gate electrode of at least one transistor and a first electrode plate of at least one capacitor located in at least one sub-pixel.

In an exemplary implementation mode, the second conductive layer may at least include at least one signal line of the plurality of signal lines, and a second electrode plate of at least one capacitor located in at least one sub-pixel.

In an exemplary implementation mode, the third conductive layer may at least include at least one signal line of the plurality of signal lines, and a first electrode and a second electrode of at least one transistor located in at least one sub-pixel.

In an exemplary implementation mode, the fourth conductive layer may at least include at least one signal line of the plurality of signal lines.

In an exemplary implementation mode, the fifth conductive layer may at least include at least one anode connection line of the plurality of anode connection lines.

In an exemplary implementation mode, as shown in FIGs. 3 to 8, for at least one pixel unit, the pixel drive circuit P1 of the first sub-pixel, the pixel drive circuit P3 of the third sub-pixel, and the pixel drive circuit P5 of the fifth sub-pixel are arranged sequentially in the first direction D1; the pixel drive circuit P2 of the second sub-pixel, the pixel drive circuit P4 of the fourth sub-pixel, and the pixel drive circuit P6 of the sixth sub-pixel are arranged sequentially in the first direction D1; the pixel drive circuit P1 of the first sub-pixel and the pixel drive circuit P2 of the second sub-pixel are arranged sequentially in the second direction D2; the pixel drive circuit P3 of the third sub-pixel and the pixel drive circuit P4 of the fourth sub-pixel are arranged sequentially in the second direction D2; and the pixel drive circuit P5 of the fifth sub-pixel and the pixel drive circuit P6 of the sixth sub-pixel are arranged sequentially in the second direction D2.

In an exemplary implementation mode, as shown in FIGs. 3 to 6, in the display substrate provided in FIGs. 3 and 5, a plurality of signal lines include 2M reset signal lines RL, 2M scan signal lines GL, 2M light emitting signal lines EL, 2M first initial signal lines INITL1, 2M second initial signal lines INITL2, 3N first power supply lines VDL, and 3N data signal lines DL, wherein M is a total number of rows of pixel units, and N is a total number of columns of pixel units.

In an exemplary implementation mode, as shown in FIGs. 3 to 6, at least one signal line of a reset signal line RL, a scan signal line GL, a light emitting signal line EL, a first initial signal line INITL1, and a second initial signal line INITL2 extends at least partially in the first direction D1.

In an exemplary implementation mode, as shown in FIGs. 3 to 6, at least one signal line of a first power supply line VDL and a data signal line DL extends at least partially in the second direction D2.

In an exemplary implementation mode, a line width of the first power supply line VDL is greater than a line width of the data signal line DL.

In an exemplary implementation mode, as shown in FIGs. 4 and 6, a pixel unit in an i-th row and a j-th column is electrically connected with a (2i-1)-th scan signal line GL(2i-1), a 2i-th scan signal line GL(2i), a (2i-1)-th reset signal line RL(2i-1), a 2i-th reset signal line RL(2i), a (2i-1)-th light emitting signal line EL(2i-1), a 2i-th light emitting signal line EL(2i), a (2i-1)-th first initial signal line INITL1(2i-1), a 2i-th first initial signal line INITL1(2i), a (2i-1)-th second initial signal line INITL2(2i-1), a 2i-th second initial signal line INITL2(2i-1), a (3j-2)-th first power supply line VDL(3j-2), a (3j-1)-th first power supply line VDL(3j-1), a 3j-th first power supply line VDL(3j), a (3j-2)-th data signal line DL(3j-2), a (3j-1)-th data signal line DL(3j-1), and a 3j-th data signal line DL(3j), respectively, wherein $1 \leq i \leq M$ and $1 \leq j \leq N$.

In an exemplary implementation mode, as shown in FIGs. 4 and 6, for at least one pixel unit, pixel structures of pixel drive circuits of at least two sub-pixels of the first sub-pixel to the sixth sub-pixel are at least partially the same.

In an exemplary implementation mode, as shown in FIGs. 4 and 6, in the pixel unit in the i-th row and j-th column, at least one sub-pixel of the first sub-pixel, the third sub-pixel, and the fifth sub-pixel is electrically connected with the (2i-1)-th scan signal line GL(2i-1), the (2i-1)-th light emitting signal line EL(2i-1), the (2i-1)-th reset signal line RL(2i-1), the (2i-1)-th first initial signal line INITL1(2i-1), and the (2i-1)-th second initial signal line INITL2(2i-1), respectively; at least one sub-pixel of the second sub-pixel, the fourth sub-pixel, and the sixth sub-pixel is electrically connected with the 2i-th scan signal line GL(2i), the 2i-th light emitting signal line EL(2i), the 2i-th reset signal line RL(2i), the 2i-th first initial signal line INITL1(2i), and the 2i-th second initial signal line INITL2(2i), respectively; at least one sub-pixel of the first sub-pixel and the second sub-pixel is further electrically connected with the (3j-2)-th first power supply line VDL(3j-2) and the (3j-2)-th data signal line DL(3j-2), respectively; at least one sub-pixel of the third sub-pixel and the fourth sub-pixel is further electrically connected with the (3j-1)-th first power supply line VDL(3j-1) and the (3j-1)-th data signal line DL(3j-1), respectively; and at least one sub-pixel of the fifth sub-pixel and the sixth sub-pixel is further electrically connected with the 3j-th first power supply line VDL(3j) and the 3j-th data signal line DL(3j), respectively.

In an exemplary implementation mode, signals of the (2i-1)-th scan signal line GL(2i-1) and the 2i-th scan signal line GL(2i) connected with a same pixel unit may be different. Signals of the (2i-1)-th light emitting signal line EL(2i-1) and the 2i-th scan signal line EL(2i) connected with a same pixel unit may be different. Signals of the (2i-1)-th reset signal line RL(2i-1) and the 2i-th reset signal line RL(2i) connected with a same pixel unit may be different.

In an exemplary implementation mode, orthographic projections of a first initial signal line, a second initial signal line, a reset signal line, a scan signal line, and a light emitting signal line connected with a same sub-pixel on the base substrate are sequentially arranged in the second direction D2. Exemplarily, as shown in FIGs. 4 and 6, for a first sub-pixel of the pixel unit in the i-th row and j-th column, orthographic projections of the (2i-1)-th first initial signal line INITL1(2i-1), the (2i-1)-th second initial signal line INITL2(2i-1), the (2i-1)-th reset signal line RL(2i-1), the (2i-1)-th scan signal line GL (2i-1), and the (2i-1)-th light emitting signal line EL (2i-1) connected with the first sub-pixel on the base substrate are sequentially arranged in the second direction D2.

In an exemplary implementation mode, an orthographic projection of a k-th data signal line on the base substrate is located between an orthographic projection of a k-th first power supply line on the base substrate and an orthographic projection of a (k+1)-th first power supply line on the base substrate, wherein $1 \leq k \leq 3N$.

In an exemplary implementation mode, the at least one transistor includes a node reset transistor, a drive transistor, and a compensation transistor; and a second electrode of the node reset transistor and a first electrode of the compensation transistor are of an integral structure and are electrically connected with a gate electrode of the drive transistor. The drive transistor and the compensation transistor; the integral structure of the second electrode of the node reset transistor and the first electrode of the compensation transistor is a second node in the pixel drive circuit. An orthographic projection of a first power supply line VDL on the base substrate is at least partially overlapped with an orthographic projection of an integral structure of a second electrode of a node reset transistor and a first electrode of a compensation transistor in a sub-pixel connected with the first power supply line on the base substrate, that is, the first power supply line VDL covers the second node, which may ensure that a signal of the second node will not be interfered by other signals, thereby improving reliability of the display substrate.

In an exemplary implementation mode, as shown in FIGs. 4 and 6, the first power supply line VDL includes a first sub-power supply line VDL1 and a second sub-power supply line VDL2 connected with each other. The first sub-power supply line VDL1 and the second sub-power supply line VDL2 extend in the second direction D2, and an orthographic projection of the first sub-power supply line VDL1 on the base substrate is at least partially overlapped with an orthographic projection of the second sub-power supply line VDL2 on the base substrate.

In an exemplary implementation mode, as shown in FIGs. 3 to 6, a light emitting signal line EL is located in the first conductive layer, a first initial signal line INITL1 and a second initial signal line INITL2 are located in the second conductive layer, a reset signal line RL and a scan signal line GL are located in the third conductive layer, the first sub-power supply line VDL1 is located in the fourth conductive layer, the second sub-power supply line VDL2 is located in the fifth conductive layer, and a data signal line DL is located in the fourth conductive layer or the fifth conductive layer. FIGs. 3 and 4 are illustrated by taking a case in which the data signal line DL is located in the fourth conductive layer, and FIGs. 5 and 6 are illustrated by taking a case in which the data signal line DL is located in the fifth conductive layer as an example.

In an exemplary implementation mode, as shown in FIGs. 7 and 8, a plurality of signal lines may include 2M reset signal lines RL, 2M scan signal lines GL, 2M light emitting signal lines EL, 2M first initial signal lines INITL1, 2M second initial signal lines INITL2, 4N first power supply lines VDL, and 6N data signal lines DL, wherein M is a total number of rows of pixel units, and N is a total number of columns of pixel units.

In an exemplary implementation mode, as shown in FIG. 8, at least one signal line of the reset signal line RL, the scan signal line GL, the light emitting signal line EL, the first initial signal line INITL1, and the second initial signal line INITL2 extends at least partially in the first direction D1, and at least one signal line of the first power supply line VDL and the data signal line DL extends at least partially in the second direction D2.

In an exemplary implementation mode, as shown in FIG. 8, a pixel unit in an i-th row and a j-th column is electrically connected with a (2i-1)-th scan signal line GL(2i-1), a 2i-th scan signal line GL(2i), a (2i-1)-th reset signal line RL(2i-1), a 2i-th reset signal line RL(2i), a (2i-1)-th light emitting signal line EL(2i-1), a 2i-th light emitting signal line EL(2i), a (2i-1)-th first initial signal line INITL1(2i-1), a 2i-th first initial signal line INITL1(2i), a (2i-1)-th second initial signal line INITL2(2i-1), a 2i-th second initial signal line INITL2(2i), a (4j-3)-th first power supply line VDL(4j-3), a (4j-2)-th first power supply line VDL(4j-2), a (4j-1)-th first power supply line VDL(4j-1), a 4j-th first power supply line VDL(4j), a (6j-5)-th data signal line DL(6j-5), a (6j-4)-th data signal line DL(6j-4), a (6j-3)-th data signal line DL(6j-3), a (6j-2)-th data signal line DL(6j-2), a (6j-1)-th data signal line DL(6j-1), and a 6j-th data signal line DL(6j), respectively, wherein $1 \leq i \leq M$ and $1 \leq j \leq N$.

In an exemplary implementation mode, as shown in FIG. 8, for at least one pixel unit, pixel structures of pixel drive circuits of at least two sub-pixels of the first sub-pixel, the third sub-pixel, and the fifth sub-pixel are at least partially the same; pixel structures of pixel drive circuits of at least two sub-pixels of the second sub-pixel, the fourth sub-pixel, and the sixth sub-pixel are at least partially the same; and a pixel structure of the pixel drive circuit P1 of the first sub-pixel is at least partially mirror symmetrical to a pixel structure of the pixel drive circuit P2 of the second sub-pixel.

In an exemplary implementation mode, as shown in FIG. 8, in the pixel unit in the i-th row and the j-th column, at least one sub-pixel of the first sub-pixel, the third sub-pixel, and the fifth sub-pixel is electrically connected with the (2i-1)-th scan signal line GL(2i-1), the (2i-1)-th light emitting signal line EL(2i-1), the (2i-1)-th reset signal line RL(2i-1), the (2i-1)-th first initial signal line INITL1(2i-1), and the (2i-1)-th second initial signal line INITL2(2i-1), respectively; at least one sub-pixel of the second sub-pixel, the fourth sub-pixel, and the sixth sub-pixel is electrically connected with the 2i-th scan signal line GL(2i), the 2i-th light emitting signal line EL(2i), the 2i-th reset signal line RL(2i), the 2i-th first initial signal line INITL1(2i), and the 2i-th second initial signal line INITL2(2i), respectively; the first sub-pixel is further electrically connected with the (6j-4)-th data signal line DL(6j-4) and the (4j-2)-th first power supply line VDL(4j-2); the second sub-pixel is further electrically connected with the (6j-5)-th data signal line DL(6j-5) and the (4j-3)-th first power supply line VDL(4j-3); the third sub-pixel is further electrically connected with the (6j-2)-th data signal line DL(6j-2) and the (4j-1)-th first power supply line VDL(4j-1), respectively; the fourth sub-pixel is further electrically connected with the (6j-3)-th data signal line DL(6j-3) and the (4j-2)-th first power supply line VDL(4j-2), respectively; the fifth sub-pixel is further electrically connected with the 6j-th data signal line DL(6j) and the 4j-th first power supply line VDL(4j), respectively; and the sixth sub-pixel is further electrically connected with the (6j-1)-th data signal line DL(6j-1) and the (4j-1)-th first power supply line VDL(4j-1), respectively.

In an exemplary implementation mode, signals of the (2i-1)-th scan signal line GL(2i-1) and the 2i-th scan signal line GL(2i) connected with a same pixel unit may be the same. Signals of the (2i-1)-th light emitting signal line EL(2i-1) and the 2i-th scan signal line EL(2i) connected with a same pixel unit may be the same. Signals of the (2i-1)-th reset signal line RL(2i-1) and the 2i-th reset signal line RL(2i) connected with a same pixel unit may be the same.

In an exemplary implementation mode, as shown in FIG. 8, an orthographic projection of the first initial signal line INITL1connected with on the base substrate, and orthographic projections of the second initial signal line INITL2, the reset signal line RL, the scan signal line GL, and the light emitting signal line EL connected with a same sub-pixel on the base substrate are sequentially arranged in the second direction D. Exemplarily, as shown in FIG. 8, for a first sub-pixel of the pixel unit in the i-th row and j-th column, orthographic projections of the (2i-1)-th first initial signal line INITL1(2i-1), the (2i-1)-th second initial signal line INITL2(2i-1), the (2i-1)-th reset signal line RL(2i-1), the (2i-1)-th scan signal line GL (2i-1), and the (2i-1)-th light emitting signal line EL(2i-1) connected with the first sub-pixel on the base substrate are sequentially arranged in the second direction D2.

In an exemplary implementation mode, as shown in FIG. 8, for at least one pixel unit, orthographic projections of two data signal lines DL connected with two sub-pixels arranged in the second direction d2 on the base substrate are located between orthographic projections of two first power supply lines DL connected with the two sub-pixels on the base substrate. Exemplarily, for the pixel unit in the i-th row and the j-th column, an orthographic projection of the (6j-4)-th data signal line DL(6j-4) connected with a first sub-pixel of the pixel unit in the i-th row and the j-th column on the base substrate and an orthographic projection of the (6j-5)-th data signal line DL(6j-5) connected with a second sub-pixel of the pixel unit in the i-th row and the j-th column on the base substrate are located between an orthographic projection of the (4j-2)-th first power supply line VDL(4j-2) connected with the first sub-pixel on the base substrate and an orthographic projection of the (4j-3)-th first power supply line VDL(4j-3) connected with the second sub-pixel on the base substrate.

In an exemplary implementation mode, as shown in FIG. 8, at least one transistor includes a node reset transistor, a drive transistor, and a compensation transistor; and a second electrode of the node reset transistor and a first electrode of the compensation transistor are of an integral structure and are electrically connected with a gate electrode of the drive transistor. The integral structure of the second electrode of the node reset transistor and the first electrode of the compensation transistor is a second node in the pixel drive circuit.

In an exemplary implementation mode, as shown in FIG. 8, the capacitor further includes a third electrode plate C3. The third electrode plate C3 is electrically connected with the second electrode plate and is located in the fourth conductive layer. For at least one sub-pixel, an orthographic projection of the third electrode plate C3 on the base substrate is at least partially overlapped with an orthographic projection of the integral structure of the second electrode of the node reset transistor and the first electrode of the compensation transistor on the base substrate. The orthographic projection of the third electrode plate C3 on the base substrate is at least partially overlapped with the orthographic projection of the integral structure of the second electrode of the node reset transistor and the first electrode of the compensation transistor on the base substrate, that is, the third electrode plate C3 covers the second node, which may ensure that a signal of the second node will not be interfered by other signals, thereby improving reliability of the display substrate.

In an exemplary implementation mode, as shown in FIG. 8, orthographic projections of third electrode plates C3 of two sub-pixels arranged in the second direction D2 on the base substrate are located between orthographic projections of two data signal lines DL connected with the two sub-pixels arranged in the second direction d2 on the base substrate. Exemplarily, for the pixel unit in the i-th row and the j-th column, an orthographic projections of third electrode plates C3 of the first sub-pixel and the second sub-pixel of the pixel unit in the i-th row and the j-th column on the base substrate are located between an orthographic projection of the (6j-4)-th data signal line DL(6j-4) connected with the first sub-pixel on the base substrate and an orthographic projection of the (6j-5)-th data signal line DL(6j-5) connected with the second sub-pixel on the base substrate.

In an exemplary implementation mode, as shown in FIG. 8, the light emitting signal line EL is located in the first conductive layer, the first initial signal line INITL1 and the second initial signal line INITL2 are located in the second conductive layer, the reset signal line RL and the scan signal line GL are located in the third conductive layer, and the data signal line DL and the first power supply line VDL are located in the fourth conductive layer.

In an exemplary implementation mode, as shown in FIGs. 9 and 10, for at least one pixel unit, the pixel drive circuit P1 of the first sub-pixel, the pixel drive circuit P2 of the second sub-pixel, the pixel drive circuit P3 of the third sub-pixel, the pixel drive circuit P4 of the fourth sub-pixel, the pixel drive circuit P5 of the fifth sub-pixel, and the pixel drive circuit P6 of the sixth sub-pixel are sequentially arranged in the first direction D1.

In an exemplary implementation mode, in the display panel provided in FIG. 9, a plurality of signal lines may include 2M reset signal lines RL, 2M scan signal lines GL, 2M light emitting signal lines EL, M first initial signal lines INITL1, M second initial signal lines INITL2, 4N first power supply lines VDL, and 6N data signal lines DL, wherein M is a total number of rows of pixel units, and N is a total number of columns of pixel units.

In an exemplary implementation mode, as shown in FIG. 9, at least one signal line of a reset signal line RL, a scan signal line GL, a light emitting signal line EL, a first initial signal line INITL1, and a second initial signal line INITL2 extends at least partially in the first direction D1, and at least one signal line of a first power supply line VDL and a data signal line DL extends at least partially in the second direction D2.

In an exemplary implementation mode, as shown in FIG. 9, a pixel unit in an i-th row and a j-th column is electrically connected with a (2i-1)-th scan signal line GL(2i-1), a 2i-th scan signal line GL(2i), a (2i-1)-th reset signal line RL(2i-1), a 2i-th reset signal line RL(2i), a (2i-1)-th light emitting signal line EL(2i-1), a 2i-th light emitting signal line EL(2i), an i-th first initial signal line INITL1(i), an i-th second initial signal line INITL2(i), a (4j-3)-th first power supply line VDL(4j-3), a (4j-2)-th first power supply line VDL(4j-2), a (4j-1)-th first power supply line VDL(4j-1), a 4j-th first power supply line VDL(4j), a (6j-5)-th data signal line DL(6j-5), a (6j-4)-th data signal line DL(6j-4), a (6j-3)-th data signal line DL(6j-3), a (6j-2)-th data signal line DL(6j-2), a (6j-1)-th data signal line DL(6j-1), and a 6j-th data signal line DL(6j), respectively, wherein $1 \leq i \leq M$ and

$1 \leq j \leq N$.

In an exemplary implementation mode, as shown in FIG. 9, for at least one pixel unit, pixel structures of pixel drive circuits of adjacent sub-pixels are at least partially symmetrically disposed with respect to a virtual straight line extending in the second direction D2. Exemplarily, a pixel structure of the pixel drive circuit P1 of the first sub-pixel and a pixel structure of the pixel drive circuit P2 of the second sub-pixel are symmetrically disposed with respect to a virtual straight line extending in the second direction D2; a pixel structure of the pixel drive circuit P3 of the third sub-pixel and a pixel structure of the pixel drive circuit P4 of the fourth sub-pixel are symmetrically disposed with respect to a virtual straight line extending in the second direction D2; and a pixel structure of the pixel drive circuit P5 of the fifth sub-pixel and a pixel structure of the pixel drive circuit P6 of the sixth sub-pixel are symmetrically disposed with respect to a virtual straight line extending in the second direction D2. The pixel structure of the pixel drive circuit P1 of the first sub-pixel, the pixel structure of the pixel drive circuit P3 of the third sub-pixel, and the pixel structure of the pixel drive circuit P5 of the fifth sub-pixel are at least partially the same, and the pixel structure of the pixel drive circuit P2 of the second sub-pixel, the pixel structure of the pixel drive circuit P4 of the fourth sub-pixel, and the pixel structure of the pixel drive circuit P6 of the sixth sub-pixel are at least partially the same.

In an exemplary implementation mode, as shown in FIG. 9, in the pixel unit in the i-th row and the j-th column, at least one sub-pixel of the first sub-pixel to the sixth sub-pixel is electrically connected with the (2i-1)-th scan signal line GL(2i-1), the 2i-th scan signal line GL(2i), the (2i-1)-th reset signal line RL(2i-1), the 2i-th reset signal line RL(2i), the (2i-1)-th light emitting signal line EL(2i-1), the 2i-th light emitting signal line EL(2i), the i-th first initial signal line INITL1(i), and the i-th second initial signal line INITL2(i), respectively; the first sub-pixel is further electrically connected with the (6j-5)-th data signal line DL(6j-5) and the (4j-3)-th first power supply line VDL(4j-3), respectively; the second sub-pixel is further electrically connected with the (6j-4)-th data signal line DL(6j-4) and the (4j-2)-th first power supply line VDL(4j-2), respectively; the third sub-pixel is further electrically connected with the (6j-3)-th data signal line DL(6j-3) and the (4j-2)-th first power supply line VDL(4j-2), respectively; the fourth sub-pixel is further electrically connected with the (6j-2)-th data signal line DL(6j-2) and the (4j-1)-th first power supply line VDL(4j-1), respectively; the fifth sub-pixel is further electrically connected with the (6j-1)-th data signal line DL(6j-1) and the (4j-1)-th first power supply line VDL(4j-1), respectively; and the sixth sub-pixel is further electrically connected with the 6j-th data signal line DL(6j) and the 4j-th first power supply line VDL(4j), respectively.

In an exemplary implementation mode, signals of the (2i-1)-th scan signal line GL(2i-1) and the 2i-th scan signal line GL(2i) connected with a same pixel unit may be the same. Signals of the (2i-1)-th light emitting signal line EL(2i-1) and the 2i-th scan signal line EL(2i) connected with a same pixel unit may be the same. Signals of the (2i-1)-th reset signal line RL(2i-1) and the 2i-th reset signal line RL(2i) connected with a same pixel unit may be the same.

In an exemplary implementation mode, at least one transistor includes a first light emitting transistor, a second light emitting transistor, a node reset transistor, an anode reset transistor, a writing transistor, a compensation transistor, and a drive transistor. The first light emitting transistor and the writing transistor are respectively electrically connected with a first electrode of the drive transistor; the second light emitting transistor is respectively electrically connected with a second electrode of the drive transistor and a first electrode of the light emitting device; the anode reset transistor is electrically connected with a first electrode of the light emitting device; the compensation transistor is respectively electrically connected with a gate electrode and a second electrode of the drive transistor; and the node reset transistor is electrically connected with a gate electrode of the drive transistor. As shown in FIG. 9, for the pixel unit in the i-th row and the j-th column, a gate electrode of a first light emitting transistor in at least one sub-pixel is electrically connected with the (2i-1)-th light emitting signal line EL(2i-1); a gate electrode of the second light emitting transistor is electrically connected with the 2i-th light emitting signal line EL(2i); a gate electrode of the writing transistor is electrically connected with the (2i-1)-th scan signal line GL(2i-1); a gate electrode of the compensation transistor is electrically connected with the 2i-th scan signal line GL(2i), a gate electrode of the node reset transistor is electrically connected with the (2i-1)-th reset signal line RL(2i-1); and a gate electrode of the anode reset transistor is electrically connected with the 2i-th reset signal line RL(2i).

In an exemplary implementation mode, for a pixel unit in the i-th row, orthographic projections of the (2i-1)-th light emitting signal line EL(2i-1), the (2i-1)-th scan signal line GL(2i-1), the 2i-th scan signal line GL(2i), the (2j-1)-th reset signal line RL(2i-1), the i-th first initial signal line INITL1(i), the 2i-th light emitting signal line EL(2i), the 2i-th reset signal line RL(2i), and the i-th second initial signal line INITL2(i) on the base substrate are sequentially arranged in the second direction D.

In an exemplary implementation mode, for at least one pixel unit, orthographic projections of data signal lines DL connected with an x-th sub-pixel and an (x+1)-th sub-pixel on the base substrate are located between orthographic projections of first power supply lines VDL connected with the x-th sub-pixel and the (x+1)-th sub-pixel on the base substrate, wherein $1 \leq x \leq 6$ and x is an odd number. Exemplarily, for a pixel unit in the j-th column, an orthographic projection of the (6j-5)-th data signal line DL(6j-5) connected with the first sub-pixel on the base substrate and an orthographic projection of the (6j-4)-th data signal line DL(6j-4) connected with the second sub-pixel on the base substrate are located between an orthographic projection of the (4j-3)-th first power supply line VDL(4j-3) connected with the first sub-pixel on the base substrate and an orthographic projection of the (4j-2)-th first power supply line VDL(4j-2) connected with the second sub-pixel on the base substrate; an orthographic projection of the (6j-3)-th data signal line DL(6j-3) connected with the third sub-pixel on the base substrate and an orthographic projection of the (6j-2)-th data signal line DL(6j-2) connected with the fourth sub-pixel on the base substrate are located between an orthographic projection of the (4j-2)-th first power supply line VDL(4j-2) connected with the third sub-pixel on the base substrate and an orthographic projection of the (4j-1)-th first power supply line VDL(4j-1) connected with the fourth sub-pixel on the base substrate; and an orthographic projection of the (6j-1)-th data signal line DL(6j-1) connected with the fifth sub-pixel on the base substrate and an orthographic projection of the 6j-th data signal line DL(6j) connected with the sixth sub-pixel on the base substrate are located between an orthographic projection of the (4j-1)-th first power supply line VDL(4j-1) connected with the fifth sub-pixel on the base substrate and an orthographic projection of the 4j-th first power supply line VDL(4j) connected with the sixth sub-pixel on the base substrate.

In an exemplary implementation mode, as shown in FIG. 10, an odd-numbered scan signal line GL includes a first sub-scan signal line GL1 and a second sub-scan signal line GL2 connected with each other. The first sub-scan signal line GL1 and the second sub-scan signal line GL2 extend in the first direction D1, and an orthographic projection of the first sub-scan signal line GL1 on the base substrate is at least partially overlapped with an orthographic projection of the second sub-scan signal line GL2 on the base substrate. The first sub-scan signal line GL1 is located in the first conductive layer, and the second sub-scan signal line GL2 is located in the third conductive layer.

In an exemplary implementation mode, as shown in FIG. 10, an even-numbered reset signal line RL includes a first sub-reset signal line RL1 and a second sub-reset signal line RL2 connected with each other. The first sub-reset signal line RL1 and the second sub-reset signal line RL2 extend in the first direction D1, and an orthographic projection of the first sub-reset signal line RL1 on the base substrate is at least partially overlapped with an orthographic projection of the second sub-reset signal line RL2 on the base substrate. The first sub-reset signal line RL1 is located in the first conductive layer, and the second sub-reset signal line RL2 is located in the third conductive layer.

In an exemplary implementation mode, as shown in FIG. 10, a light emitting signal line EL is located in the first conductive layer, a first initial signal line INITL1 and a second initial signal line INITL2 are located in the second conductive layer, an even-numbered scan signal line and an odd-numbered reset signal line are located in the third conductive layer, and a data signal line DL and a first power supply line VDL are located in the fourth conductive layer.

In an exemplary implementation mode, a plurality of signal lines in the display substrate include a plurality of first initial signal lines INITL1 and a plurality of second initial signal lines INITL2. The display substrate further includes at least one connection line of a first initial connection line and a second initial connection line (not shown in the figure). The display substrate provided in FIG. 4 includes a first initial connection line NL.

In an exemplary implementation mode, a quantity of first initial connection lines may be N, and a j-th first initial connection line is located on a side of a pixel unit in a j-th column close to a pixel unit in a (j+1)-th column.

In an exemplary implementation mode, the first initial connection line extends in the second direction D2 and is located between adjacent pixel units, and the first initial connection line is electrically connected with a plurality of first initial signal lines INITL1. The first initial connection line NL may be located in the fourth conductive layer or the fifth conductive layer. FIG. 4 is illustrated by taking a case in which the first initial connection line may be located in the fourth conductive layer as an example. Provision of the first initial connection line may form a mesh structure with the plurality of first initial signal lines, which may ensure display uniformity of the display substrate.

In an exemplary implementation mode, a quantity of second initial connection lines may be N.

In an exemplary implementation mode, the second initial connection line extends in the second direction D2 and is located between adjacent pixel units, and the second initial connection line is electrically connected with a plurality of second initial signal lines INITL2. The second initial connection line may be located in the fourth conductive layer or the fifth conductive layer. Provision of the second initial connection line may form a mesh structure with the plurality of second initial signal lines, which may ensure display uniformity of the display substrate.

In an exemplary implementation mode, FIG. 12A is a schematic diagram of a structure of a data multiplexing circuit in a display substrate. As shown in FIG. 12A, for the display substrate provided in FIGs. 7 and 9, the display substrate may further include a first multiplexing control signal line MUX1, a second multiplexing control signal line MUX2, 6N data signal lines DL, 3N data electrical power supply lines DSL, and a data multiplexing circuit. The data multiplexing circuit includes N sub-multiplexing circuits, wherein N is a total number of columns of pixel units. An n-th sub-multiplexing circuit is electrically connected with three data electrical power supply lines DSL, the first multiplexing control signal line MUX1, the second multiplexing control signal line MUX2, and six data signal lines DL connected with a pixel unit in an n-th column, respectively, and is configured to provide a signal of at least one data electrical power supply line DSL to at least one data signal line DL under signal control of the first multiplexing control signal line MUX1 and the second multiplexing control signal line MUX2, wherein 1≤n≤N. Provision of the data multiplexing circuit in the present disclosure may reduce a quantity of signal lines connected with a drive signal of the display substrate and may achieve a narrow bezel of the display substrate.

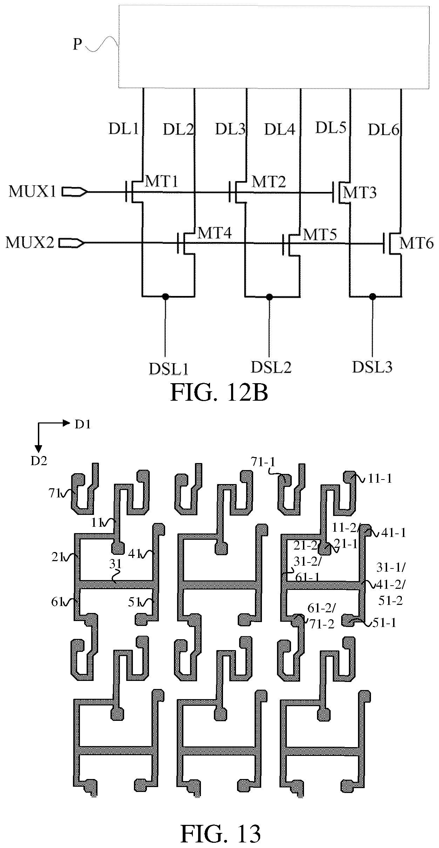

In an exemplary implementation mode, FIG. 12B is an equivalent circuit diagram of a sub-multiplexing circuit. In FIG. 12B, DL1 is a data signal line connected with the first sub-pixel, DL2 is a data signal line connected with the second sub-pixel, DL3 is a data signal line connected with the third sub-pixel, DL4 is a data signal line connected with the fifth sub-pixel, DL5 is a data signal line connected with the fifth sub-pixel, DL6 is a data signal line connected with the sixth sub-pixel, DSL1 is a first data electrical power supply line of three data electrical power supply lines connected with an n-th multiplexing sub-circuit, DSL2 is a second data electrical power supply line of the three data electrical power supply lines connected with the n-th multiplexing sub-circuit, and DSL3 is a third data electrical power supply line of the three data electrical power supply lines connected with the n-th multiplexing sub-circuit. As shown in FIG. 12B, an n-th sub-multiplexing circuit includes a first multiplexing transistor MT1 to a sixth multiplexing transistor MT6. A gate electrode of the first multiplexing transistor MT1 is electrically connected with the first multiplexing control signal line MUX1, a first electrode of the first multiplexing transistor MT1 is electrically connected with a data signal line connected with one of the first sub-pixel and the second sub-pixel in a pixel unit in an n-th column, and a second electrode of the first multiplexing transistor MT1 is electrically connected with a first data electrical power supply line DSL1 of three data electrical power supply lines connected with the n-th multiplexing sub-circuit. A gate electrode of the second multiplexing transistor MT2 is electrically connected with the first multiplexing control signal line MUX1, a first electrode of the second multiplexing transistor MT2 is electrically connected with a data signal line connected with one of the third sub-pixel and the fourth sub-pixel in the pixel unit in the n-th column, and a second electrode of the second multiplexing transistor MT2 is electrically connected with a second data electrical power supply line DSL2 of the three data electrical power supply lines connected with the n-th multiplexing sub-circuit. A gate electrode of the third multiplexing transistor MT3 is electrically connected with the first multiplexing control signal line MUX1, a first electrode of the third multiplexing transistor MT3 is electrically connected with a data signal line connected with one of the fifth sub-pixel and the sixth sub-pixel in the pixel unit in the n-th column, and a second electrode of the third multiplexing transistor MT3 is electrically connected with a third data electrical power supply line DSL3 of the three data electrical power supply lines connected with the n-th multiplexing sub-circuit. A gate electrode of the fourth multiplexing transistor MT4 is electrically connected with the second multiplexing control signal line MUX2, a first electrode of the fourth multiplexing transistor MT4 is electrically connected with a data signal line connected with the other of the first sub-pixel and the second sub-pixel in the pixel unit in the n-th column, and a second electrode of the fourth multiplexing transistor MT4 is electrically connected with the first data electrical power supply line DSL1 of the three data electrical power supply lines connected with the n-th multiplexing sub-circuit. A gate electrode of the fifth multiplexing transistor MT5 is electrically connected with the second multiplexing control signal line MUX2, a first electrode of the fifth multiplexing transistor MT5 is electrically connected with a data signal line DL connected with the other of the third sub-pixel and the fourth sub-pixel in the pixel unit in the n-th column, and a second electrode of the fifth multiplexing transistor MT5 is electrically connected with the second data electrical power supply line DSL2 of the three data electrical power supply lines connected with the n-th multiplexing sub-circuit. A gate electrode of the sixth multiplexing transistor MT6 is electrically connected with the second multiplexing control signal line MUX2, a first electrode of the sixth multiplexing transistor MT6 is electrically connected with a data signal line DL connected with the other of the fifth sub-pixel and the sixth sub-pixel in the pixel unit in the n-th column, and a second electrode of the sixth multiplexing transistor MT6 is electrically connected with the third data electrical power supply line DSL3 of the three data electrical power supply lines connected with the n-th multiplexing sub-circuit. FIG. 12B is illustrated by taking a case in which the first electrode of the first multiplexing transistor MT1 is electrically connected with the data signal line DL1 connected with the first sub-pixel in the pixel unit in the n-th column, the first electrode of the fourth multiplexing transistor MT4 is electrically connected with the data signal line DL2 connected with the second sub-pixel in the pixel unit in the n-th column, the first electrode of the second multiplexing transistor MT2 is electrically connected with the data signal line DL3 connected with the third sub-pixel in the pixel unit in the n-th column, the first electrode of the fifth multiplexing transistor MT5 is electrically connected with the data signal line DL5 connected with the fifth sub-pixel in the pixel unit in the n-th column, the first electrode of the third multiplexing transistor MT3 is electrically connected with the data signal line DL3 connected with the third sub-pixel in the pixel unit in the n-th column, and the first electrode of the sixth multiplexing transistor MT6 is electrically connected with the data signal line DL6 connected with the sixth sub-pixel in the pixel unit in the n-th column as an example, which is not limited in the present disclosure.

Exemplary description is made below through a preparation process of a display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition. Coating may be any one or more of spray coating, spin coating, and inkjet printing. A "thin film" refers to a layer of thin film made of a certain material on a base substrate using deposition, coating, or other processes. If the "thin film" does not need to be processed through a patterning process in an entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" after the patterning process. "A and B are disposed in a same layer" in the present disclosure means that A and B are formed simultaneously through a same patterning process, and a "thickness" of a film layer is a dimension of the film layer in a direction perpendicular to a display substrate. In an exemplary implementation mode of the present disclosure, "an orthographic projection of B is within a range of an orthographic projection of A" or "an orthographic projection of A contains an orthographic projection of B" refers to that a boundary of the orthographic projection of B falls within a range of a boundary of the orthographic projection of A, or the boundary of the orthographic projection of A is overlapped with the boundary of the orthographic projection of B.

In an exemplary implementation mode, taking one pixel unit as an example, the preparation process of the display substrate may include following operations.

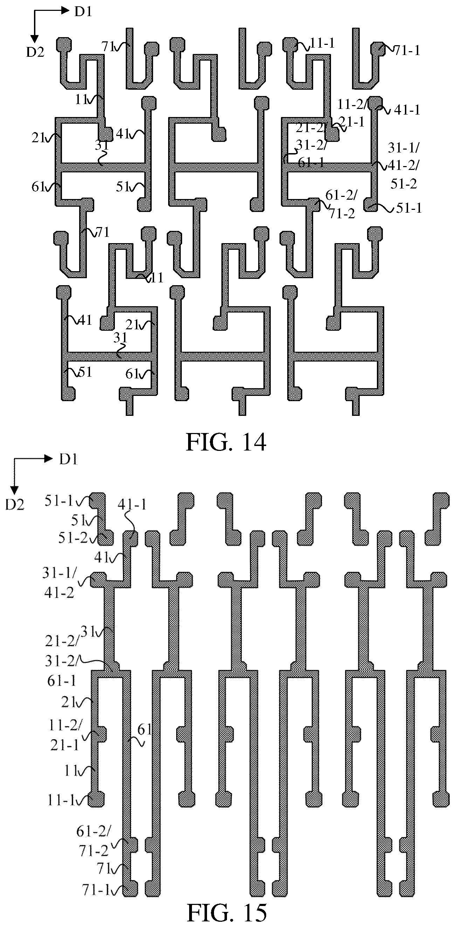

(1) A pattern of a semiconductor layer is formed. In an exemplary implementation mode, forming a pattern of a semiconductor layer may include depositing a semiconductor thin film on a base substrate, and patterning the semiconductor thin film through a patterning process, to form a pattern of a semiconductor layer provided on the base substrate, as shown in FIGs. 13 to 15. FIG. 13 is a schematic diagram of a pattern of a semiconductor layer in the display substrate provided in FIGs. 3 and 5, FIG. 14 is a schematic diagram of a pattern of a semiconductor layer in the display substrate provided in FIG. 7, and FIG. 15 is a schematic diagram of a pattern of a semiconductor layer in the display substrate provided in FIG. 9.

In an exemplary implementation mode, the pattern of the semiconductor layer may include at least an active pattern 11 of a first transistor to an active pattern 71 of a seventh transistor located in at least one sub-pixel.

In an exemplary implementation mode, as shown in FIG. 13, in the display substrate provided in FIGs. 3 and 5, structures of the active pattern 11 of the first transistor to the active pattern 71 of the seventh transistor in all sub-pixels located in a same pixel unit are at least partially the same.

In an exemplary implementation mode, as shown in FIG. 14, in the display substrate provided in FIG. 7, structures of the active pattern 11 of the first transistor to the active pattern 71 of the seventh transistor in the first sub-pixel, the third sub-pixel, and the fifth sub-pixel located in a same pixel unit are at least partially the same; structures of the active pattern 11 of the first transistor to the active pattern 71 of the seventh transistor in the second sub-pixel, the fourth sub-pixel, and the sixth sub-pixel located in a same pixel unit are at least partially the same; and structures of the active pattern 11 of the first transistor to the active pattern 71 of the seventh transistor in the first sub-pixel and the second sub-pixel located in a same pixel unit are provided at least partially in mirror symmetry.

In an exemplary implementation mode, as shown in FIG. 15, in the display substrate provided in FIG. 9, structures of the active pattern 11 of the first transistor to the active pattern 71 of the seventh transistor in adjacent sub-pixels located in a same pixel unit are provided at least partially symmetrically with respect to a virtual straight line extending in the second direction D2.

In an exemplary implementation mode, as shown in FIGs. 13 and 14, in the display substrate provided in FIGs. 3, 5, and 7, the active pattern 11 of the first transistor to the active pattern 61 of the sixth transistor of at least one sub-pixel are of an interconnected integral structure; and in the second direction D2, the active pattern 61 of the sixth transistor of a sub-pixel in a present row and the active pattern 71 of the seventh transistor of a sub-pixel in a next row are connected with each other.

In an exemplary implementation mode, as shown in FIGs. 13 and 14, in the display substrate provided in FIGs. 3, 5, and 7, in the first direction D1, the active pattern 21 of the second transistor and the active pattern 61 of the sixth transistor may be located on a same side of the active pattern 31 of the third transistor of a present sub-pixel; the active pattern 41 of the fourth transistor and the active pattern 51 of the fifth transistor may be located on a same side of the active pattern 31 of the third transistor of the present sub-pixel; and the active pattern 21 of the second transistor and the active pattern 41 of the fourth transistor may be located on different sides of the active pattern 31 of the third transistor of the present sub-pixel. In the second direction D2, the active pattern 11 of the first transistor, the active pattern 21 of the second transistor, the active pattern 41 of the fourth transistor, and the active pattern 71 of the seventh transistor in the present sub-pixel may be located on a side of the active pattern 31 of the third transistor in the present sub-pixel away from a sub-pixel in a next row; and the active pattern 51 of the fifth transistor and the active pattern 61 of the sixth transistor in the present sub-pixel may be located on a side of the active pattern 31 of the third transistor in the present sub-pixel close to the sub-pixel in the next row.

In an exemplary implementation mode, as shown in FIGs. 13 and 14, the active pattern 11 of the first transistor may have a "⇶" shape, the active pattern 21 of the second transistor may have a "⌐" shape, the active pattern 31 of the third transistor may have a "⇝" shape, the active pattern 41 of the fourth transistor and the active pattern 51 of the fifth transistor may have an "I" shape, the active pattern 61 of the sixth transistor may have an "L" shape, and the active pattern 71 of the seventh transistor may have an inverted "n" shape.

In an exemplary implementation mode, as shown in FIG. 15, in the display substrate provided in FIG. 9, the active pattern 11 of the first transistor to the active pattern 41 of the fourth transistor, the active pattern 61 of the sixth transistor, and the active pattern 71 of the seventh transistor of at least one sub-pixel are of an interconnected integral structure, and the active pattern 51 of the fifth transistor is provided separately.

In an exemplary implementation mode, as shown in FIG. 15, in the display substrate provided in FIG. 9, in the second direction D2, the active pattern 41 of the fourth transistor and the active pattern 51 of the fifth transistor in a present sub-pixel may be located on a side of the active pattern 31 of the third transistor in the present sub-pixel away from a sub-pixel in a next row; and the active pattern 11 of the first transistor, the active pattern 21 of the second transistor, the active pattern 61 of the sixth transistor, and the active pattern 71 of the seventh transistor may be located on a side of the active pattern 31 of the third transistor in the present sub-pixel close to the sub-pixel in the next row. The active pattern 11 of the first transistor and the active pattern 21 of the second transistor are arranged in the second direction D2, the active pattern 61 of the sixth transistor and the active pattern 71 of the seventh transistor are arranged in the second direction D2, and the active pattern 11 of the first transistor and the active pattern 61 of the sixth transistor are arranged in the first direction D1.

In an exemplary implementation mode, as shown in FIG. 15, the active pattern 11 of the first transistor, the active pattern 21 of the second transistor, the active pattern 41 of the fourth transistor, the active pattern 51 of the fifth transistor, the active pattern 61 of the sixth transistor, and the active pattern 71 of the seventh transistor may have an "I" shape, and the active pattern 31 of the third transistor may have a " $\underline{\underline{I}}$ " shape.

In an exemplary implementation mode, an active pattern of each transistor may include a first region, a second region, and a channel region located between the first region and the second region. In an exemplary implementation mode, in the display substrate provided in FIGs. 3, 5, and 7, a second region 11-2 of the active pattern 11 of the first transistor may serve as a first region 21-1 of the active pattern 21 of the second transistor; a first region 31-1 of the active pattern 31 of the third transistor may simultaneously serve as a second region 41-2 of the active pattern 41 of the fourth transistor and a second region 51-2 of the active pattern 51 of the fifth transistor; a second region 31-2 of the active pattern 31 of the third transistor may simultaneously serve as the second region 21-2 of the active pattern 21 of the second transistor and a first region 61-1 of the active pattern 61 of the sixth transistor; a second region 61-2 of the active pattern 61 of the sixth transistor may serve as a second region 71-2 of the active pattern 71 of the seventh transistor; and a first region 11-1 of the active pattern 11 of the first transistor, a first region 41-1 of the active pattern 41 of the fourth transistor, a first region 51-1 of the active pattern 51 of the fifth transistor, and a first region 71-1 of the active pattern of the seventh transistor may be provided separately. In the display substrate provided in FIG. 9, the second region 11-2 of the active pattern 11 of the first transistor may serve as the first region 21-1 of the active pattern 21 of the second transistor; the first region 31-1 of the active pattern 31 of the third transistor may simultaneously serve as the second region 41-2 of the active pattern 41 of the fourth transistor; the second region 31-2 of the active pattern 31 of the third transistor may simultaneously serve as the second region 21-2 of the active pattern 21 of the second transistor and the first region 61-1 of the active pattern 61 of the sixth transistor; the second region 61-2 of the active pattern 61 of the sixth transistor may serve as the second region 71-2 of the active pattern 71 of the seventh transistor; and the first region 11-1 of the active pattern of the first transistor, the first region 41-1 of the active pattern 41 of the fourth transistor, the first region 51-1 and the second region 51-2 of the active pattern 51 of the fifth transistor, and the first region 71-1 of the active pattern of the seventh transistor may be provided separately.

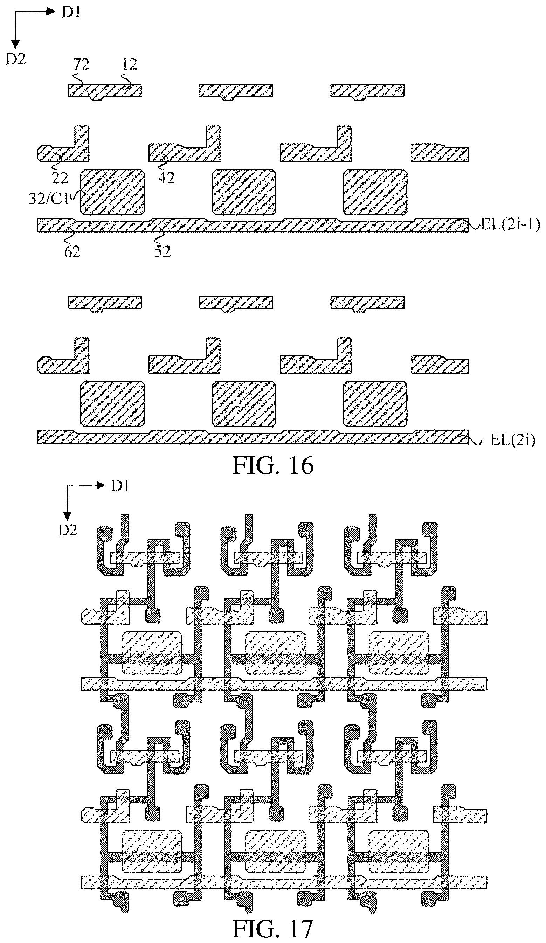

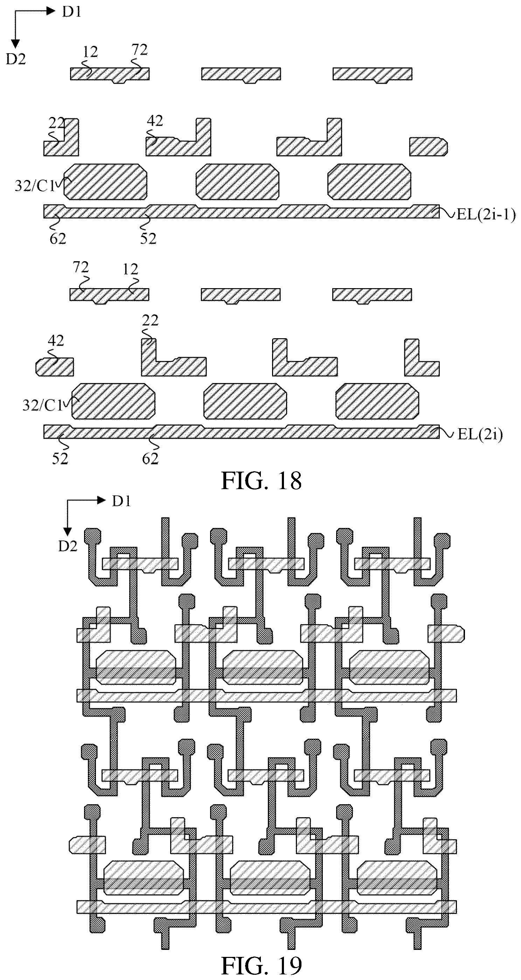

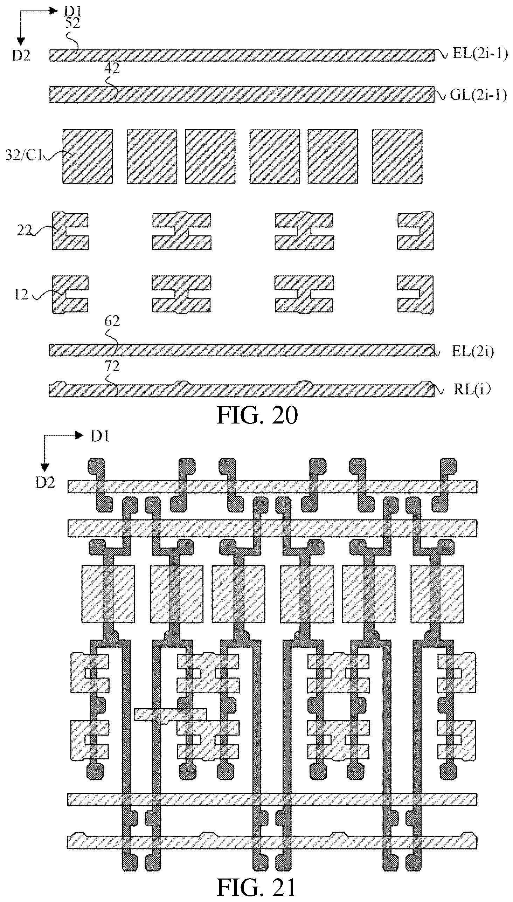

(2) A pattern of a first conductive layer is formed. In an exemplary implementation mode, forming a pattern of a first conductive layer may include sequentially depositing a first insulation thin film and a first conductive thin film on the base substrate on which the aforementioned pattern is formed, and patterning the first conductive thin film through a patterning process, to form a first insulation layer covering the pattern of the semiconductor layer, and a pattern of a first conductive layer provided on the first insulation layer, as shown in FIGs. 16 to 21. FIG. 16 is a schematic diagram of a pattern of a first conductive layer in the display substrate provided in FIGs. 3 and 5. FIG. 17 is a schematic diagram of the display substrate provided in FIGs. 3 and 5 after a pattern of a first conductive layer is formed. FIG. 18 is a schematic diagram of a pattern of a first conductive layer in the display substrate provided in FIG. 7. FIG. 19 is a schematic diagram of the display substrate provided in FIG. 7 after a pattern of a first conductive layer is formed. FIG. 20 is a schematic diagram of a pattern of a first conductive layer in the display substrate provided in FIG. 9. FIG. 21 is a schematic diagram of the display substrate provided in FIG. 9 after a pattern of a first conductive layer is formed. In an exemplary implementation mode, the first conductive layer may be referred to as a first gate metal (GATE1) layer.

In an exemplary implementation mode, as shown in FIGs. 16 to 19, in the display substrate provided in FIGs. 3, 5, and 7, the pattern of the first conductive layer at least includes a light emitting signal line EL, and a gate electrode 12 of a first transistor to a gate electrode 72 of a seventh transistor and a first electrode plate 24 of a capacitor located in at least one sub-pixel.

In an exemplary implementation mode, as shown in FIGs. 16 and 17, in the display substrate provided in FIGs. 3 and 5, structures of gate electrodes 12 of first transistors to gate electrodes 72 of seventh transistors and first electrode plates C1 of capacitors of all sub-pixels located in a same pixel unit are at least partially the same.

In an exemplary implementation mode, as shown in FIGs. 18 and 19, in the display substrate provided in FIG. 7, structures of gate electrodes 12 of first transistors to gate electrodes 72 of seventh transistors, and first electrode plates C1 of capacitors in the first sub-pixel, the third sub-pixel, and the fifth sub-pixel located in a same pixel unit are at least partially the same; structures of gate electrodes 12 of first transistors to gate electrodes 72 of seventh transistors, and first electrode plates C1 of capacitors in the second sub-pixel, the fourth sub-pixel, and the sixth sub-pixel located in a same pixel unit are at least partially the same; structures of gate electrodes 12 of first transistors to gate electrodes 72 of seventh transistors, and first electrode plates C1 of capacitors in the first sub-pixel and the second sub-pixel located in a same pixel unit are provided at least partially in mirror symmetry.

In an exemplary implementation mode, as shown in FIGs. 16 to 19, in the display substrate provided in FIGs. 3, 5, and 7, the first electrode plate C1 and the gate electrode 32 of the third transistor are of an integral structure. The integral structure of the first electrode plate C1 and the gate electrode 32 of the third transistor may have a rectangular shape, and corners of the rectangular shape may be provided with chamfers. An orthographic projection of the integral structure of the first electrode plate C1 and the gate electrode 32 of the third transistor on the base substrate is at least partially overlapped with an orthographic projection of the active pattern of the third transistor on the base substrate.

In an exemplary implementation mode, as shown in FIGs. 16 to 19, the light emitting signal line EL may have a line shape in which a main body portion extends in the first direction D1, and a light emitting signal line EL in a present sub-pixel may be located on a side of the integral structure of the first electrode plate C1 and the gate electrode 32 of the third transistor close to a sub-pixel in a next row. A region where the light emitting signal line EL is overlapped with the active pattern of the fifth transistor of the present sub-pixel serves as the gate electrode 52 of the fifth transistor, and a region where the light emitting signal line EL is overlapped with the active pattern of the sixth transistor of the present sub-pixel serves as the gate electrode 62 of the sixth transistor.

In an exemplary implementation mode, as shown in FIGs. 16 to 19, the gate electrode 12 of the first transistor and the gate electrode 72 of the seventh transistor in a same sub-pixel are of an integral structure. The integral structure of the gate electrode 12 of the first transistor and the gate electrode 72 of the seventh transistor has a strip shape and extends in the first direction D1. In an exemplary implementation mode, as shown in FIGs. 16 to 19, the gate electrode 42 of the fourth transistor and the gate electrode 22 of the second transistor in a same sub-pixel are provided separately. The gate electrode 42 of the fourth transistor has a strip shape and extends in the first direction D1. The gate electrode 22 of the second transistor has a "⌐" shape. The gate electrode 42 of the fourth transistor of a sub-pixel in an m-th column and the gate electrode 22 of the second transistor of a sub-pixel in an (m+1)-th column located in a same row are of an integral structure.

In an exemplary implementation mode, as shown in FIGs. 16 to 19, there are two overlapping regions of the gate electrode 12 of the first transistor and the active pattern of the first transistor, so the first transistor may have a dual-gate structure. There are two overlapping regions of the gate electrode 22 of the second transistor and the active pattern of the second transistor, so the second transistor may have a dual-gate structure.

In an exemplary implementation mode, as shown in FIGs. 20 and 21, in the display substrate provided in FIG. 9, the pattern of the first conductive layer at least includes an odd-numbered light emitting signal line EL(2i-1), an even-numbered light emitting signal line EL(2i), a first sub-scan signal line GL1(2i-1) of an odd-numbered scan signal line, a first sub-reset signal line RL1(2i) of an even-numbered reset signal line, and a gate electrode 12 of a first transistor to a gate electrode 72 of a seventh transistor and a first electrode plate 24 of a capacitor located in at least one sub-pixel.

In an exemplary implementation mode, as shown in FIGs. 20 and 21, in the display substrate provided in FIG. 9, structures of gate electrodes 12 of first transistors to gate electrodes 72 of seventh transistors and first electrode plates C1 of capacitors in adjacent sub-pixels located in a same pixel unit are provided at least partially symmetrically with respect to a virtual straight line extending in the second direction D2.

In an exemplary implementation mode, as shown in FIGs. 20 and 21, in the display substrate provided in FIG. 9, the first electrode plate C1 and the gate electrode 32 of the third transistor are of an integral structure. The integral structure of the first electrode plate C1 and the gate electrode 32 of the third transistor may have a rectangular shape, and corners of the rectangular shape may be provided with chamfers. An orthographic projection of the integral structure of the first electrode plate C1 and the gate electrode 32 of the third transistor on the base substrate is at least partially overlapped with an orthographic projection of the active pattern of the third transistor on the base substrate.

In an exemplary implementation mode, as shown in FIGs. 20 and 21, the odd-numbered light emitting signal line EL(2i-1) may have a line shape in which a main body portion extends in the first direction D1, and the odd-numbered light emitting signal line EL(2i-1) in a present sub-pixel may be located on a side of the integral structure of the first electrode plate C1 and the gate electrode 32 of the third transistor away from a sub-pixel in a next row. A region where the odd-numbered light emitting signal line EL(2i-1) is overlapped with the active pattern of the fifth transistor of the present sub-pixel serves as the gate electrode 52 of the fifth transistor.

In an exemplary implementation mode, as shown in FIGs. 20 and 21, the even-numbered light emitting signal line EL(2i) may have a line shape in which a main body portion extends in the first direction D1, and the even-numbered light emitting signal line EL(2i) in a present sub-pixel may be located on a side of the integral structure of the first electrode plate C1 and the gate electrode 32 of the third transistor close to a sub-pixel in a next row. A region where the even-numbered light emitting signal line EL(2i) is overlapped with the active pattern of the sixth transistor of the present sub-pixel serves as the gate electrode 62 of the sixth transistor.

In an exemplary implementation mode, as shown in FIGs. 20 and 21, the first sub-scan signal line GL1(2i-1) of the odd-numbered scan signal line may have a line shape in which a main body portion extends in the first direction D1, and the first sub-scan signal line GL1(2i-1) of the odd-numbered scan signal line in a present sub-pixel may be located between the odd-numbered light emitting signal line EL(2i-1) and the integral structure of the first electrode plate C1 and the gate electrode 32 of the third transistor. A region where the first sub-scan signal line GL1(2i-1) of the odd-numbered scan signal line is overlapped with the active pattern of the fourth transistor of the present sub-pixel serves as the gate electrode 42 of the fourth transistor.

In an exemplary implementation mode, as shown in FIGs. 20 and 21, the first sub-reset signal line RL1(2i) of the even-numbered reset signal line may have a line shape in which a main body portion extends in the first direction D1, and the first sub-reset signal line RL1(2i) of the even-numbered reset signal line in a present sub-pixel may be located on a side of the even-numbered light emitting signal line EL(2i) away from the integral structure of the first electrode plate C1 and the gate electrode 32 of the third transistor. A region where the first sub-reset signal line RL1(2i) of the even-numbered reset signal line is overlapped with the active pattern of the seventh transistor of a present sub-pixel serves as the gate electrode 72 of the seventh transistor.

In an exemplary implementation mode, as shown in FIGs. 20 and 21, the gate electrode 12 of the first transistor and the gate electrode 22 of the second transistor in a sub-pixel are located between the integral structure of the first electrode plate C1 and the gate electrode 32 of the third transistor in the sub-pixel and the even-numbered light emitting signal line EL(2i) connected with the sub-pixel. The gate electrode 12 of the first transistor and the gate electrode 22 of the second transistor in a same sub-pixel are provided separately. The gate electrode 12 of the first transistor and the gate electrode 22 of the second transistor have a "⌐" shape. The gate electrode 12 of the first transistor in the second sub-pixel and the gate electrode 12 of the first transistor in the third sub-pixel located in a same sub-pixel are of an integral structure and have a "⊥" shape, and the gate electrode 12 of the first transistor in the fourth sub-pixel and the gate electrode 12 of the first transistor in the fifth sub-pixel are of an integral structure and have a "⊥" shape. The gate electrode 22 of the second transistor in the second sub-pixel and the gate electrode 22 of the second transistor in the third sub-pixel located in a same sub-pixel are of an integral structure and have a "⊥" shape, and the gate electrode 22 of the second transistor in the fourth sub-pixel and the gate electrode 22 of the second transistor in the fifth sub-pixel of an integral structure and have a "⊥" shape.

In an exemplary implementation mode, as shown in FIGs. 20 and 21, the odd-numbered light emitting signal line EL(2i-1), the even-numbered light emitting signal line EL(2i), the first sub-scan signal line GL1(2i-1) of the odd-numbered scan signal line, and the first sub-reset signal line RL1(2i) of the even-numbered reset signal line may be of an equal width design, or may be of a non-equal width design, may be straight lines, or may be polylines, which not only may facilitate a layout of a pixel structure, but also may reduce a parasitic capacitance between signal lines, which is not limited herein in the present disclosure.

In an exemplary implementation mode, after the pattern of the first conductive layer is formed, a conductive treatment may be performed on the semiconductor layer by using the first conductive layer as a shield. The semiconductor layer, in a region which is shielded by the first conductive layer, forms channel regions of the first transistor to the seventh transistor, and the semiconductor layer, in a region which is not shielded by the first conductive layer, is made to be conductive, that is, first regions and second regions of the first transistor T1 to the seventh active pattern are all made to be conductive.

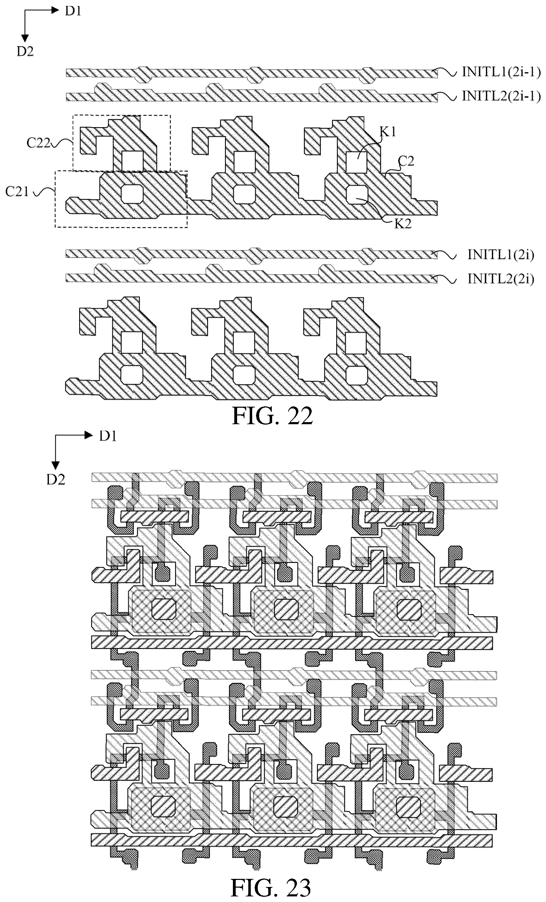

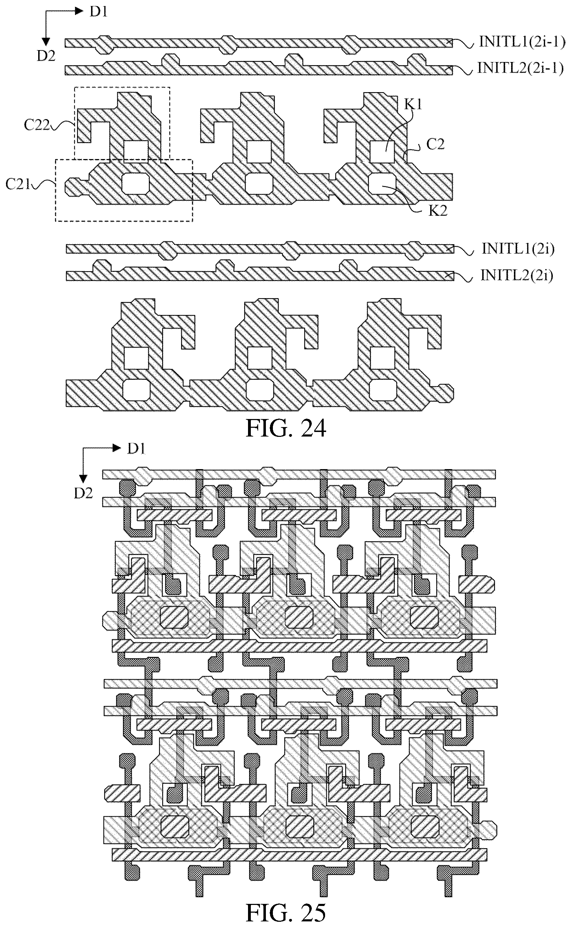

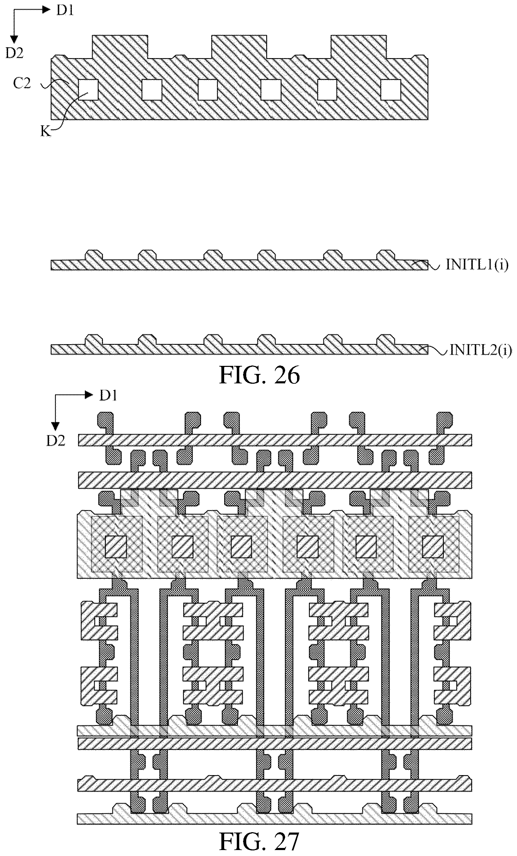

(5) A pattern of a second conductive layer is formed. In an exemplary implementation mode, forming a pattern of a second conductive layer may include depositing a second insulation thin film and a second conductive thin film on the base substrate on which the aforementioned patterns are formed, and patterning the second conductive thin film through a patterning process, to form a second insulation layer covering the base substrate and form a pattern of a second conductive layer provided on the second insulation layer, as shown in FIGs. 22 and 27. FIG. 22 is a schematic diagram of a pattern of a second conductive layer in the display substrate provided in FIGs. 3 and 5. FIG. 23 is a schematic diagram of the display substrate provided in FIGs. 3 and 5 after a pattern of a second conductive layer is formed. FIG. 24 is a schematic diagram of a pattern of a second conductive layer in the display substrate provided in FIG. 7. FIG. 25 is a schematic diagram of the display substrate provided in FIG. 7 after a pattern of a second conductive layer is formed. FIG. 26 is a schematic diagram of a pattern of a second conductive layer in the display substrate provided in FIG. 9. FIG. 27 is a schematic diagram of the display substrate provided in FIG. 9 after a pattern of a second conductive layer is formed. In an exemplary implementation mode, the second conductive layer may be referred to as a second gate metal (GATE2) layer.

In an exemplary implementation mode, as shown in FIGs. 22 to 27, in the display substrate provided in FIGs. 3, 5, 7, and 9, the pattern of the second conductive layer at least includes a first initial signal line INITL1, a second initial signal line INITL2, and a first electrode plate C2 of a capacitor located in at least one sub-pixel.

In an exemplary implementation mode, as shown in FIGs. 22 and 23, in the display substrate provided in FIGs. 3 and 5, structures of first electrode plates C2 of capacitors of all sub-pixels located in a same pixel unit are at least partially the same.

In an exemplary implementation mode, as shown in FIGs. 24 and 25, in the display substrate provided in FIG. 7, structures of first electrode plates C2 of capacitors in the first sub-pixel, the third sub-pixel, and the fifth sub-pixel located in a same pixel unit are at least partially the same; structures of first electrode plates C2 of capacitors in the second sub-pixel, the fourth sub-pixel, and the sixth sub-pixel located in a same pixel unit are at least partially the same; and structures of first electrode plates C2 of capacitors in the first sub-pixel and the second sub-pixel located in a same pixel unit are provided at least partially in mirror symmetry.

In an exemplary implementation mode, as shown in FIGs. 22 to 25, in the display substrate provided in FIGs. 3, 5, and 7, the second electrode plate C2 includes a capacitor main body portion C21 and a capacitor connection portion C22 connected with each other. The capacitor connection portion C22 is located on a side of the capacitor main body portion C21 close to the second initial signal line INITL2. An outline of the capacitor main body portion C21 may have a rectangular shape, and corners of the rectangular shape may be provided with chamfers. An orthographic projection of the capacitor main body portion C21 on the base substrate is at least partially overlapped with an orthographic projection of the first electrode plate on the base substrate. The capacitor main body portion C21 is provided with an opening K2, and the opening K2 may have a rectangular shape and may be located in a middle of the capacitor main body portion C21, so that the capacitor main body portion C21 forms an annular structure. The opening K2 exposes the second insulation layer covering the first electrode plate, and an orthographic projection of the first electrode plate on the base substrate contains an orthographic projection of the opening K2 on the base substrate. An opening K1 is formed between the capacitor connection portion C22 and the capacitor main body portion C21. The opening K1 may have a rectangular shape, and the opening K2 exposes the second insulation layer covering a second region of the active pattern of the first transistor (which is also ae first region of the active pattern of the second transistor). An orthographic projection of the capacitor connection portion C22 on the base substrate is partially overlapped with a portion of the active pattern of the first transistor. A portion of a structure of the capacitor connection portion C22 fits with a portion of a structure of a gate electrode of the second transistor.

In an exemplary implementation mode, as shown in FIGs. 22 to 25, capacitor main body portions of second capacitors of adjacent sub-pixels located in a same row are connected with each other, which may ensure display uniformity of the display substrate.

In an exemplary implementation mode, as shown in FIGs. 22 to 25, the first initial signal line INITL1 may have a line shape in which a main body portion extends in the first direction D1. The first initial signal line INITL1 connected with a present sub-pixel may be located on a side of the first electrode plate C2 of the present sub-pixel away from a sub-pixel in a next row.

In an exemplary implementation mode, as shown in FIGs. 22 to 25, the second initial signal line INITL2 may have a line shape in which a main body portion extends in the first direction D1. The second initial signal line INITL2 connected with a present sub-pixel may be located between the first initial signal line INITL1 connected with the present sub-pixel and the first electrode plate C2 of the present sub-pixel.

In an exemplary implementation mode, as shown in FIGs. 26 and 27, in the display substrate provided in FIG. 9, structures of first electrode plates C2 of capacitors of adjacent sub-pixels located in a same pixel unit are provided at least partially symmetrically with respect to a virtual straight line extending in the second direction D2.

In an exemplary implementation mode, as shown in FIGs. 26 and 27, in the display substrate provided in FIG. 9, an outline of the second electrode plate C2 may have a rectangular shape, and corners of the rectangular shape may be provided with chamfers. An orthographic projection of the second electrode plate C2 on the base substrate is at least partially overlapped with an orthographic projection of the first electrode plate on the base substrate. The second electrode plate C2 is provided with an opening K. The opening K may have a rectangular shape and may be located in a middle of the second electrode plate C2, so that the second electrode plate C2 forms an annular structure. The opening K exposes the second insulation layer covering the first electrode plate, and an orthographic projection of the first electrode plate on the base substrate contains an orthographic projection of the opening K on the base substrate.

In an exemplary implementation mode, as shown in FIGs. 22 to 25, second capacitors of adjacent sub-pixels located in a same row are connected with each other, which may ensure display uniformity of the display substrate.

In an exemplary implementation mode, as shown in FIGs. 22 to 25, the first initial signal line INITL1 may have a line shape in which a main body portion extends in the first direction D1. The first initial signal line INITL1 connected with a present sub-pixel may be located on a side of the first electrode plate C2 of the present sub-pixel close to a sub-pixel in a next row.

In an exemplary implementation mode, as shown in FIGs. 22 to 25, the second initial signal line INITL2 may have a line shape in which a main body portion extends in the first direction D1. The second initial signal line INITL2 connected with a present sub-pixel may be located between the first initial signal line INITL1 connected with the present sub-pixel and the first electrode plate C2 of the present sub-pixel.

In an exemplary implementation mode, as shown in FIGs. 22 to 27, the first initial signal line INITL1 and the second initial signal line INITL2 may be of an equal width design, or may be of a non-equal width design, may be straight lines, or may be polylines, which not only may facilitate a layout of a pixel structure, but also may reduce a parasitic capacitance between signal lines, which is not limited herein in the present disclosure.

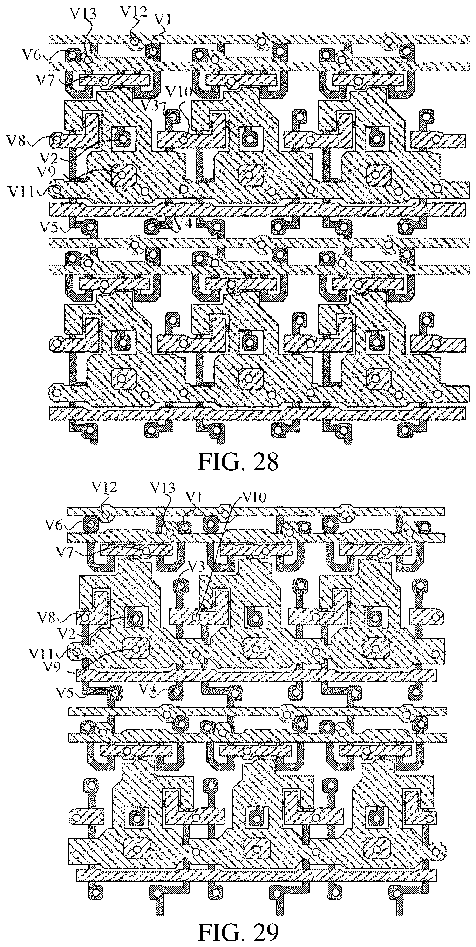

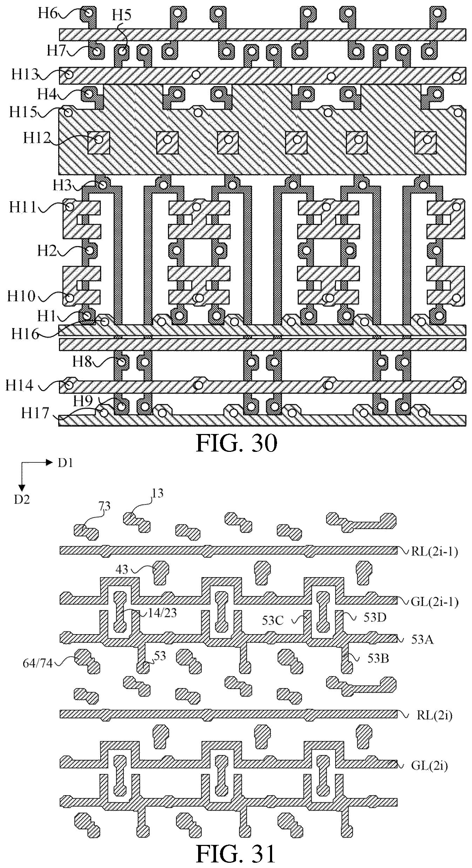

(4) A pattern of a third insulation layer is formed. In an exemplary implementation mode, forming a pattern of a third insulation layer may include depositing a third insulation thin film on the base substrate on which the aforementioned patterns are formed, and patterning the third insulation thin film through a patterning process, to form a third insulation layer covering the second conductive layer, the third insulation layer being provided with multiple vias, as shown in FIGs. 28 to 31. FIG. 28 is a schematic diagram of the display substrate provided in FIGs. 3 and 5 after a third insulation layer is formed. FIG. 29 is a schematic diagram of the display substrate provided in FIG. 7 after a third insulation layer is formed. FIG. 30 is a schematic diagram of the display substrate provided in FIG. 9 after a third insulation layer is formed.

In an exemplary implementation mode, as shown in FIGs. 28 and 29, in the display substrate provided in FIGs. 3, 5, and 7, the multiple vias of the third insulation layer at least include a first via V1, a second via V2, a third via V3, a fourth via V4, a fifth via V5, a sixth via V6, a seventh via V7, an eighth via V8, a ninth via V9, a tenth via V10, an eleventh via V11, a twelfth via V12, and a thirteenth via V13.

In an exemplary implementation mode, an orthographic projection of the first via V1 on the base substrate is located within a range of an orthographic projection of the first region of the active pattern of the first transistor on the base substrate. The first insulation layer and the second insulation layer in the first via V1 are etched away, exposing a surface of the first region of the active pattern of the first transistor. The first via V1 is configured such that a first electrode of the first transistor formed subsequently is connected with the first region of the active pattern of the first transistor through the via.

In an exemplary implementation mode, an orthographic projection of the second via V2 on the base substrate is located within a range of an orthographic projection of the second region of the active pattern of the first transistor (also the first region of the active pattern of the second transistor) on the base substrate. The first insulation layer and the second insulation layer in the second via V2 are etched away, exposing a surface of the second region of the active pattern of the first transistor (also the first region of the active pattern of the second transistor). The second via V2 is configured such that a second electrode of the first transistor formed subsequently (also the first electrode of the second transistor) is connected with the second region of the active pattern of the first transistor (also the first region of the active pattern of the second transistor) through the via.

In an exemplary implementation mode, an orthographic projection of the third via V3 on the base substrate is located within a range of an orthographic projection of the first region of the active pattern of the fourth transistor on the base substrate. The first insulation layer and the second insulation layer in the third via V3 are etched away, exposing a surface of the first region of the active pattern of the fourth transistor. The third via V3 is configured such that a first electrode of the fourth transistor formed subsequently is connected with the first region of the active pattern of the fourth transistor through the via.

In an exemplary implementation mode, an orthographic projection of the fourth via V4 on the base substrate is located within a range of an orthographic projection of the first region of the active pattern of the fifth transistor on the base substrate. The first insulation layer and the second insulation layer in the fourth via V4 are etched away, exposing a surface of the first region of the active pattern of the fifth transistor. The fourth via V4 is configured such that a first electrode of the fifth transistor formed subsequently is connected with the first region of the active pattern of the fifth transistor through the via.

In an exemplary implementation mode, an orthographic projection of the fifth via V5 on the base substrate is located within a range of an orthographic projection of the second region of the active pattern of the sixth transistor (also the second region of the active pattern of the seventh transistor) on the base substrate. The first insulation layer and the second insulation layer in the fifth via V5 are etched away, exposing a surface of the second region of the active pattern of the sixth transistor (also the second region of the active pattern of the seventh transistor). The fifth via V5 is configured such that a second electrode of the sixth transistor formed subsequently (also the second electrode of the seventh transistor) is connected with the second region of the active pattern of the sixth transistor (also the second region of the active pattern of the seventh transistor) through the via.

In an exemplary implementation mode, an orthographic projection of the sixth via V6 on the base substrate is located within a range of an orthographic projection of the first region of the active pattern of the seventh transistor on the base substrate. The first insulation layer and the second insulation layer in the sixth via V6 are etched away, exposing a surface of the first region of the active pattern of the seventh transistor. The sixth via V6 is configured such that a first electrode of the seventh transistor formed subsequently is connected with the first region of the active pattern of the seventh transistor through the via.

In an exemplary implementation mode, an orthographic projection of the seventh via V7 on the base substrate is located within a range of an orthographic projection of the gate electrode of the first transistor (also the gate electrode of the seventh transistor) on the base substrate. The second insulation layer in the seventh via V7 is etched away, exposing a surface of the gate electrode of the first transistor (also the gate electrode of the seventh transistor). The seventh via V7 is configured such that a reset signal line formed subsequently is connected with the gate electrode of the first transistor (also the gate electrode of the seventh transistor) through the via.

In an exemplary implementation mode, an orthographic projection of the eighth via V8 on the base substrate is located within a range of an orthographic projection of the gate electrode of the second transistor on the base substrate. The second insulation layer in the eighth via V8 is etched away, exposing a surface of the gate electrode of the second transistor. The eighth via V8 is configured such that a scan signal line formed subsequently is connected with the gate electrode of the second transistor through the via.

In an exemplary implementation mode, an orthographic projection of the ninth via V9 on the base substrate is located within a range of an orthographic projection of the gate electrode of the third transistor (also the first electrode plate of the capacitor) on the base substrate. The second insulation layer in the ninth via V9 is etched away, exposing a surface of the gate electrode of the third transistor (also the first electrode plate of the capacitor). The ninth via V9 is configured such that a second electrode of the first transistor (also the first electrode of the second transistor) formed subsequently is connected with the gate electrode of the third transistor (also the first electrode plate of the capacitor) through the via.

In an exemplary implementation mode, an orthographic projection of the tenth via V10 on the base substrate is located within a range of an orthographic projection of the gate electrode of the fourth transistor on the base substrate. The second insulation layer in the tenth via V10 is etched away, exposing a surface of the gate electrode of the fourth transistor. The tenth via V10 is configured such that a scan signal line formed subsequently is connected with the gate electrode of the fourth transistor through the via.

In an exemplary implementation mode, an orthographic projection of the eleventh via V11 on the base substrate is located within a range of an orthographic projection of the second electrode plate of the capacitor on the base substrate. The eleventh via V11 exposes a surface of the second electrode plate of the capacitor. The eleventh via V11 is configured such that a first electrode of the fifth transistor formed subsequently is connected with the second electrode plate of the capacitor through the via.

In an exemplary implementation mode, an orthographic projection of the twelfth via V12 on the base substrate is located within a range of an orthographic projection of the first initial signal line on the base substrate. The twelfth via V12 exposes a surface of the first initial signal line. The twelfth via V12 is configured such that a first electrode of the first transistor formed subsequently is connected with the first initial signal line through the via.

In an exemplary implementation mode, an orthographic projection of the thirteenth via V13 on the base substrate is located within a range of an orthographic projection of the second initial signal line on the base substrate. The thirteenth via V13 exposes a surface of the second initial signal line. The thirteenth via V13 is configured such that a first electrode of the seventh transistor formed subsequently is connected with the second initial signal line through the via.

In an exemplary implementation mode, in the display substrate provided in FIGs. 3, 5, and 7, the tenth via V10 of a sub-pixel in an n-th column and the eighth via V8 of a sub-pixel in an (n+1)-th column located in a same row are a same via.

In an exemplary implementation mode, as shown in FIG. 30, in the display substrate provided in FIG. 9, the multiple vias of the third insulation layer at least include a first via H1, a second via H2, a third via H3, a fourth via H4, a fifth via H5, a sixth via H6, a seventh via H7, an eighth via H8, a ninth via H9, a tenth via H10, an eleventh via H11, a twelfth via H12, a thirteenth via H13, a fourteenth via H14, a fifteenth via H15, a sixteenth via H16, and a seventeenth via H17.

In an exemplary implementation mode, an orthographic projection of the first via H1 on the base substrate is located within a range of an orthographic projection of the first region of the active pattern of the first transistor on the base substrate. The first insulation layer and the second insulation layer in the first via H1 are etched away, exposing a surface of the first region of the active pattern of the first transistor. The first via H1 is configured such that a first electrode of the first transistor formed subsequently is connected with the first region of the active pattern of the first transistor through the via.

In an exemplary implementation mode, an orthographic projection of the second via H2 on the base substrate is located within a range of an orthographic projection of the second region of the active pattern of the first transistor (also the first region of the active pattern of the second transistor) on the base substrate. The first insulation layer and the second insulation layer in the second via H2 are etched away, exposing a surface of the second region of the active pattern of the first transistor (also the first region of the active pattern of the second transistor). The second via H2 is configured such that a second electrode of the first transistor formed subsequently (also the first electrode of the second transistor) is connected with the second region of the active pattern of the first transistor (also the first region of the active pattern of the second transistor) through the via.

In an exemplary implementation mode, an orthographic projection of the third via H3 on the base substrate is located within a range of an orthographic projection of the second region of the active pattern of the second transistor (also the second region of the active pattern of the third transistor and the first region of the active pattern of the sixth transistor) on the base substrate. The first insulation layer and the second insulation layer in the third via H3 are etched away, exposing a surface of the second region of the active pattern of the second transistor (also the second region of the active pattern of the third transistor and the first region of the active pattern of the sixth transistor). The third via H3 is configured such that a second electrode of the second transistor (also a second electrode of the third transistor and a first electrode of the sixth transistor) formed subsequently is connected with the second region of the active pattern of the second transistor (also the second region of the active pattern of the third transistor and the first region of the active pattern of the sixth transistor) through the via.

In an exemplary implementation mode, an orthographic projection of the fourth via H4 on the base substrate is located within a range of an orthographic projection of the first region of the active pattern of the third transistor (also the second region of the active pattern of the fourth transistor) on the base substrate. The first insulation layer and the second insulation layer in the fourth via H4 are etched away, exposing a surface of the first region of the active pattern of the third transistor (also the second region of the active pattern of the fourth transistor). The fourth via H4 is configured such that a first electrode of the third transistor formed subsequently (also the second electrode of the fourth transistor) is connected with the first region of the active pattern of the third transistor (also the second region of the active pattern of the fourth transistor) through the via.

In an exemplary implementation mode, an orthographic projection of the fifth via H5 on the base substrate is located within a range of an orthographic projection of the first region of the active pattern of the fourth transistor on the base substrate. The first insulation layer and the second insulation layer in the fifth via H5 are etched away, exposing a surface of the first region of the active pattern of the fourth transistor. The fifth via H5 is configured such that a first electrode of the fourth transistor formed subsequently is connected with the first region of the active pattern of the fourth transistor through the via.

In an exemplary implementation mode, an orthographic projection of the sixth via H6 on the base substrate is located within a range of an orthographic projection of the first region of the active pattern of the fifth transistor on the base substrate. The first insulation layer and the second insulation layer in the sixth via H6 are etched away, exposing a surface of the first region of the active pattern of the fifth transistor. The sixth via H6 is configured such that a first electrode of the fifth transistor formed subsequently is connected with the first region of the active pattern of the fifth transistor through the via.

In an exemplary implementation mode, an orthographic projection of the seventh via H7 on the base substrate is located within a range of an orthographic projection of the second region of the active pattern of the fifth transistor on the base substrate. The first insulation layer and the second insulation layer in the seventh via H7 are etched away, exposing a surface of the second region of the active pattern of the fifth transistor. The seventh via H7 is configured such that a second electrode of the fifth transistor formed subsequently is connected with the second region of the active pattern of the fifth transistor through the via.

In an exemplary implementation mode, an orthographic projection of the eighth via H8 on the base substrate is located within a range of an orthographic projection of the second region of the active pattern of the sixth transistor (also the second region of the active pattern of the seventh transistor) on the base substrate. The first insulation layer and the second insulation layer in the eighth via H8 are etched away, exposing a surface of the second region of the active pattern of the sixth transistor (also the second region of the active pattern of the seventh transistor). The eighth via H8 is configured such that a second electrode of the sixth transistor formed subsequently (also the second electrode of the seventh transistor) is connected with the second region of the active pattern of the sixth transistor (also the second region of the active pattern of the seventh transistor) through the via.

In an exemplary implementation mode, an orthographic projection of the ninth via H9 on the base substrate is located within a range of an orthographic projection of the first region of the active pattern of the seventh transistor on the base substrate. The first insulation layer and the second insulation layer in the ninth via H9 are etched away, exposing a surface of the first region of the active pattern of the seventh transistor. The ninth via H9 is configured such that a first electrode of the seventh transistor formed subsequently is connected with the first region of the active pattern of the seventh transistor through the via.

In an exemplary implementation mode, an orthographic projection of the tenth via H10 on the base substrate is within a range of an orthographic projection of the gate electrode of the first transistor on the base substrate. The second insulation layer in the tenth via H10 is etched away, exposing a surface of the gate electrode of the first transistor (also the gate electrode of the seventh transistor). The tenth via H10 is configured such that an odd-numbered reset signal line formed subsequently is connected with the gate electrode of the first transistor through the via.

In an exemplary implementation mode, an orthographic projection of the eleventh via H11 on the base substrate is within a range of an orthographic projection of the gate electrode of the second transistor on the base substrate. The second insulation layer in the eleventh via H11 is etched away, exposing a surface of the gate electrode of the second transistor. The eleventh via H11 is configured such that an even-numbered scan signal line formed subsequently is connected with the gate electrode of the second transistor through the via.

In an exemplary implementation mode, an orthographic projection of the twelfth via H12 on the base substrate is located within a range of an orthographic projection of the gate electrode of the third transistor (also the first electrode plate of the capacitor) on the base substrate. The second insulation layer in the twelfth via H12 is etched away, exposing a surface of the gate electrode of the third transistor (also the first electrode plate of the capacitor). The twelfth via H12 is configured such that a first connection electrode formed subsequently is connected with the gate electrode of the third transistor (also the first electrode plate of the capacitor) through the via.

In an exemplary implementation mode, an orthographic projection of the thirteenth via H13 on the base substrate is located within a range of an orthographic projection of the first sub-scan signal line of the odd-numbered scan signal line on the base substrate. The second insulation layer in the thirteenth via H13 is etched away, exposing a surface of the first sub-scan signal line of the odd-numbered scan signal line. The thirteenth via H13 is configured such that a second sub-scan signal line of the odd-numbered scan signal line formed subsequently is connected with the first sub-scan signal line of the odd-numbered scan signal line through the via.

In an exemplary implementation mode, an orthographic projection of the fourteenth via H14 on the base substrate is located within a range of an orthographic projection of the first sub-reset signal line of the even-numbered reset signal line on the base substrate. The second insulation layer in the fourteenth via H14 is etched away, exposing a surface of the first sub-reset signal line of the even-numbered reset signal line. The fourteenth via H14 is configured such that a second sub-reset signal line of the even-numbered reset signal line formed subsequently is connected with the first sub-reset signal line of the even-numbered reset signal line through the via.

In an exemplary implementation mode, an orthographic projection of the fifteenth via H15 on the base substrate is located within a range of an orthographic projection of the second electrode plate of the capacitor on the base substrate. The fifteenth via H15 exposes a surface of the second electrode plate of the capacitor. The fifteenth via H15 is configured such that a power connection line formed subsequently is connected with the second electrode plate of the capacitor through the via.

In an exemplary implementation mode, an orthographic projection of the sixteenth via H16 on the base substrate is located within a range of an orthographic projection of the first initial signal line on the base substrate. The sixteenth via H16 exposes a surface of the first initial signal line. The sixteenth via H16 is configured such that a first electrode of the first transistor formed subsequently is connected with the first initial signal line through the via.

In an exemplary implementation mode, an orthographic projection of the seventeenth via H17 on the base substrate is located within a range of an orthographic projection of the second initial signal line on the base substrate. The seventeenth via H17 exposes a surface of the second initial signal line. The seventeenth via H17 is configured such that a first electrode of the seventh transistor formed subsequently is connected with the second initial signal line through the via.

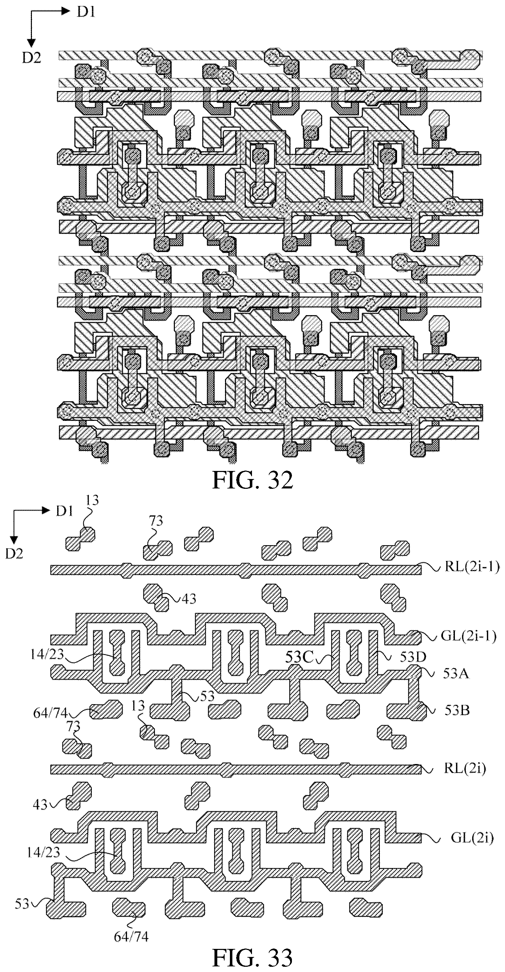

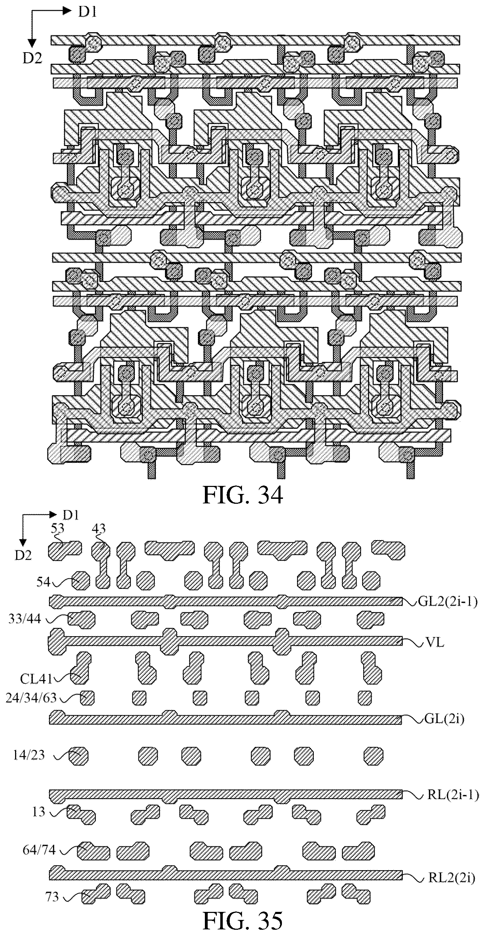

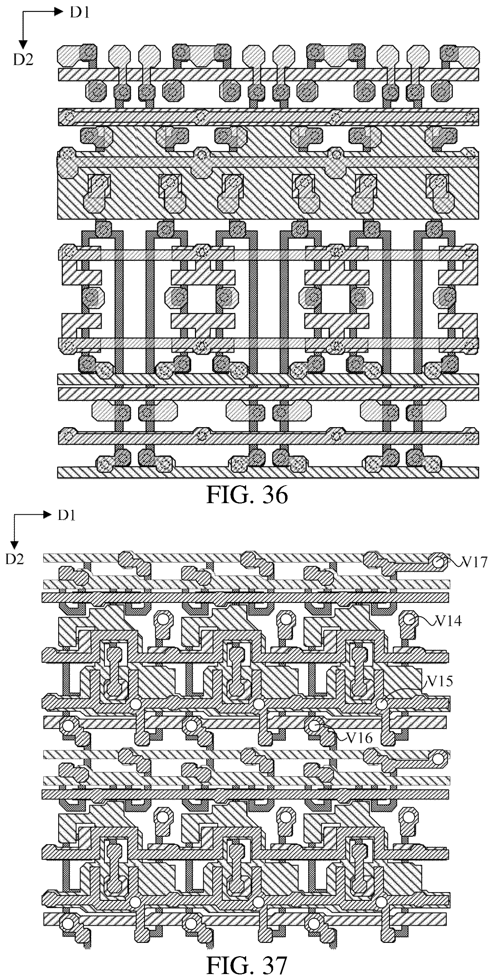

(5) A pattern of a third conductive layer is formed. In an exemplary implementation mode, forming a third conductive layer may include depositing a third conductive thin film on the base substrate on which the aforementioned patterns are formed, and patterning the third conductive thin film through a patterning process, to form a third conductive layer provided on the third insulation layer, as shown in FIGs. 31 to 36. FIG. 31 is a schematic diagram of a pattern of a second conductive layer in the display substrate provided in FIGs. 3 and 5. FIG. 32 is a schematic diagram of the display substrate provided in FIGs. 3 and 5 after a pattern of a second conductive layer is formed. FIG. 33 is a schematic diagram of a pattern of a second conductive layer in the display substrate provided in FIG. 7. FIG. 34 is a schematic diagram of the display substrate provided in FIG. 7 after a pattern of a second conductive layer is formed. FIG. 35 is a schematic diagram of a pattern of a second conductive layer in the display substrate provided in FIG. 9. FIG. 36 is a schematic diagram of the display substrate provided in FIG. 9 after a pattern of a second conductive layer is formed. In an exemplary implementation mode, the third conductive layer may be referred to as a first source-drain metal (SD1) layer.

In an exemplary implementation mode, as shown in FIGs. 31 to 34, in the display substrate provided in FIGs. 3, 5, and 7, the pattern of the third conductive layer at least includes a reset signal line RL, a scan signal line GL, and a first electrode 13 and a second electrode 14 of a first transistor, a first electrode 23 of a second transistor, a first electrode 43 of a fourth transistor, a first electrode 53 of a fifth transistor, a second electrode 64 of a sixth transistor, and a first electrode 73 and a second electrode 74 of a seventh transistor located in at least one sub-pixel.

In an exemplary implementation mode, as shown in FIGs. 31 and 32, in the display substrates provided in FIGs. 3 and 5, structures of the first electrode 13 and the second electrode 14 of the first transistor, the first electrode 23 of the second transistor, the first electrode 43 of the fourth transistor, the first electrode 53 of the fifth transistor, the second electrode 64 of the sixth transistor, and the first electrode 73 and the second electrode 74 of the seventh transistor located in a same pixel unit are at least partially the same.

In an exemplary implementation mode, as shown in FIGs. 33 and 34, in the display substrate provided in FIG. 7, structures of the first electrode 13 and the second electrode 14 of the first transistor, the first electrode 23 of the second transistor, the first electrode 43 of the fourth transistor, the first electrode 53 of the fifth transistor, the second electrode 64 of the sixth transistor, and the first electrode 73 and the second electrode 74 of the seventh transistor in the first sub-pixel, the third sub-pixel, and the fifth sub-pixel located in a same pixel unit are at least partially the same; structures of the first electrode 13 and the second electrode 14 of the first transistor, the first electrode 23 of the second transistor, the first electrode 43 of the fourth transistor, the first electrode 53 of the fifth transistor, the second electrode 64 of the sixth transistor, and the first electrode 73 and the second electrode 74 of the seventh transistor in the second sub-pixel, the fourth sub-pixel, and the sixth sub-pixel located in a same pixel unit are at least partially the same; and structures of the first electrode 13 and the second electrode 14 of the first transistor, the first electrode 23 of the second transistor, the first electrode 43 of the fourth transistor, the first electrode 53 of the fifth transistor, the second electrode 64 of the sixth transistor, and the first electrode 73 and the second electrode 74 of the seventh transistor located in a same pixel unit are provided at least partially in mirror symmetry.

In an exemplary implementation mode, as shown in FIGs. 31 to 34, the reset signal line RL may have a line shape in which a main body portion extends in the first direction D1. The reset signal line RL is connected with the gate electrode of the first transistor (also the gate electrode of the seventh transistor) through the seventh via.

In an exemplary implementation mode, as shown in FIGs. 31 to 34, the scan signal line GL may have a line shape in which a main body portion extends in the first direction D1. The scan signal line GL is connected with the gate electrode of the second transistor through the eighth via, and is connected with the gate electrode of the fourth transistor through the tenth via.

In an exemplary implementation mode, as shown in FIGs. 31 to 34, the first electrode 13 of the first transistor is provided separately and has a strip shape extending in the first direction D1. The first electrode 13 of the first transistor is connected with the first region of the active pattern of the first transistor through the first via, and is connected with the first initial signal line through the twelfth via.

In an exemplary implementation mode, as shown in FIGs. 31 to 34, the second electrode 14 of the first transistor and the first electrode 23 of the second transistor are of an integral structure, and have a strip shape extending in the second direction D2. The second electrode 14 of the first transistor (also the first electrode 23 of the second transistor) is connected with the second region of the active pattern of the first transistor (also the first region of the active pattern of the second transistor) through the second via, and is connected with the gate electrode of the third transistor (also the first electrode plate of the capacitor) through the ninth via.

In an exemplary implementation mode, as shown in FIGs. 31 to 34, the first electrode 43 of the fourth transistor is provided separately, and has a strip shape extending in the second direction D2. The first electrode 43 of the fourth transistor is connected with the first region of the active pattern of the fourth transistor through the third via.

In an exemplary implementation mode, as shown in FIGs. 31 to 34, the first electrode 53 of the fifth transistor includes a first electrode connection portion 53A, a second electrode connection portion 53B, a third electrode connection portion 53C, and a fourth electrode connection portion 53D. The second electrode connection portion 53B is located on a side of the first electrode connection portion 53A close to the scan signal line GL. The third electrode connection portion 53C and the fourth electrode connection portion 53D are located on a side of the first electrode connection portion 53A way from the scan signal line GL, and are respectively located on opposite sides of the second electrode 14 of the first transistor (also the first electrode 23 of the second transistor). The first electrode connection portion 53A is electrically connected with the second electrode connection portion 53B, the third electrode connection portion 53C, and the fourth electrode connection portion 53D, respectively. The first electrode connection portion 53A extends at least partially in the first direction D1, and the second electrode connection portion 53B, the third electrode connection portion 53C, and the fourth electrode connection portion 53D extend at least partially in the second direction D2. The second electrode connection portion 53B of the first electrode 53 of the fifth transistor is connected with the first region of the active pattern of the fifth transistor through the fourth via. The first electrode connection portion 53A of the first electrode 53 of the fifth transistor is connected with the second electrode plate of the capacitor through the eleventh via.

In an exemplary implementation mode, first electrode connection portions 53A of first electrodes 53 of fifth transistors of adjacent sub-pixels located in a same row are connected.

In an exemplary implementation mode, as shown in FIGs. 31 to 34, the second electrode 64 of the sixth transistor and the second electrode 74 of the seventh transistor are of an integral structure and have a strip shape extending at least partially in the first direction D1. The second electrode 64 of the sixth transistor (also the second electrode 74 of the seventh transistor) is connected with the second region of the active pattern of the sixth transistor (also the second region of the active pattern of the seventh transistor) through the fifth via.

In an exemplary implementation mode, as shown in FIGs. 31 to 34, the first electrode 73 of the seventh transistor is provided separately, and has a strip shape extending in the first direction D1. The first electrode 73 of the seventh transistor is connected with the first region of the active pattern of the seventh transistor through the sixth via, and is connected with the second initial signal line through the thirteenth via.

In an exemplary implementation mode, as shown in FIGs. 31 to 34, the reset signal line RL and the scan signal line GL may be of an equal width design, or may be of a non-equal width design, may be straight lines, or may be polylines, which may not only facilitate a layout of a pixel structure, but also reduce a parasitic capacitance between signal lines, which is not limited here in the present disclosure.

In an exemplary implementation mode, as shown in FIGs. 35 and 36, in the display substrate provided in FIG. 9, the pattern of the third conductive layer at least includes an even-numbered scan signal line GL(2i), a second sub-scan signal line GL2(2i-1) of an odd-numbered scan signal line, an odd-numbered reset signal line RL(2i-1), a second sub-reset signal line RL2(2i) of an even-numbered reset signal line, a power supply connection line VL, and a first electrode 13 and a second electrode 14 of a first transistor, a first electrode 23 of a second transistor, a first electrode 43 of a fourth transistor, a first electrode 53 of a fifth transistor, a second electrode 64 of a sixth transistor, and a first electrode 73 and a second electrode 74 of a seventh transistor located in at least one sub-pixel, and a first connection electrode CL41.

In an exemplary implementation mode, as shown in FIGs. 35 and 36, in the display substrate provided in FIG. 9, structures of the first electrode 13 and the second electrode 14 of the first transistor, the first electrode 23 of the second transistor, the first electrode 43 of the fourth transistor, the first electrode 53 of the fifth transistor, the second electrode 64 of the sixth transistor, and the first electrode 73 and the second electrode 74 of the seventh transistor in adjacent sub-pixels located in a same pixel unit are provided at least partially symmetrically with respect to a virtual straight line extending in the second direction D2.

In an exemplary implementation mode, as shown in FIGs. 35 and 36, the even-numbered scan signal line GL(2i) may have a line shape in which a main body portion extends in the first direction D1. The even-numbered scan signal line GL(2i) is connected with the gate electrode of the second transistor through the eleventh via.

In an exemplary implementation mode, as shown in FIGs. 35 and 36, the second sub-scanning signal line GL2(2i-1) of the odd-numbered scan signal line may have a line shape in which a main body portion extends in the first direction D1. The second sub-scan signal line GL2(2i-1) of the odd-numbered scan signal line is connected with the first sub-scan signal line of the odd-numbered scan signal line through the thirteenth via.

In an exemplary implementation mode, as shown in FIGs. 35 and 36, the odd-numbered reset signal line RL(2i-1) may have a line shape in which a main body portion extends in the first direction D1. The odd-numbered reset signal line RL(2i-1) is connected with the gate electrode of the first transistor through the tenth via.

In an exemplary implementation mode, as shown in FIGs. 35 and 36, the second sub reset signal line RL2(2i) of the even-numbered reset signal line may have a line shape in which a main body portion extends in the first direction D1. The second sub-reset signal line RL2(2i) of the even-numbered reset signal line is connected with the first sub-reset signal line of the even-numbered reset signal line through the fourteenth via.

In an exemplary implementation mode, as shown in FIGs. 35 and 36, the power supply connection line VL may have a line shape in which a main body portion extends in the first direction D1. The power supply connection line VL is connected with the second electrode plate of the capacitor through the fifteenth via.

In an exemplary implementation mode, as shown in FIGs. 35 and 36, the first connection electrode CL41 is provided separately and has a strip shape extending in the second direction D2. The first connection electrode CL41 is connected with the gate electrode of the third transistor (also the first electrode plate of the capacitor) through the twelfth via.

In an exemplary implementation mode, as shown in FIGs. 35 and 36, the first electrode 13 of the first transistor is provided separately and has a strip shape extending in the first direction D1. The first electrode 13 of the first transistor is connected with the first region of the active pattern of the first transistor through the first via, and is connected with the first initial signal line through the sixteenth via.

In an exemplary implementation mode, as shown in FIGs. 35 and 36, the second electrode 14 of the first transistor and the first electrode 23 of the second transistor are of an integral structure and have a block shape. The second electrode 14 of the first transistor (also the first electrode 23 of the second transistor) is connected with the second region of the active pattern of the first transistor (also the first region of the active pattern of the second transistor) through the second via.

In an exemplary implementation mode, as shown in FIGs. 35 and 36, the second electrode 24 of the second transistor, the second electrode 34 of the third transistor, and the first electrode 63 of the sixth transistor are of an integral structure and have a block shape. The second electrode 24 of the second transistor (also the second electrode 34 of the third transistor and the first electrode 63 of the sixth transistor) is connected with the second region of the active pattern of the second transistor (also the second region of the active pattern of the third transistor and the first region of the active pattern of the sixth transistor) through the third via.

In an exemplary implementation mode, as shown in FIGs. 35 and 36, the first electrode 33 of the third transistor and the second electrode 44 of the fourth transistor are of an integral structure and have a block shape. The first electrode 33 of the third transistor (also the second electrode 44 of the fourth transistor) is connected with the first region of the active pattern of the third transistor (also the second region of the active pattern of the fourth transistor) through the fourth via H4.

In an exemplary implementation mode, as shown in FIGs. 35 and 36, the first electrode 43 of the fourth transistor is provided separately, and has a strip shape extending in the second direction D2. The first electrode 43 of the fourth transistor is connected with the first region of the active pattern of the fourth transistor through the fifth via.

In an exemplary implementation mode, as shown in FIGs. 35 and 36, the first electrode 53 of the fifth transistor is provided separately and has a strip shape extending in the first direction D1. The first electrode 53 of the fifth transistor is connected with the first region of the active pattern of the fifth transistor through the sixth via.

In an exemplary implementation mode, as shown in FIGs. 35 and 36, the second electrode 54 of the fifth transistor is provided separately, and has a block shape. The second electrode 54 of the fifth transistor is connected with the second region of the active pattern of the fifth transistor through the seventh via.

In an exemplary implementation mode, as shown in FIGs. 35 and 36, the second electrode 64 of the sixth transistor and the second electrode 74 of the seventh transistor are of an integral structure and have a strip shape extending at least partially in the first direction D1. The second electrode 64 of the sixth transistor (also the second electrode 74 of the seventh transistor) is connected with the second region of the active pattern of the sixth transistor (also the second region of the active pattern of the seventh transistor) through the eighth via.

In an exemplary implementation mode, as shown in FIGs. 35 and 36, the first electrode 73 of the seventh transistor is provided separately and has a strip shape extending in the first direction D1. The first electrode 73 of the seventh transistor is connected with the first region of the active pattern of the seventh transistor through the ninth via, and is connected with the second initial signal line through the seventeenth via.

In an exemplary implementation mode, as shown in FIGs. 35 and 36, the even-numbered scan signal line GL(2i), the second sub-scan signal line GL2(2i-1) of the odd-numbered scan signal line, the odd-numbered reset signal line RL(2i-1), the second sub-reset signal line RL2(2i) of the even-numbered reset signal line, and the power supply connection line VL may be of an equal width design, or may be of a non-equal width design, may be straight lines, or may be polylines, which not only may facilitate a layout of a pixel structure, but also may reduce a parasitic capacitance between signal lines, which is not limited herein in the present disclosure.

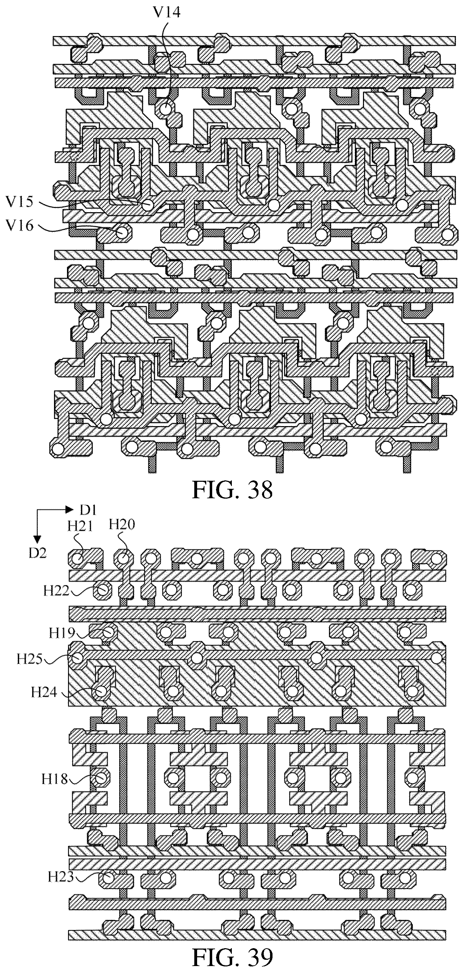

(6) A pattern of a first planarization layer is formed. In an exemplary implementation mode, forming a pattern of a first planarization layer may include first depositing a fourth insulation thin film on the base substrate on which the aforementioned patterns are formed, then coating the first planarization thin film, and patterning the first planarization thin film and the fourth insulation thin film through a patterning process, to form a fourth insulation layer covering the pattern of the third conductive layer and a first planarization layer provided on the fourth insulation layer, the first planarization layer being provided with multiple vias, as shown in FIGs. 37 to 39. FIG. 37 is a schematic diagram of the display substrate provided in FIGs. 3 and 5 after a first planarization layer is formed. FIG. 38 is a schematic diagram of the display substrate provided in FIG. 7 after a first planarization layer is formed. FIG. 39 is a schematic diagram of the display substrate provided in FIG. 9 after a first planarization layer is formed.

In an exemplary implementation mode, as shown in FIG. 37, in the display substrate provided in FIG. 3, the multiple vias of the first planarization layer at least include a fourteenth via V14 to a seventeenth via V17.

In an exemplary implementation mode, an orthographic projection of the fourteenth via V14 on the base substrate is within a range of an orthographic projection of the first electrode of the fourth transistor on the base substrate. The fourth insulation layer in the fourteenth via V14 is etched away, exposing a surface of the first electrode of the fourth transistor. The fourteenth via V14 is configured such that a data signal line formed subsequently is connected with the first electrode of the fourth transistor through the via.

In an exemplary implementation mode, an orthographic projection of the fifteenth via V15 on the base substrate is within a range of an orthographic projection of the first electrode of the fifth transistor on the base substrate. The fourth insulation layer in the fifteenth via V15 is etched away, exposing a surface of the first electrode of the fourth transistor. The fifteenth via V15 is configured such that a first sub-power supply line of the first power supply line formed subsequently is connected with the first electrode of the fifth transistor.

In an exemplary implementation mode, an orthographic projection of the sixteenth via V16 on the base substrate is within a range of an orthographic projection of the second electrode of the sixth transistor (also the second electrode of the seventh transistor) on the base substrate. The fourth insulation layer in the sixteenth via V16 is etched away, exposing a surface of the second electrode of the sixth transistor (also the second electrode of the seventh transistor). The sixteenth via V16 is configured such that a connection electrode formed subsequently is connected with the second electrode of the sixth transistor (also the second electrode of the seventh transistor).

In an exemplary implementation mode, an orthographic projection of the seventeenth via V17 on the base substrate is within a range of an orthographic projection of first electrodes of first transistors in the third sub-pixel and the sixth sub-pixel located in at least one pixel unit on the base substrate. The fourth insulation layer in the seventeenth via V17 is etched away, exposing a surface of the first electrode of the first transistor. The seventeenth via V17 is configured such that a first initial connection line formed subsequently is connected with the first electrode of the first transistor.

In an exemplary implementation mode, as shown in FIG. 37, in the display substrate provided in FIG. 5, the multiple vias of the first planarization layer at least include a fourteenth via V14 to a seventeenth via V17.

In an exemplary implementation mode, an orthographic projection of the fourteenth via V14 on the base substrate is located within a range of an orthographic projection of the first electrode of the fourth transistor on the base substrate. The fourth insulation layer in the fourteenth via V14 is etched away, exposing a surface of the first electrode of the fourth transistor. The fourteenth via V14 is configured such that a second connection electrode formed subsequently is connected with the first electrode of the fourth transistor through the via.

In an exemplary implementation mode, an orthographic projection of the fifteenth via V15 on the base substrate is within a range of an orthographic projection of the first electrode of the fifth transistor on the base substrate. The fourth insulation layer in the fifteenth via V15 is etched away, exposing a surface of the first electrode of the fourth transistor. The fifteenth via V15 is configured such that a first sub-power supply line of the first power supply line formed subsequently is connected with the first electrode of the fifth transistor.

In an exemplary implementation mode, an orthographic projection of the sixteenth via V16 on the base substrate is within a range of an orthographic projection of the second electrode of the sixth transistor (also the second electrode of the seventh transistor) on the base substrate. The fourth insulation layer in the sixteenth via V16 is etched away, exposing a surface of the second electrode of the sixth transistor (also the second electrode of the seventh transistor). The sixteenth via V16 is configured such that a first connection electrode formed subsequently is connected with the second electrode of the sixth transistor (also the second electrode of the seventh transistor).

In an exemplary implementation mode, an orthographic projection of the seventeenth via V17 on the base substrate is within a range of an orthographic projection of first electrodes of first transistors in the third sub-pixel and the sixth sub-pixel located in at least one pixel unit on the base substrate. The fourth insulation layer in the seventeenth via V17 is etched away, exposing a surface of the first electrode of the first transistor. The seventeenth via V17 is configured such that a first initial connection line formed subsequently is connected with the first electrode of the first transistor.

In an exemplary implementation mode, as shown in FIG. 38, in the display substrate provided in FIG. 7, the multiple vias of the first planarization layer at least include a fourteenth via V14 to a sixteenth via V16.

In an exemplary implementation mode, an orthographic projection of the fourteenth via V14 on the base substrate is within a range of an orthographic projection of the first electrode of the fourth transistor on the base substrate. The fourth insulation layer in the fourteenth via V14 is etched away, exposing a surface of the first electrode of the fourth transistor. The fourteenth via V14 is configured such that a data signal line formed subsequently is connected with the first electrode of the fourth transistor through the via.

In an exemplary implementation mode, an orthographic projection of the fifteenth via V15 on the base substrate is within a range of an orthographic projection of the first electrode of the fifth transistor on the base substrate. The fourth insulation layer in the fifteenth via V15 is etched away, exposing a surface of the first electrode of the fourth transistor. The fifteenth via V15 is configured such that a first power supply line and a third electrode plate of the capacitor formed subsequently is connected with the first electrode of the fifth transistor.

In an exemplary implementation mode, an orthographic projection of the sixteenth via V16 on the base substrate is within a range of an orthographic projection of the second electrode of the sixth transistor (also the second electrode of the seventh transistor) on the base substrate. The fourth insulation layer in the sixteenth via V16 is etched away, exposing a surface of the second electrode of the sixth transistor (also the second electrode of the seventh transistor). The sixteenth via V16 is configured such that a connection electrode formed subsequently is connected with the second electrode of the sixth transistor (also the second electrode of the seventh transistor).

In an exemplary implementation mode, as shown in FIG. 39, in the display substrate provided in FIG. 9, the multiple vias of the first planarization layer at least include an eighteenth via H18 to a twenty-fifth via H25.

In an exemplary implementation mode, an orthographic projection of the eighteenth via H18 on the base substrate is located within a range of an orthographic projection of the second electrode of the first transistor (also the first electrode of the second transistor) on the base substrate. The fourth insulation layer in the eighteenth via H18 is etched away, exposing a surface of the second electrode of the first transistor (also the first electrode of the second transistor). The eighteenth via H18 is configured such that a second connection electrode formed subsequently is connected with the second electrode of the first transistor (also the first electrode of the second transistor).

In an exemplary implementation mode, an orthographic projection of the nineteenth via H19 on the base substrate is within a range of an orthographic projection of the first electrode of the third transistor (also the second electrode of the fourth transistor) on the base substrate. The fourth insulation layer in the nineteenth via H19 is etched away, exposing a surface of the first electrode of the third transistor (also the second electrode of the fourth transistor). The nineteenth via H19 is configured such that a third connection electrode formed subsequently is connected with the first electrode of the third transistor (also the second electrode of the fourth transistor).

In an exemplary implementation mode, an orthographic projection of the twentieth via H20 on the base substrate is within a range of an orthographic projection of the first electrode of the fourth transistor on the base substrate. The fourth insulation layer in the twentieth via H20 is etched away, exposing a surface of the first electrode of the fourth transistor. The twentieth via H20 is configured such that a data signal line formed subsequently is connected with the first electrode of the fourth transistor.

In an exemplary implementation mode, an orthographic projection of the twenty-first via H21 on the base substrate is within a range of an orthographic projection of the first electrode of the fifth transistor on the base substrate. The fourth insulation layer in the twenty-first via H21 is etched away, exposing a surface of the first electrode of the fifth transistor. The twenty-first via H21 is configured such that a first power supply line formed subsequently is connected with the first electrode of the fifth transistor.

In an exemplary implementation mode, an orthographic projection of the twenty-second via H22 on the base substrate is within a range of an orthographic projection of the second electrode of the fifth transistor on the base substrate. The fourth insulation layer in the twenty-second via H22 is etched away, exposing a surface of the second electrode of the fifth transistor. The twenty-second via H22 is configured such that a third connection electrode formed subsequently is connected with the second electrode of the fifth transistor.

In an exemplary implementation mode, an orthographic projection of the twenty-third via H23 on the base substrate is within a range of an orthographic projection of the second electrode of the sixth transistor (also the second electrode of the seventh transistor) on the base substrate. The fourth insulation layer in the twenty-third via H23 is etched away, exposing a surface of the second electrode of the sixth transistor (also the second electrode of the seventh transistor). The twenty-third via H23 is configured such that a fourth connection electrode formed subsequently is connected with the second electrode of the sixth transistor (also the second electrode of the seventh transistor).

In an exemplary implementation mode, an orthographic projection of the twenty-fourth via 24 on the base substrate is located within a range of an orthographic projection of the first connection electrode on the base substrate. The fourth insulation layer in the twenty-fourth via H24 is etched away, exposing a surface of the first connection electrode. The twenty-fourth via H24 is configured such that a second connection electrode formed subsequently is connected with the first connection electrode.

In an exemplary implementation mode, an orthographic projection of the twenty-fifth via H25 on the base substrate is within a range of an orthographic projection of the power supply connection line on the base substrate. The fourth insulation layer in the twenty-fifth via H25 is etched away, exposing a surface of the power supply connection line. The twenty-fifth via H25 is configured such that a first power supply line formed subsequently is connected with the power supply connection line.

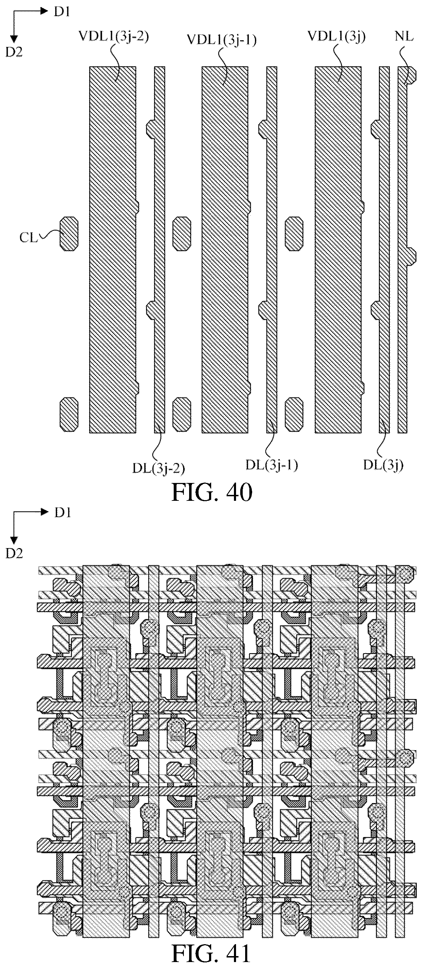

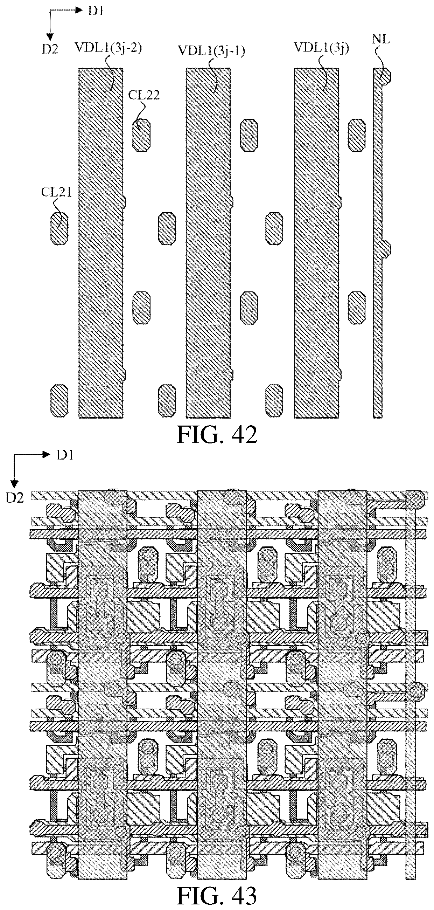

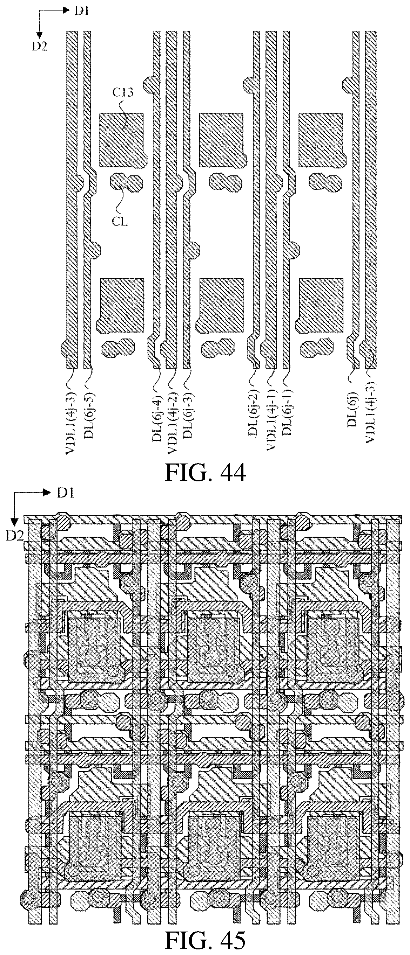

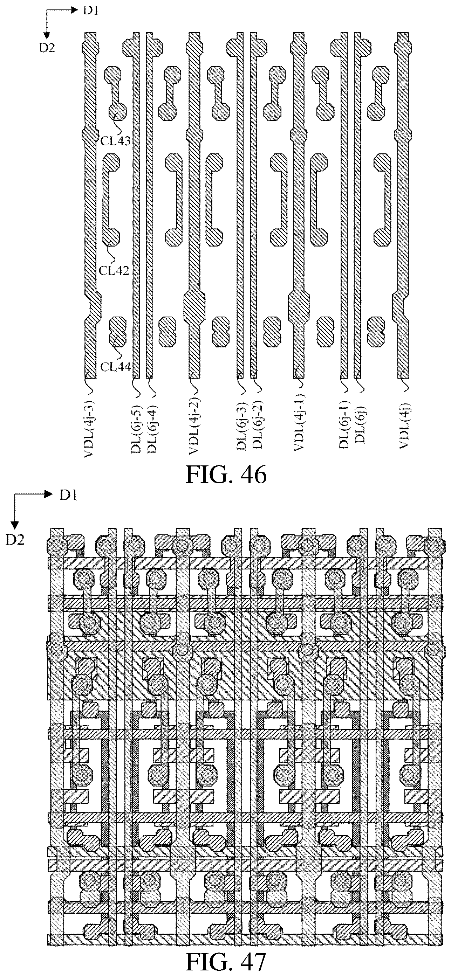

(7) A pattern of a fourth conductive layer is formed. In an exemplary implementation mode, forming a pattern of a fourth conductive layer may include depositing a fourth conductive thin film on the base substrate on which the aforementioned patterns are formed, and patterning the fourth conductive thin film through a patterning process, to form a pattern of a fourth conductive layer provided on the first planarization layer, as shown in FIGs. 40 to 47. FIG. 40 is a schematic diagram of a pattern of a fourth conductive layer in the display substrate provided in FIG. 3. FIG. 41 is a schematic diagram of the display substrate provided in FIG. 3 after a pattern of a fourth conductive layer is formed. FIG. 42 is a schematic diagram of a pattern of a fourth conductive layer in the display substrate provided in FIG. 5. FIG. 43 is a schematic diagram of the display substrate provided in FIG. 5 after a pattern of a fourth conductive layer is formed. FIG. 44 is a schematic diagram of a pattern of a fourth conductive layer in the display substrate provided in FIG. 7. FIG. 45 is a schematic diagram of the display substrate provided in FIG. 7 after a pattern of a fourth conductive layer is formed. FIG. 46 is a schematic diagram of a pattern of a fourth conductive layer in the display substrate provided in FIG. 9. FIG. 47 is a schematic diagram of the display substrate provided in FIG. 9 after a pattern of a fourth conductive layer is formed. In an exemplary implementation mode, the fourth conductive layer may be referred to as a second source-drain metal (SD2) layer.

In an exemplary implementation mode, as shown in FIGs. 40 and 41, in the display substrate provided in FIG. 3, the pattern of the fourth conductive layer at least includes a first sub-power supply line VDL1 of the first power supply line, a data signal line DL, a first initial connection line NL, and a connection electrode CL located in at least one sub-pixel.

In an exemplary implementation mode, as shown in FIGs. 40 and 41, structures of connection electrodes CL of all sub-pixels located in a same pixel unit are at least partially the same.

In an exemplary implementation mode, as shown in FIGs. 40 and 41, a line width of the first sub-power supply line VDL1 of the first power supply line is greater than a line width of the data signal line DL.

In an exemplary implementation mode, as shown in FIGs. 40 and 41, the first sub-power supply line VDL1 of the first power supply line may have a line shape in which a main body portion extends in the second direction D2. The first sub-power supply line VDL1 of the first power supply line is connected with the first electrode of the fifth transistor through the fifteenth via.

In an exemplary implementation mode, as shown in FIGs. 40 and 41, the data signal line DL may have a line shape in which a main body portion extends in the second direction D2. The data signal line DL is connected with the first electrode of the fourth transistor through the fourteenth via.

In an exemplary implementation mode, as shown in FIGs. 40 and 41, the first initial connection line NL may have a line shape in which a main body portion extends in the second direction D2. The first initial connection line NL is connected with the first electrode of the first transistor through the seventeenth via.

In an exemplary implementation mode, as shown in FIGs. 40 and 41, the connection electrode CL has a strip shape extending in the second direction D2. The connection electrode CL is connected with the second electrode of the sixth transistor (also the second electrode of the seventh transistor) through the sixteenth via.

In an exemplary implementation mode, as shown in FIGs. 42 and 43, in the display substrate provided in FIG. 5, the pattern of the fourth conductive layer at least includes a first sub-power supply line VDL1 of the first power supply line, a first initial connection line NL, and a first connection electrode CL21 and a second connection electrode CL22 located in at least one sub-pixel.

In an exemplary implementation mode, as shown in FIGs. 42 and 43, structures of first connection electrodes CL21 and second connection electrodes CL22 of all sub-pixels located in a same pixel unit are at least partially the same.

In an exemplary implementation mode, as shown in FIGs. 42 and 43, a line width of the first sub-power supply line VDL1 of the first power supply line is greater than a line width of the data signal line DL.

In an exemplary implementation mode, as shown in FIGs. 42 and 43, the first sub-power supply line VDL1 of the first power supply line may have a line shape in which a main body portion extends in the second direction D2. The first sub-power supply line VDL1 of the first power supply line is connected with the first electrode of the fifth transistor through the fifteenth via.

In an exemplary implementation mode, as shown in FIGs. 42 and 43, the first initial connection line NL may have a line shape in which a main body portion extends in the second direction D2. The first initial connection line NL is connected with the first electrode of the first transistor through the seventeenth via.

In an exemplary implementation mode, as shown in FIGs. 42 and 43, the first connection electrode CL1 has a strip shape extending in the second direction D2. The first connection electrode CL1 is connected with the second electrode of the sixth transistor (also the second electrode of the seventh transistor) through the sixteenth via.

In an exemplary implementation mode, as shown in FIGs. 42 and 43, the second connection electrode CL2 has a strip shape extending in the second direction D2. The second connection electrode CL2 is connected with the first electrode of the fourth transistor through the fourteenth via.

In an exemplary implementation mode, as shown in FIGs. 44 and 45, in the display substrate provided in FIG. 7, the pattern of the fourth conductive layer at least includes a first power supply line VDL, a data signal line DL, and a third electrode plate C3 of a capacitor and a connection electrode CL located in least one sub-pixel.

In an exemplary implementation mode, as shown in FIGs. 44 and 45, structures of third electrode plates C3 of capacitors and connection electrodes CL of all sub-pixels in a same row located in a same pixel unit are at least partially the same; and structures of third electrode plates C3 of capacitors and connection electrodes CL of sub-pixels in different rows located in a same pixel unit are provided at least partially in mirror symmetry.

In an exemplary implementation mode, as shown in FIGs. 44 and 45, the first power supply line VDL may have a line shape in which a main body portion extends in the second direction D2. The first power supply line VDL is connected with the first electrode of the fifth transistor through the fifteenth via.

In an exemplary implementation mode, as shown in FIGs. 44 and 45, the data signal line DL may have a line shape in which a main body portion extends in the second direction D2. The data signal line DL is connected with the first electrode of the fourth transistor through the fourteenth via.

In an exemplary implementation mode, as shown in FIGs. 44 and 45, an outline of the third electrode plate C3 of the capacitor may have a rectangular shape, of which corners may be provided with chamfers. An orthographic projection of the third electrode plate C3 of the capacitor on the base substrate is at least partially overlapped with an orthographic projection of the first electrode plate on the base substrate, and is at least partially overlapped with an orthographic projection of the second electrode of the first transistor (also the first electrode of the second transistor) on the base substrate. The third electrode plate C3 of the capacitor is connected with the first electrode of the fifth transistor through the fifteenth via.

In an exemplary implementation mode, as shown in FIGs. 44 and 45, the connection electrode CL has a strip shape extending in the first direction D1. The connection electrode CL is connected with the second electrode of the sixth transistor (also the second electrode of the seventh transistor) through the sixteenth via.

In an exemplary implementation mode, as shown in FIGs. 46 and 47, in the display substrate provided in FIG. 9, the pattern of the fourth conductive layer at least includes a first power supply line VDL, a data signal line DL, and a second connection electrode CL2, a third connection electrode CL3, and a fourth connection electrode CL4 located in at least one sub-pixel.

In an exemplary implementation mode, as shown in FIGs. 46 and 47, structures of the second connection electrode CL2, the third connection electrode CL3, and the fourth connection electrode CL4 in adjacent sub-pixels located in a same pixel unit are provided at least partially symmetrically with respect to a virtual straight line extending in the second direction D2.

In an exemplary implementation mode, as shown in FIGs. 46 and 47, the first power supply line VDL may have a line shape in which a main body portion extends in the second direction D2. The first power supply line VDL is connected with the first electrode of the fifth transistor through the twenty-first via, and is connected with the power supply connection line through the twenty-fifth via.

In an exemplary implementation mode, as shown in FIGs. 46 and 47, the data signal line DL may have a line shape in which a main body portion extends in the second direction D2. The data signal line DL is connected with the first electrode of the fourth transistor through the twentieth via.

In an exemplary implementation mode, as shown in FIGs. 46 and 47, the second connection electrode CL42 may have a strip shape extending in the second direction D2. The second connection electrode CL42 is connected with the second electrode of the first transistor (also the first electrode of the second transistor) through the eighteenth via, and is connected with the first connection electrode through the twenty-fourth via.

In an exemplary implementation mode, as shown in FIGs. 46 and 47, the third connection electrode CL43 may have a strip shape extending in the second direction D2. The third connection electrode CL43 is connected with the first electrode of the third transistor (also the second electrode of the fourth transistor) through the nineteenth via, and is connected with the second electrode of the fifth transistor through the twenty-second via.

In an exemplary implementation mode, as shown in FIGs. 46 and 47, the fourth connection electrode CL44 may have a strip shape extending in the second direction D2. The fourth connection electrode CL44 is connected with the second electrode of the sixth transistor (also the second electrode of the seventh transistor) through the twenty-third via.

In an exemplary implementation mode, as shown in FIGs. 44 to 47, in the display substrate provided in FIG. 7 and FIG. 9, the first power supply line VDL and the data signal line DL may be of an equal width design, or may be of a non-equal width design, may be straight lines, or may be polylines, which may not only facilitate a layout of a pixel structure, but also reduce a parasitic capacitance between signal lines, which is not limited here in the present disclosure.

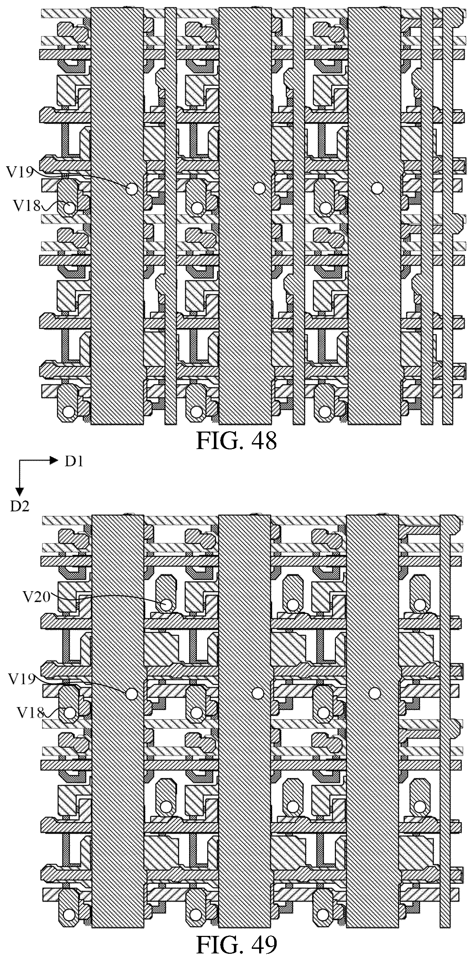

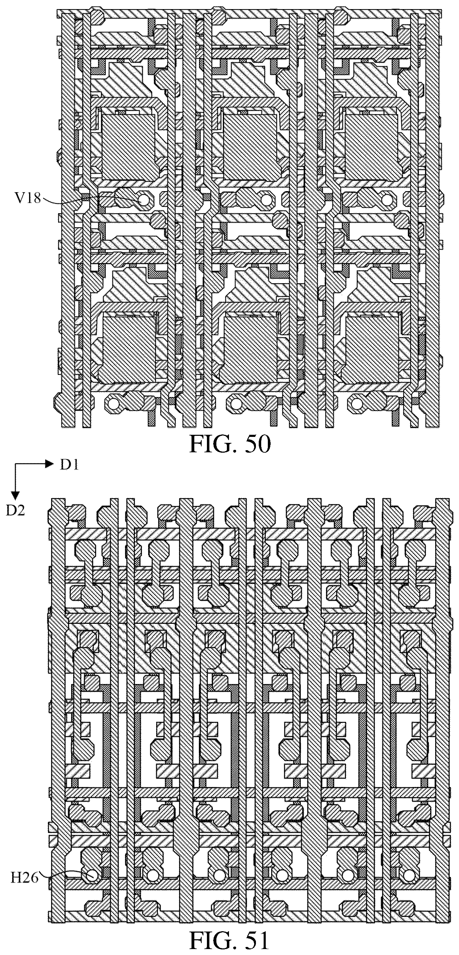

(8) A pattern of a second planarization layer is formed. In an exemplary implementation mode, forming a pattern of a second planarization layer may include coating a second planarization thin film on the base substrate on which the aforementioned patterns are formed, and patterning the second planarization thin film through a patterning process, to form a second planarization layer covering the pattern of the fourth conductive layer, the second planarization layer being provided with multiple vias, as shown in FIGs. 48 to 51. FIG. 48 is a schematic diagram of the display substrate provided in FIG. 3 after a second planarization layer is formed. FIG. 49 is a schematic diagram of the display substrate provided in FIG. 5 after a second planarization layer is formed. FIG. 50 is a schematic diagram of the display substrate provided in FIG. 7 after a second planarization layer is formed. FIG. 51 is a schematic diagram of the display substrate provided in FIG. 9 after a second planarization layer is formed.

In an exemplary implementation mode, as shown in FIG. 48, in the display substrate provided in FIG. 3, the multiple vias of the second planarization layer include an eighteenth via V18 and a nineteenth via V19.

In an exemplary implementation mode, an orthographic projection of the eighteenth via V18 on the base substrate is within a range of an orthographic projection of the connection electrode on the base substrate. The eighteenth via V18 exposes a surface of the connection electrode. The eighteenth via V18 is configured such that an anode connection line formed subsequently is connected with the connection electrode.

In an exemplary implementation mode, an orthographic projection of the nineteenth via V19 on the base substrate is within a range of an orthographic projection of the first sub-power supply line of the first power supply line on the base substrate. The nineteenth via V19 exposes a surface of the connection electrode. The nineteenth via V19 is configured such that a second sub-power supply line of the first power supply line formed subsequently is connected with the first sub-power supply line of the first power supply line.

In an exemplary implementation mode, as shown in FIG. 49, in the display substrate provided in FIG. 5, the multiple vias of the second planarization layer include an eighteenth via V18 to a twentieth via V20.

In an exemplary implementation mode, an orthographic projection of the eighteenth via V18 on the base substrate is located within a range of an orthographic projection of the first connection electrode on the base substrate. The eighteenth via V18 exposes a surface of the first connection electrode. The eighteenth via V18 is configured such that an anode connection line formed subsequently is connected with the first connection electrode.

In an exemplary implementation mode, an orthographic projection of the nineteenth via V19 on the base substrate is within a range of an orthographic projection of the first sub-power supply line of the first power supply line on the base substrate. The nineteenth via V19 exposes a surface of the connection electrode. The nineteenth via V19 is configured such that the second sub-power supply line of the first power supply line formed subsequently is connected with the first sub-power supply line of the first power supply line.

In an exemplary implementation mode, an orthographic projection of the twentieth via V20 on the base substrate is within a range of an orthographic projection of the second connection electrode on the base substrate. The twentieth via V20 exposes a surface of the second connection electrode. The twentieth via V20 is configured such that a data signal line formed subsequently is connected with the second connection electrode.

In an exemplary implementation mode, as shown in FIG. 50, in the display substrate provided in FIG. 7, the multiple vias of the second planarization layer include an eighteenth via V18.

In an exemplary implementation mode, an orthographic projection of the eighteenth via V18 on the base substrate is within a range of an orthographic projection of the connection electrode on the base substrate. The eighteenth via V18 exposes a surface of the connection electrode. The eighteenth via V18 is configured such that an anode connection line formed subsequently is connected with the connection electrode.

In an exemplary implementation mode, as shown in FIG. 51, in the display substrate provided in FIG. 9, the multiple vias of the second planarization layer include a twenty-sixth via H26.

In an exemplary implementation mode, an orthographic projection of the twenty-sixth via H26 on the base substrate is located within a range of an orthographic projection of the fourth connection electrode on the base substrate. The twenty-sixth via H26 exposes a surface of the fourth connection electrode. The twenty-sixth via H26 is configured such that an anode connection line formed subsequently is connected with the fourth connection electrode.

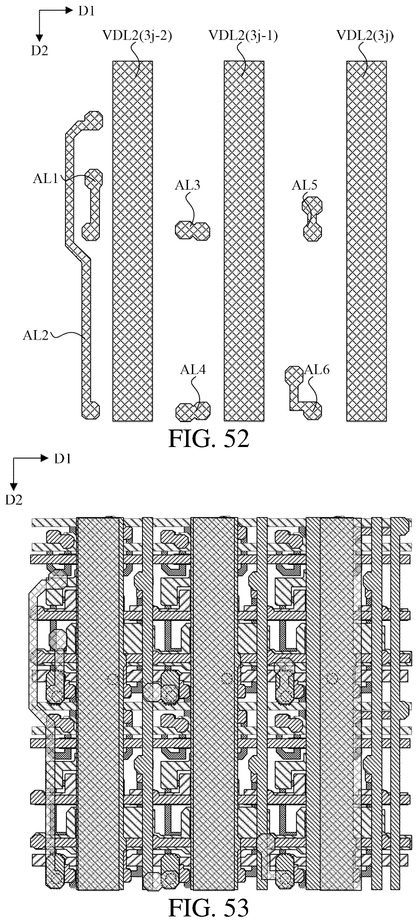

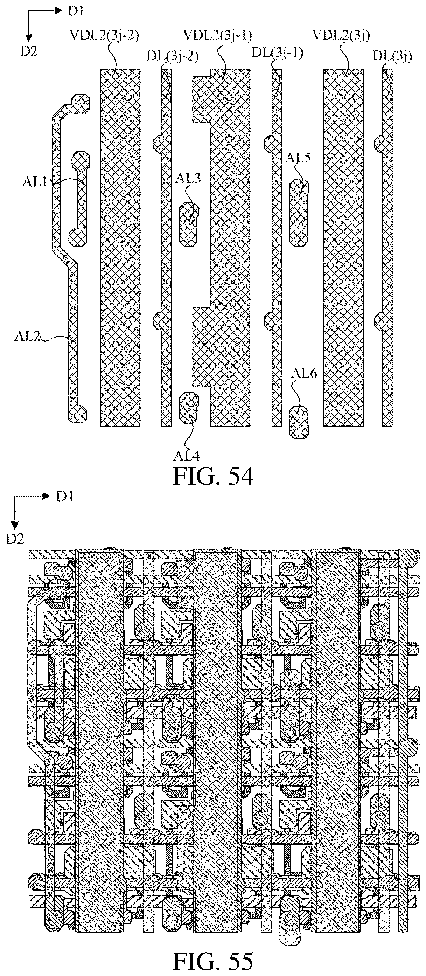

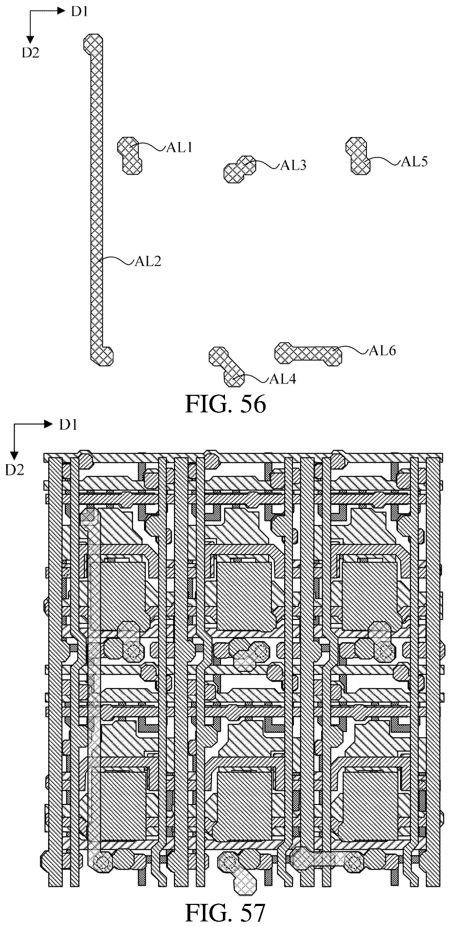

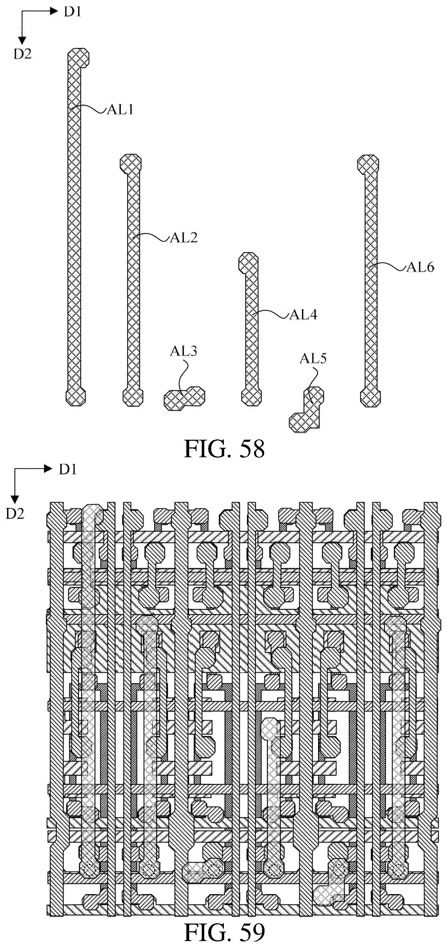

(9) A pattern of a fifth conductive layer is formed. In an exemplary implementation mode, forming a pattern of a fifth conductive layer may include depositing a fifth conductive thin film on the base substrate on which the aforementioned patterns are formed, and patterning the fifth conductive thin film through a patterning process, to form a pattern of a fifth conductive layer provided on the first planarization layer, as shown in FIGs. 52 to 59. FIG. 52 is a schematic diagram of a pattern of a fifth conductive layer in the display substrate provided in FIG. 3. FIG. 53 is a schematic diagram of the display substrate provided in FIG. 3 after a pattern of a fifth conductive layer is formed. FIG. 54 is a schematic diagram of a pattern of a fifth conductive layer in the display substrate provided in FIG. 5. FIG. 55 is a schematic diagram of the display substrate provided in FIG. 5 after a pattern of a fifth conductive layer is formed. FIG. 56 is a schematic diagram of a pattern of a fifth conductive layer in the display substrate provided in FIG. 7. FIG. 57 is a schematic diagram of the display substrate provided in FIG. 7 after a pattern of a fifth conductive layer is formed. FIG. 58 is a schematic diagram of a pattern of a fifth conductive layer in the display substrate provided in FIG. 9. FIG. 59 is a schematic diagram of the display substrate provided in FIG. 9 after a pattern of a fifth conductive layer is formed. In an exemplary implementation mode, the fifth conductive layer may be referred to as a third source-drain metal (SD3) layer.

In an exemplary implementation mode, as shown in FIGs. 52 and 53, in the display substrate provided in FIG. 3, the pattern of the fifth conductive layer at least includes a second sub-power supply line VDL2 of the first power supply line, and a first anode connection line AL1 to a sixth anode connection line AL6.

In an exemplary implementation mode, as shown in FIGs. 52 and 53, the second sub-power supply line VDL2 of the first power supply line may have a line shape in which a main body portion extends in the second direction D2. The second sub-power supply line VDL2 of the first power supply line is connected with the first sub-power supply line of the first power supply line through the nineteenth via.

In an exemplary implementation mode, as shown in FIGs. 52 and 53, the first anode connection line AL1 has a line shape extending at least partially in the second direction D2. The first anode connection line AL1 is connected with a connection electrode of the first sub-pixel through the eighteenth via located in the first sub-pixel.

In an exemplary implementation mode, as shown in FIGs. 52 and 53, the second anode connection line AL2 has a line shape extending at least partially in the second direction D2. The second anode connection line AL2 is connected with a connection electrode of the second sub-pixel through the eighteenth via located in the second sub-pixel.

In an exemplary implementation mode, as shown in FIGs. 52 and 53, the third anode connection line AL3 has a line shape extending at least partially in the first direction D1. The third anode connection line AL3 is connected with a connection electrode of the third sub-pixel through the eighteenth via located in the third sub-pixel.

In an exemplary implementation mode, as shown in FIGs. 52 and 53, the fourth anode connection line AL4 has a line shape extending at least partially in the first direction D1. The fourth anode connection line AL4 is connected with a connection electrode of the fourth sub-pixel through the eighteenth via located in the fourth sub-pixel.

In an exemplary implementation mode, as shown in FIGs. 52 and 53, the fifth anode connection line AL5 has a line shape extending at least partially in the second direction D2. The fifth anode connection line AL5 is connected with a connection electrode of the fifth sub-pixel through the eighteenth via located in the fifth sub-pixel.

In an exemplary implementation mode, as shown in FIGs. 52 and 53, the sixth anode connection line AL6 has a line shape extending at least partially in the second direction D2. The sixth anode connection line AL6 is connected with a connection electrode of the sixth sub-pixel through the eighteenth via located in the sixth sub-pixel.

In an exemplary implementation mode, as shown in FIGs. 54 and 55, in the display substrate provided in FIG. 5, the pattern of the fifth conductive layer at least includes a second sub-power supply line VDL2 of the first power supply line, a data signal line DL, and a first anode connection line AL1 to a sixth anode connection line AL6.

In an exemplary implementation mode, as shown in FIGs. 54 and 55, the second sub-power supply line VDL2 of the first power supply line may have a line shape in which a main body portion extends in the second direction D2. The second sub-power supply line VDL2 of the first power supply line is connected with the first sub-power supply line of the first power supply line through the nineteenth via.

In an exemplary implementation mode, as shown in FIGs. 54 and 55, a line width of the second sub-power supply line VDL2 of the first power supply line is greater than a line width of the data signal line DL.

In an exemplary implementation mode, as shown in FIGs. 54 and 55, the data signal line DL may have a line shape in which a main body portion extends in the second direction D2. The data signal line DL is connected with the second connection electrode through the twentieth via.

In an exemplary implementation mode, as shown in FIGs. 54 and 55, the first anode connection line AL1 has a line shape extending at least partially in the second direction D2. The first anode connection line AL1 is connected with a connection electrode of the first sub-pixel through the eighteenth via located in the first sub-pixel.

In an exemplary implementation mode, as shown in FIGs. 54 and 55, the second anode connection line AL2 has a line shape extending at least partially in the second direction D2. The second anode connection line AL2 is connected with a connection electrode of the second sub-pixel through the eighteenth via located in the second sub-pixel.

In an exemplary implementation mode, as shown in FIGs. 54 and 55, the third anode connection line AL3 has a line shape extending at least partially in the second direction D2. The third anode connection line AL3 is connected with a connection electrode of the third sub-pixel through the eighteenth via located in the third sub-pixel.

In an exemplary implementation mode, as shown in FIGs. 54 and 55, the fourth anode connection line AL4 has a line shape extending at least partially in the second direction D2. The fourth anode connection line AL4 is connected with a connection electrode of the fourth sub-pixel through the eighteenth via located in the fourth sub-pixel.

In an exemplary implementation mode, as shown in FIGs. 54 and 55, the fifth anode connection line AL5 has a line shape extending at least partially in the second direction D2. The fifth anode connection line AL5 is connected with a connection electrode of the fifth sub-pixel through the eighteenth via located in the fifth sub-pixel.

In an exemplary implementation mode, as shown in FIGs. 54 and 55, the sixth anode connection line AL6 has a line shape extending at least partially in the second direction D2. The sixth anode connection line AL6 is connected with a connection electrode of the sixth sub-pixel through the eighteenth via located in the sixth sub-pixel.

In an exemplary implementation mode, as shown in FIGs. 56 and 57, in the display substrate provided in FIG. 7, the pattern of the fifth conductive layer at least includes a first anode connection line AL1 to a sixth anode connection line AL6.

In an exemplary implementation mode, as shown in FIGs. 56 and 57, the first anode connection line AL1 has a line shape extending at least partially in the second direction D2. The first anode connection line AL1 is connected with a connection electrode of the first sub-pixel through the eighteenth via located in the first sub-pixel.

In an exemplary implementation mode, as shown in FIGs. 56 and 57, the second anode connection line AL2 has a line shape extending at least partially in the second direction D2. The second anode connection line AL2 is connected with a connection electrode of the second sub-pixel through the eighteenth via located in the second sub-pixel.

In an exemplary implementation mode, as shown in FIGs. 56 and 57, the third anode connection line AL3 has a line shape extending at least partially in the first direction D1. The third anode connection line AL3 is connected with a connection electrode of the third sub-pixel through the eighteenth via located in the third sub-pixel.

In an exemplary implementation mode, as shown in FIGs. 56 and 57, the fourth anode connection line AL4 has a line shape extending at least partially in the first direction D1. The fourth anode connection line AL4 is connected with a connection electrode of the fourth sub-pixel through the eighteenth via located in the fourth sub-pixel.

In an exemplary implementation mode, as shown in FIGs. 56 and 57, the fifth anode connection line AL5 has a line shape extending at least partially in the second direction D2. The fifth anode connection line AL5 is connected with a connection electrode of the fifth sub-pixel through the eighteenth via located in the fifth sub-pixel.

In an exemplary implementation mode, as shown in FIGs. 56 and 57, the sixth anode connection line AL6 has a line shape extending at least partially in the first direction D1. The sixth anode connection line AL6 is connected with a connection electrode of the sixth sub-pixel through the eighteenth via located in the sixth sub-pixel.

In an exemplary implementation mode, as shown in FIGs. 58 and 59, in the display substrate provided in FIG. 9, the pattern of the fifth conductive layer at least includes a first anode connection line AL1 to a sixth anode connection line AL6.

In an exemplary implementation mode, as shown in FIGs. 58 and 59, the first anode connection line AL1 has a line shape extending at least partially in the second direction D2. The first anode connection line AL1 is connected with a connection electrode of the first sub-pixel through the twenty-sixth via located in the first sub-pixel.

In an exemplary implementation mode, as shown in FIGs. 58 and 59, the second anode connection line AL2 has a line shape extending at least partially in the second direction D2. The second anode connection line AL2 is connected with a connection electrode of the second sub-pixel through the twenty-sixth via located in the second sub-pixel.

In an exemplary implementation mode, as shown in FIGs. 58 and 59, the third anode connection line AL3 has a line shape extending at least partially in the first direction D1. The third anode connection line AL3 is connected with a connection electrode of the third sub-pixel through the twenty-sixth via located in the third sub-pixel.

In an exemplary implementation mode, as shown in FIGs. 58 and 59, the fourth anode connection line AL4 has a line shape extending at least partially in the second direction D2. The fourth anode connection line AL4 is connected with a connection electrode of the fourth sub-pixel through the twenty-sixth via located in the fourth sub-pixel.

In an exemplary implementation mode, as shown in FIGs. 52 and 53, the fifth anode connection line AL5 has a line shape extending at least partially in the second direction D2. The fifth anode connection line AL5 is connected with a connection electrode of the fifth sub-pixel through the twenty-sixth via located in the fifth sub-pixel.

In an exemplary implementation mode, as shown in FIGs. 58 and 59, the sixth anode connection line AL6 has a line shape extending at least partially in the second direction D2. The sixth anode connection line AL6 is connected with a connection electrode of the sixth sub-pixel through the twenty-sixth via located in the sixth sub-pixel.

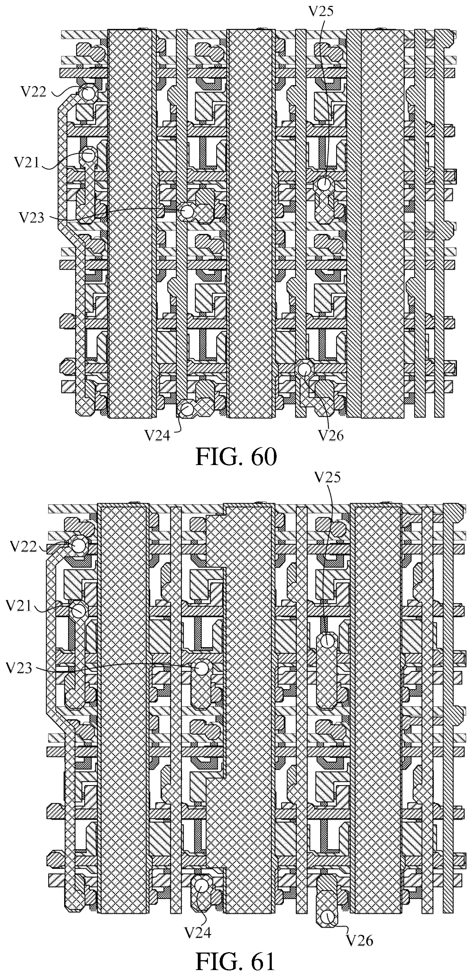

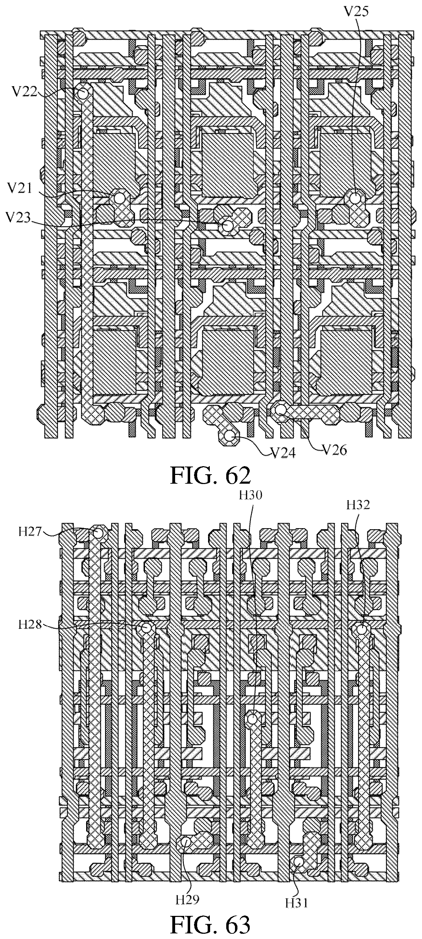

(10) A pattern of a third planarization layer is formed. In an exemplary implementation mode, forming a pattern of a third planarization layer pattern may include coating a third planarization thin film on the base substrate on which the aforementioned patterns are formed, and patterning the third planarization thin film through a patterning process, to form a third planarization layer covering the pattern of the fifth conductive layer, the third planarization layer being provided with multiple vias, as shown in FIGs. 60 to 62. FIG. 60 is a schematic diagram of the display substrate provided in FIG. 3 after a third planarization layer is formed. FIG. 61 is a schematic diagram of the display substrate provided in FIG. 5 after a third planarization layer is formed. FIG. 62 is a schematic diagram of the display substrate provided in FIG. 7 after a third planarization layer is formed. FIG. 63 is a schematic diagram of the display substrate provided in FIG. 9 after a third planarization layer is formed.

In an exemplary implementation mode, as shown in FIGs. 60 to 62, in the display substrate provided in FIGs. 3, 5, and 7, the multiple vias of the third planarization layer include a twenty-first via V21 to a twenty-sixth via V26.

In an exemplary implementation mode, an orthographic projection of the twenty-first via V21 on the base substrate is located within a range of an orthographic projection of the first anode connection line on the base substrate. The twenty-first via V21 exposes a surface of the first anode connection line. The twenty-first via V21 is configured such that a first electrode of the first sub-pixel formed subsequently is connected with the first anode connection line.

In an exemplary implementation mode, an orthographic projection of the twenty-second via V22 on the base substrate is within a range of an orthographic projection of the second anode connection line on the base substrate. The twenty-second via V22 exposes a surface of the second anode connection line. The twenty-second via V22 is configured such that a first electrode of the second sub-pixel formed subsequently is connected with the second anode connection line.

In an exemplary implementation mode, an orthographic projection of the twenty-third via V23 on the base substrate is within a range of an orthographic projection of the third anode connection line on the base substrate. The twenty-third via V23 exposes a surface of the third anode connection line. The twenty-third via V23 is configured such that a first electrode of the third sub-pixel formed subsequently is connected with the third anode connection line.

In an exemplary implementation mode, an orthographic projection of the twenty-fourth via V24 on the base substrate is within a range of an orthographic projection of the fourth anode connection line on the base substrate. The twenty-fourth via V24 exposes a surface of the fourth anode connection line. The twenty-fourth via V24 is configured such that a first electrode of the fourth sub-pixel formed subsequently is connected with the fourth anode connection line.

In an exemplary implementation mode, an orthographic projection of the twenty-fifth via V25 on the base substrate is within a range of an orthographic projection of the fifth anode connection line on the base substrate. The twenty-fifth via V25 exposes a surface of the fifth anode connection line. The twenty-fifth via V25 is configured such that a first electrode of the fifth sub-pixel formed subsequently is connected with the fifth anode connection line.

In an exemplary implementation mode, an orthographic projection of the twenty-sixth via V26 on the base substrate is within a range of an orthographic projection of the sixth anode connection line on the base substrate. The twenty-sixth via V26 exposes a surface of the sixth anode connection line. The twenty-sixth via V26 is configured such that a first electrode of the sixth sub-pixel formed subsequently is connected with the sixth anode connection line.

In an exemplary implementation mode, as shown in FIG. 63, in the display substrate provided in FIG. 9, the multiple vias of the third planarization layer include a twenty-seventh via H27 to a thirty-second via H32.

In an exemplary implementation mode, an orthographic projection of the twenty-seventh via H27 on the base substrate is located within a range of an orthographic projection of the first anode connection line on the base substrate. The twenty-seventh via H27 exposes a surface of the first anode connection line. The twenty-seventh H27 is configured such that a first electrode of the first sub-pixel formed subsequently is connected with the first anode connection line.

In an exemplary implementation mode, an orthographic projection of the twenty-eighth via H28 on the base substrate is within a range of an orthographic projection of the second anode connection line on the base substrate. The twenty-eighth via H28 exposes a surface of the second anode connection line. The twenty-eighth via H28 is configured such that a first electrode of the second sub-pixel formed subsequently is connected with the second anode connection line.

In an exemplary implementation mode, an orthographic projection of the twenty-ninth via H29 on the base substrate is within a range of an orthographic projection of the third anode connection line on the base substrate. The twenty-ninth via H29 exposes a surface of the third anode connection line. The twenty-ninth via H29 is configured such that a first electrode of the third sub-pixel formed subsequently is connected with the third anode connection line.

In an exemplary implementation mode, an orthographic projection of the thirtieth via H30 on the base substrate is within a range of an orthographic projection of the fourth anode connection line on the base substrate. The thirtieth via H30 exposes a surface of the fourth anode connection line. The thirtieth via H30 is configured such that a first electrode of the fourth sub-pixel formed subsequently is connected with the fourth anode connection line.

In an exemplary implementation mode, an orthographic projection of the thirty-first via H31 on the base substrate is located within a range of an orthographic projection of the fifth anode connection line on the base substrate. The thirty-first via H31 exposes a surface of the fifth anode connection line. The thirty-first via H31 is configured such that a first electrode of the fifth sub-pixel formed subsequently is connected with the fifth anode connection line.

In an exemplary implementation mode, an orthographic projection of the thirty-second via H32 on the base substrate is within a range of an orthographic projection of the sixth anode connection line on the base substrate. The thirty-second via H32 exposes a surface of the sixth anode connection line. The thirty-second via H32 is configured such that a first electrode of the sixth sub-pixel formed subsequently is connected with the sixth anode connection line.

So far, a drive circuit layer has been prepared on the base substrate. In a plane parallel to the display substrate, the drive circuit layer may include a plurality of circuit units, each of which may include a pixel drive circuit connected with a scan signal line, a reset signal line, a light emitting signal line, a first initial signal line, a second initial signal line, a data signal line, and a first power supply line. In a plane perpendicular to the display substrate, the drive circuit layer may be provided on the base substrate.

The drive circuit layer may include a semiconductor layer, a first insulation layer, a first conductive layer, a second insulation layer, a second conductive layer, a third insulation layer, a third conductive layer, a fourth insulation layer, a first planarization layer, a fourth conductive layer, a second planarization layer, a fifth conductive layer, and a third planarization layer that are sequentially provided on the base substrate. The semiconductor layer may at least include active patterns of a first transistor to a seventh transistor, the first conductive layer may at least include gate electrodes of the first transistor to the seventh transistor and a first electrode plate of a capacitor, the second conductive layer may at least include a second electrode plate of the capacitor, the third conductive layer may at least include first electrodes and second electrodes of a plurality of transistors, and the fifth conductive layer may at least include at least one anode connection electrode.

In an exemplary implementation mode, the semiconductor layer may be made of various materials, such as amorphous Indium Gallium Zinc Oxide (α-IGZO), Zinc Oxynitride (ZnON), Indium Zinc Tin Oxide (IZTO), amorphous Silicon (a-Si), polycrystalline Silicon (p-Si), hexathiophene, and polythiophene. That is, the present disclosure is applicable to transistors manufactured based on an oxide technology, a silicon technology, and an organic substance technology.

In an exemplary implementation mode, the first conductive layer, the second conductive layer, the third conductive layer, the fourth conductive layer, and the fifth conductive layer may be made of a metal material, such as any one or more of Argentum (Ag), Copper (Cu), Aluminum (Al), and Molybdenum (Mo), or an alloy material of the aforementioned metals, such as an Aluminum Neodymium alloy (AlNd) or a Molybdenum Niobium alloy (MoNb), and may be of a single-layer structure or a multi-layer composite structure, such as Mo/Cu/Mo.

In an exemplary implementation mode, the first insulation layer, the second insulation layer, the third insulation layer, and the fourth insulation layer may be made of any one or more of Silicon Oxide (SiOx), Silicon Nitride (SiNx), and Silicon Oxynitride (SiON), and may be a single layer, a multi-layer, or a composite layer. The first insulation layer and the second insulation layer may be referred to as Gate Insulation (GI) layers, the third insulation layer and the fourth insulation layer may be referred to as Interlayer Dielectric (ILD) layers, and the fifth insulation layer may be referred to as a Passivation (PVX) layer.

In an exemplary implementation mode, the first planarization layer, the second planarization layer, and the third planarization layer may be made of an organic material, such as resin.

In an exemplary implementation mode, after preparation of the drive circuit layer is completed, a light emitting structure layer is prepared on the drive circuit layer, and a preparation process of the light emitting structure layer may include following operations.

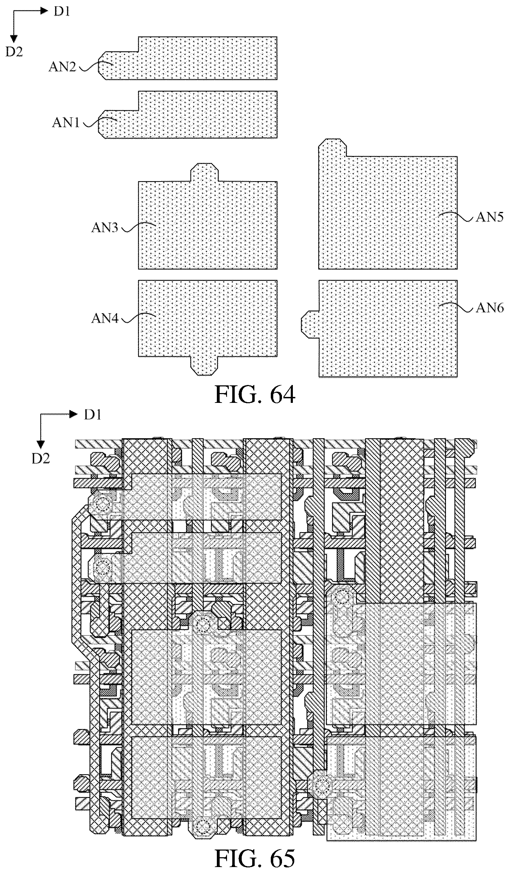

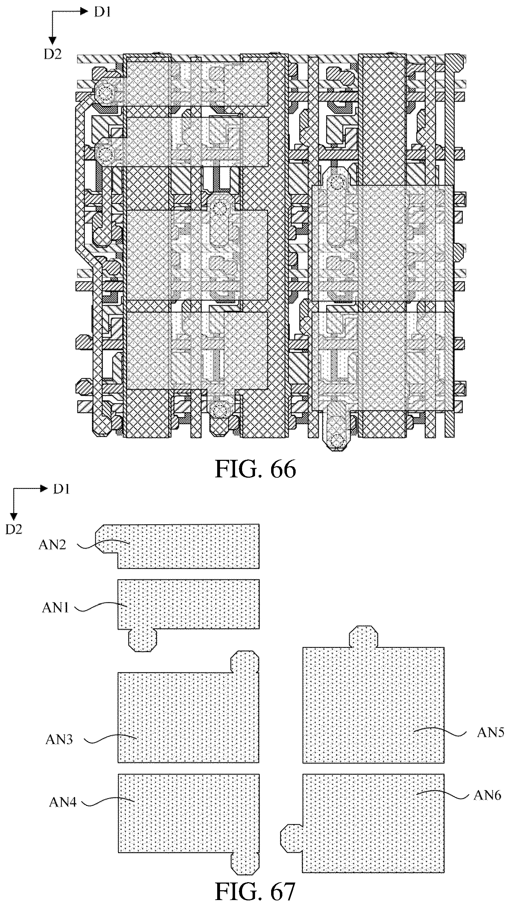

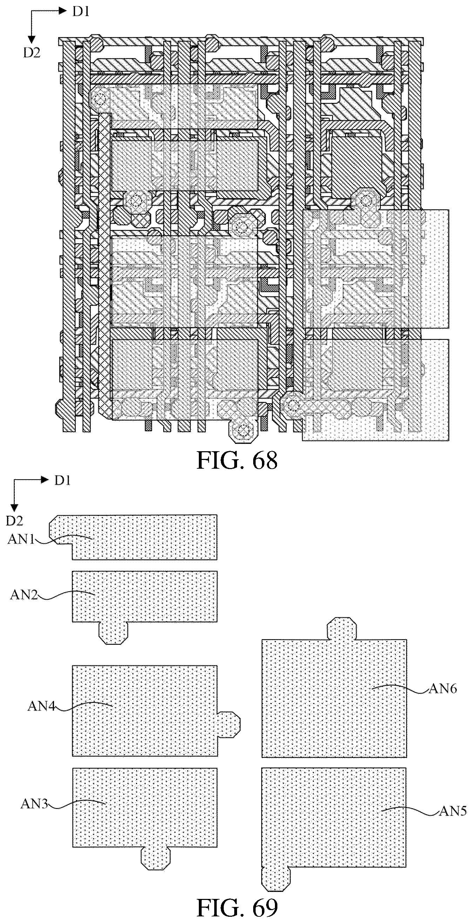

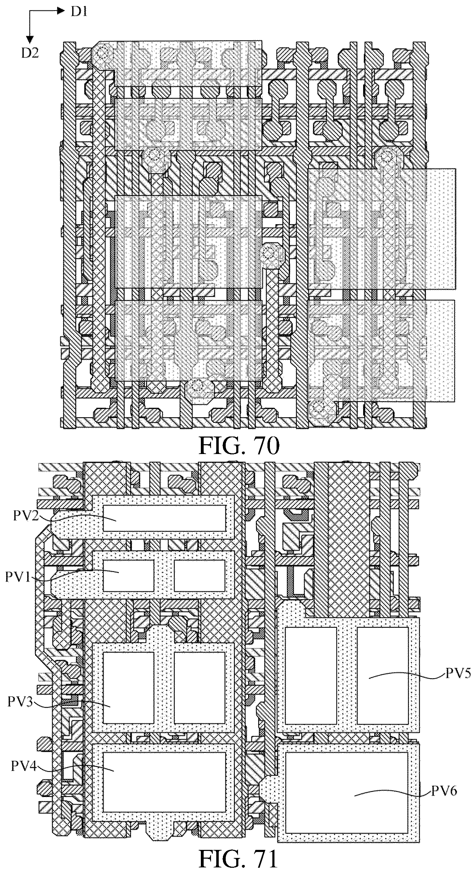

(11) A pattern of a sixth conductive layer is formed. In an exemplary implementation mode, forming a pattern of a sixth conductive layer may include depositing a sixth conductive thin film on the base substrate on which the aforementioned patterns are formed, and patterning the sixth conductive thin film through a patterning process, to forming a sixth conductive layer provided on the third planarization layer, as shown in FIGs. 64 to 70. FIG. 64 is a schematic diagram of a pattern of a sixth conductive layer in the display substrate provided in FIGs. 3 and 5. FIG. 65 is a schematic diagram of the display substrate provided in FIG. 3 after a pattern of a sixth conductive layer is formed. FIG. 66 is a schematic diagram of the display substrate provided in FIG. 5 after a pattern of a sixth conductive layer is formed. FIG. 67 is a schematic diagram of a pattern of a sixth conductive layer in the display substrate provided in FIG. 7. FIG. 68 is a schematic diagram of the display substrate provided in FIG. 7 after a pattern of a sixth conductive layer is formed. FIG. 69 is a schematic diagram of a pattern of a sixth conductive layer in the display substrate provided in FIG. 9. FIG. 70 is a schematic diagram of the display substrate provided in FIG. 9 after a pattern of a sixth conductive layer is formed.

In an exemplary implementation mode, as shown in FIGs. 64 to 70, in the display substrate provided in FIGs. 3, 5, 7, and 9, the pattern of the sixth conductive layer may at least include a first electrode AN1 of the first sub-pixel to a sixth electrode AN6 of the sixth sub-pixel.

In an exemplary implementation mode, in the display substrate provided in FIGs. 3, 5, and 7, the first electrode AN1 of the first sub-pixel is connected with the first anode connection line through the twenty-first via. The first electrode AN2 of the second sub-pixel is connected with the second anode connection line through the twenty-second via. The first electrode AN3 of the third sub-pixel is connected with the third anode connection line through the twenty-third via. The first electrode AN4 of the fourth sub-pixel is connected with the fourth anode connection line through the twenty-fourth via. The first electrode AN5 of the fifth sub-pixel is connected with the fifth anode connection line through the twenty-fifth via. The first electrode AN6 of the sixth sub-pixel is connected with the sixth anode connection line through the twenty-sixth via.

In an exemplary implementation mode, in the display substrate provided in FIG. 9, the first electrode AN1 of the first sub-pixel is connected with the first anode connection line through the twenty-seventh via. The first electrode AN2 of the second sub-pixel is connected with the second anode connection line through the twenty-eighth via. The first electrode AN3 of the third sub-pixel is connected with the third anode connection line through the twenty-ninth via. The first electrode AN4 of the fourth sub-pixel is connected with the fourth anode connection line through the thirtieth via. The first electrode AN5 of the fifth sub-pixel is connected with the fifth anode connection line through the thirty-first via. The first electrode AN6 of the sixth sub-pixel is connected with the sixth anode connection line through the thirty-second via.

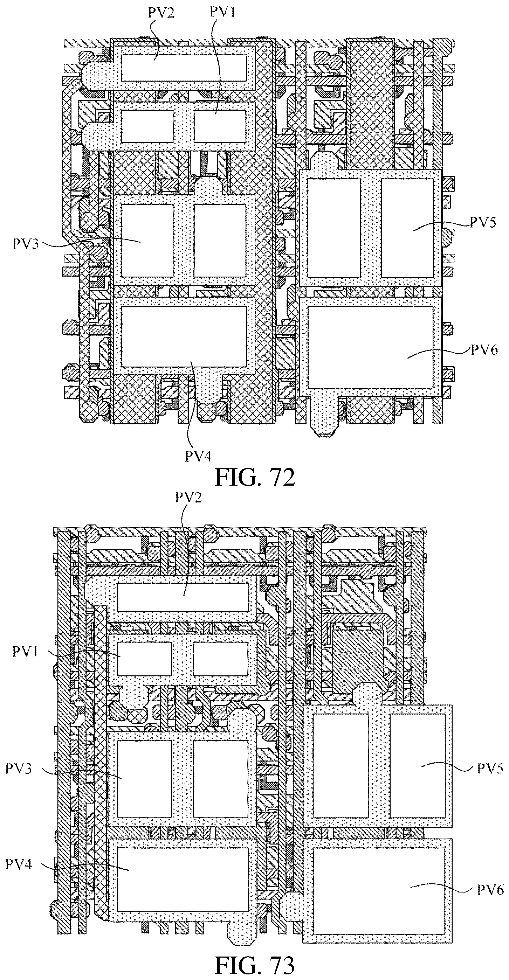

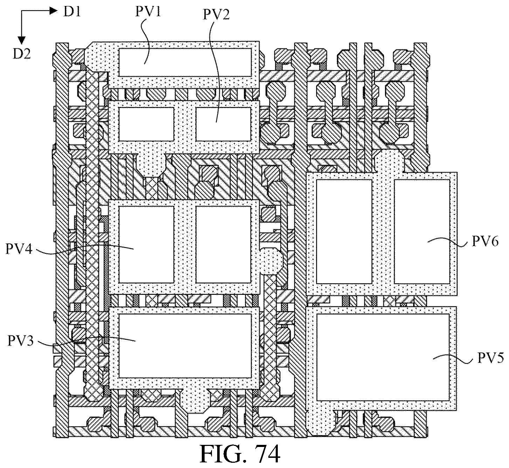

(12) A pattern of a pixel definition layer is formed. In an exemplary implementation mode, forming a pattern of a pixel definition layer may include coating a pixel definition thin film on the base substrate on which the aforementioned patterns are formed, and patterning the pixel definition thin film through a patterning process, to form a pixel definition layer. The pixel definition layer is provided with multiple pixel openings, as shown in FIGs. 71 to 74. FIG. 71 is a schematic diagram of the display substrate provided in FIG. 3 after a pixel definition layer is formed. FIG. 72 is a schematic diagram of the display substrate provided in FIG. 5 after a pixel definition layer is formed. FIG. 73 is a schematic diagram of the display substrate provided in FIG. 7 after a pixel definition layer is formed. FIG. 74 is a schematic diagram of the display substrate provided in FIG. 9 after a pixel definition layer is formed.

In an exemplary implementation mode, as shown in FIGs. 71 to 74, in the display substrate provided in FIGs. 3, 5, 7, and 9, the multiple openings of the pixel definition layer include a first pixel opening PV1 to a sixth pixel opening PV6.

In an exemplary implementation mode, as shown in FIGs. 71 to 74, the first pixel opening PV1 exposes the first electrode of the first sub-pixel, the second pixel opening PV1 exposes the first electrode of the second sub-pixel, the third pixel opening PV3 exposes the first electrode of the third sub-pixel, the fourth pixel opening PV4 exposes the first electrode of the fourth sub-pixel, the fifth pixel opening PV5 exposes the first electrode of the fifth sub-pixel, and the sixth pixel opening PV6 exposes the first electrode of the sixth sub-pixel.

In an exemplary implementation mode, a subsequent preparation process may include forming an organic emitting layer using an evaporation process or an inkjet printing process at first, subsequently forming a cathode on the organic emitting layer, then forming an encapsulation structure layer, and then forming an optical structure layer on the encapsulation structure layer.

In an exemplary implementation mode, the sixth conductive layer may be made of a metal material or a transparent conductive material, and the metal material may include any one or more of Argentum (Ag), Copper (Cu), Aluminum (Al), Titanium (TI), and Molybdenum (Mo), or an alloy material of the above metals, and the transparent conductive material may include Indium Tin Oxide (ITO) or Indium Zinc Oxide (IZO). In an exemplary implementation mode, the anode conductive layer may be of a single-layer structure or a multi-layer composite structure, such as ITO/Al/ITO.

In an exemplary implementation mode, a material of the pixel definition layer may include polyimide, acrylic, or polyethylene terephthalate, etc.

In an exemplary implementation mode, the cathode may be made of any one or more of Magnesium (Mg), Argentum (Ag), Aluminum (Al), Copper (Cu), and Lithium (Li), or an alloy made of any one or more of the above metals.

The present disclosure also provides a display apparatus which includes the aforementioned display substrate. The display apparatus may be any product or component with a display function, such as a mobile phone, a tablet computer, a television, a display, a laptop computer, a digital photo frame, or a navigator, which is not limited in the embodiments of the present invention.

The drawings of the embodiments of the present disclosure only involve structures involved in the embodiments of the present disclosure, and other structures may be referred to general designs.

For the sake of clarity, a thickness and size of a layer or a micro structure are enlarged in the accompanying drawings used for describing the embodiments of the present disclosure. It may be understood that when an element such as a layer, film, region, or substrate is described as being "on" or "under" another element, the element may be "directly" located "on" or "under" the another element, or there may be an intermediate element.

Although implementation modes of the present disclosure are disclosed above, described contents are only implementation modes used for ease of understanding of the present disclosure, but not intended to limit the present disclosure. Any of those skilled in the art of the present disclosure may make any modification and variation in modes and details of implementation without departing from the spirit and scope of the present disclosure. However, the protection scope of the present disclosure should be subject to the scope defined in the appended claims.

**Claims**

1. A display substrate, comprising a base substrate and pixel units arranged in an array provided on the base substrate, wherein at least one pixel unit comprises a plurality of sub-pixels, the plurality of sub-pixels comprise at least one peep-proof sub-pixel and at least one shared sub-pixel, at least one sub-pixel comprises a pixel drive circuit and a light emitting device, the pixel drive circuit is configured to drive the light emitting device to emit light, a display mode of the display substrate comprises a first display mode and a second display mode, and a viewing angle range of the first display mode is smaller than a viewing angle range of the second display mode; and

   in a state in which the display mode of the display substrate is the first display mode, the peep-proof sub-pixel emits light; and in a state in which the display mode of the display substrate is the second display mode, the shared sub-pixel emits light, or the peep-proof sub-pixel and the shared sub-pixel emit light.

2. The display substrate according to claim 1, wherein the plurality of sub-pixels in the at least one pixel unit comprise a first sub-pixel to a sixth sub-pixel;

   a pixel drive circuit in the first sub-pixel to a pixel drive circuit in the sixth sub-pixel located in a same pixel unit are arranged in an array along a first direction and a second direction or are arranged along a first direction, the first sub-pixel and the second sub-pixel emit light of a first color, the third sub-pixel and the fourth sub-pixel emit light of a second color, the fifth sub-pixel and the sixth sub-pixel emit a light of a third color, and the first direction intersects with the second direction; and

one sub-pixel of the first sub-pixel and the second sub-pixel is a peep-proof sub-pixel, and the other sub-pixel of the first sub-pixel and the second sub-pixel is a shared sub-pixel; one sub-pixel of the third sub-pixel and the fourth sub-pixel is a peep-proof sub-pixel, and the other sub-pixel of the third sub-pixel and the fourth sub-pixel is a shared sub-pixel; and one sub-pixel of the fifth sub-pixel and the sixth sub-pixel is a peep-proof sub-pixel, and the other sub-pixel of the fifth sub-pixel and the sixth sub-pixel is a shared sub-pixel.

3. The display substrate according to claim 1, wherein the light emitting device comprises a first electrode, wherein the display substrate is further provided with a pixel definition layer, and the pixel definition layer is provided with a pixel opening that exposes the first electrode;

for a peep-proof sub-pixel and a shared sub-pixel emitting light of a same color, an area of a first electrode in the peep-proof sub-pixel is equal to an area of a first electrode in the shared sub-pixel, and an area of a pixel opening that exposes the first electrode of the peep-proof sub-pixel is smaller than an area of a pixel opening that exposes the first electrode of the shared sub-pixel; and

the pixel opening that exposes the first electrode of the peep-proof sub-pixel comprises at least two sub-pixel openings, and the at least two sub-pixel openings are arranged along a first direction.

4. The display substrate according to claim 2, wherein the light emitting device comprises a first electrode;

for at least one pixel unit, a light emitting device of the first sub-pixel, a light emitting device of the second sub-pixel, a light emitting device of the third sub-pixel, and a light emitting device of the fourth sub-pixel are arranged along the second direction; a light emitting device of the fifth sub-pixel and a light emitting device of the sixth sub-pixel are arranged along the second direction; the light emitting device of the third sub-pixel and the light emitting device of the fifth sub-pixel are arranged along the first direction; and the light emitting device of the fourth sub-pixel and the light emitting device of the sixth sub-pixel are arranged along the first direction; and

an area of a first electrode of the fifth sub-pixel and an area of a first electrode of the sixth sub-pixel are greater than an area of a first electrode of the third sub-pixel and an area of a first electrode of the fourth sub-pixel, and the area of the first electrode of the third sub-pixel and the area of the first electrode of the fourth sub-pixel are greater than an area of a first electrode of the first sub-pixel and an area of a first electrode of the second sub-pixel.

5. The display substrate according to claim 2, further comprising a drive structure layer, a light emitting structure layer, an encapsulation layer, and an optical structure layer sequentially stacked on the base substrate, wherein the pixel drive circuit is provided on the drive structure layer, the light emitting device is provided on the light emitting structure layer, and the optical structure layer comprises at least one of a light shielding structure layer and an optical device layer; and the optical device layer is located on a side of the light shielding structure layer close to the base substrate or away from the base substrate.

6. The display substrate according to claim 5, wherein the light shielding structure layer comprises a first light shielding layer, a light shielding base substrate layer, and a second light shielding layer; the first light shielding layer is located on a side of the light shielding base substrate layer close to the base substrate, and the second light shielding layer is located on a side of the light shielding base substrate layer away from the base substrate; the first light shielding layer comprises a plurality of first light shielding structures, and the second light shielding layer comprises a plurality of second light shielding structures; and the light emitting structure layer comprises an organic emitting layer of a light emitting device of at least one sub-pixel; and

an orthographic projection of the first light shielding layer on the base substrate is at least partially overlapped with an orthographic projection of the second light shielding layer on the base substrate; the first light shielding structures and the second light shielding structures are located in a peep-proof sub-pixel region, and orthographic projections of the first light shielding structures and the second light shielding structures on the base substrate are partially overlapped with an orthographic projection of an organic emitting layer of at least one peep-proof sub-pixel on the base substrate; and the peep-proof sub-pixel region is a region where the peep-proof sub-pixel is located.

7. The display substrate according to claim 5, wherein the optical device layer comprises an optical base substrate layer and a plurality of optical devices; the optical devices are located on a side of the optical base substrate layer close to or away from the base substrate, and configured to converge incident light; and the light emitting structure layer comprises an organic emitting layer of a light emitting device of at least one sub-pixel; and

orthographic projections of the optical devices on the base substrate are at least partially overlapped with an orthographic projection of an organic emitting layer of the peep-proof sub-pixel on the base substrate.

8. The display substrate according to claim 5, further comprising a plurality of signal lines and a plurality of anode connection lines, wherein the pixel drive circuit is electrically connected with the plurality of signal lines and the plurality of anode connection lines respectively; the drive structure layer comprises a semiconductor layer, a first conductive layer, a second conductive layer, a third conductive layer, a fourth conductive layer, and a fifth conductive layer sequentially stacked on the base substrate; the pixel drive circuit comprises at least one transistor and at least one capacitor; and the transistor comprises an active pattern, a gate electrode, a first electrode, and a second electrode, and the capacitor comprises a first electrode plate and a second electrode plate;

the semiconductor layer at least comprises an active pattern of at least one transistor located in at least one sub-pixel;
the first conductive layer at least comprises at least one signal line of the plurality of signal lines, and a gate electrode of at least one transistor and a first electrode plate of at least one capacitor located in at least one sub-pixel;
the second conductive layer at least comprises at least one signal line of the plurality of signal lines, and a second electrode plate of at least one capacitor located in at least one sub-pixel;
the third conductive layer at least comprises at least one signal line of the plurality of signal lines, and a first electrode and a second electrode of at least one transistor located in at least one sub-pixel;
the fourth conductive layer at least comprises at least one signal line of the plurality of signal lines; and
the fifth conductive layer at least comprises at least one anode connection line of the plurality of anode connection lines.

9. The display substrate according to claim 8, wherein for at least one pixel unit, the pixel drive circuit of the first sub-pixel, the pixel drive circuit of the third sub-pixel, and the pixel drive circuit of the fifth sub-pixel are arranged sequentially along the first direction; the pixel drive circuit of the second sub-pixel, the pixel drive circuit of the fourth sub-pixel, and the pixel drive circuit of the sixth sub-pixel are arranged sequentially along the first direction; the pixel drive circuit of the first sub-pixel and the pixel drive circuit of the second sub-pixel are arranged along the second direction; the pixel drive circuit of the third sub-pixel and the pixel drive circuit of the fourth sub-pixel are arranged along the second direction; and the pixel drive circuit of the fifth sub-pixel and the pixel drive circuit of the sixth sub-pixel are arranged along the second direction.

10. The display substrate according to claim 9, wherein the plurality of signal lines comprise 2M reset signal lines, 2M scan signal lines, 2M light emitting signal lines, 2M first initial signal lines, 2M second initial signal lines, 3N first power supply lines, and 3N data signal lines, wherein M is a total number of rows of pixel units, and N is a total number of columns of pixel units;

at least one signal line of the reset signal lines, the scan signal lines, the light emitting signal lines, the first initial signal lines, and the second initial signal lines extends at least partially along the first direction; at least one signal line of the first power supply lines and the data signal lines extends at least partially along the second direction; and line widths of the first power supply lines are greater than line widths of the data signal lines; and
a pixel unit in an $i$-th row and a $j$-th column is electrically connected with a $(2i-1)$-th scan signal line, a $2i$-th scan signal line, a $(2i-1)$-th reset signal line, a $2i$-th reset signal line, a $(2i-1)$-th light emitting signal line, a $2i$-th light emitting signal line, a $(2i-1)$-th first initial signal line, a $2i$-th first initial signal line, a $(2i-1)$-th second initial signal line, a $2i$-th second initial signal line, a $(3j-2)$-th first power supply line, a $(3j-1)$-th first power supply line, a $3j$-th first power supply line, a $(3j-2)$-th data signal line, a $(3j-1)$-th data signal line, and a $3j$-th data signal line, respectively, wherein $1 \leq i \leq M$ and $1 \leq j \leq N$.

11. The display substrate according to claim 10, wherein for at least one pixel unit, pixel structures of pixel drive circuits of at least two sub-pixels of the first sub-pixel to the sixth sub-pixel are at least partially the same.

12. The display substrate according to claim 10, wherein in the pixel unit in the $i$-th row and the $j$-th column, at least one sub-pixel of the first sub-pixel, the third sub-pixel, and the fifth sub-pixel is electrically connected with the $(2i-1)$-th scan signal line, the $(2i-1)$-th light emitting signal line, the $(2i-1)$-th reset signal line, the $(2i-1)$-th first initial signal line, and the $(2i-1)$-th second initial signal line, respectively; at least one sub-pixel of the second sub-pixel, the fourth sub-pixel, and the sixth sub-pixel is electrically connected with the $2i$-th scan signal line, the $2i$-th light emitting signal line, the $2i$-th reset signal line, the $2i$-th first initial signal line, and the $2i$-th second initial signal line, respectively; at least one sub-pixel of the first sub-pixel and the second sub-pixel is further electrically connected with the $(3j-2)$-th first power supply line and the $(3j-2)$-th data signal line, respectively; at least one sub-pixel of the third sub-pixel and the fourth sub-pixel is further electrically connected with the $(3j-1)$-th first power supply line and the $(3j-1)$-th data signal line, respectively;

and at least one sub-pixel of the fifth sub-pixel and the sixth sub-pixel is further electrically connected with the 3j-th first power supply line and the 3j-th data signal line, respectively.

13. The display substrate according to claim 10, wherein orthographic projections of a first initial signal line, a second initial signal line, a reset signal line, a scan signal line, and a light emitting signal line connected with a same sub-pixel on the base substrate are sequentially arranged along the second direction; and
an orthographic projection of a k-th data signal line on the base substrate is located between an orthographic projection of a k-th first power supply line on the base substrate and an orthographic projection of a (k+1)-th first power supply line on the base substrate, wherein 1≤k≤3N.

14. The display substrate according to claim 10, wherein the at least one transistor comprises a node reset transistor, a drive transistor, and a compensation transistor; and a second electrode of the node reset transistor and a first electrode of the compensation transistor are of an integral structure and are electrically connected with a gate electrode of the drive transistor; and
an orthographic projection of a first power supply line on the base substrate is at least partially overlapped with an orthographic projection of the integral structure of the second electrode of the node reset transistor and the first electrode of the compensation transistor in a sub-pixel connected with the first power supply line on the base substrate.

15. The display substrate according to claim 10, wherein a first power supply line comprises a first sub-power supply line and a second sub-power supply line connected with each other; the first sub-power supply line and the second sub-power supply line extend along the second direction; and an orthographic projection of the first sub-power supply line on the base substrate is at least partially overlapped with an orthographic projection of the second sub-power supply line on the base substrate; and
the light emitting signal lines are located on the first conductive layer, the first initial signal lines and the second initial signal lines are located on the second conductive layer, the reset signal lines and the scan signal lines are located on the third conductive layer, the first sub-power supply line is located on the fourth conductive layer, the second sub-power supply line is located on the fifth conductive layer, and the data signal lines are located on the fourth conductive layer or the fifth conductive layer.

16. The display substrate according to claim 9, wherein the plurality of signal lines comprise 2M reset signal lines, 2M scan signal lines, 2M light emitting signal lines, 2M first initial signal lines, 2M second initial signal lines, 4N first power supply lines, and 6N data signal lines, wherein M is a total number of rows of pixel units, N is a total number of columns of pixel units;

at least one signal line of the reset signal lines, the scan signal lines, the light emitting signal lines, the first initial signal lines, and the second initial signal lines extends at least partially along the first direction; and at least one signal line of the first power supply lines and the data signal lines extends at least partially along the second direction; and
a pixel unit in an i-th row and a j-th column is electrically connected with a (2i-1)-th scan signal line, a 2i-th scan signal line, a (2i-1)-th reset signal line, a 2i-th reset signal line, a (2i-1)-th light emitting signal line, a 2i-th light emitting signal line, a (2i-1)-th first initial signal line, a 2i-th first initial signal line, a (2i-1)-th second initial signal line, a 2i-th second initial signal line, a (4j-3)-th first power supply line, a (4j-2)-th first power supply line, a (4j-1)-th first power supply line, a 4j-th first power supply line, a (6j-5)-th data signal line, a (6j-4)-th data signal line, a (6j-3)-th data signal line, a (6j-2)-th data signal line, a (6j-1)-th data signal line, and a 6j-th data signal line, respectively, wherein 1≤i≤M and 1≤j≤N.

17. The display substrate according to claim 16, wherein for at least one pixel unit, pixel structures of pixel drive circuits of at least two sub-pixels of the first sub-pixel, the third sub-pixel, and the fifth sub-pixel are at least partially the same; pixel structures of pixel drive circuits of at least two sub-pixels of the second sub-pixel, the fourth sub-pixel, and the sixth sub-pixel are at least partially the same; and a pixel structure of the pixel drive circuit of the first sub-pixel is at least partially mirror symmetrical to a pixel structure of the pixel drive circuit of the second sub-pixel.

18. The display substrate according to claim 16, wherein in the pixel unit in the i-th row and the j-th column, at least one sub-pixel of the first sub-pixel, the third sub-pixel, and the fifth sub-pixel is electrically connected with the (2i-1)-th scan signal line, the (2i-1)-th light emitting signal line, the (2i-1)-th reset signal line, the (2i-1)-th first initial signal line, and the (2i-1)-th second initial signal line, respectively; at least one sub-pixel of the second sub-pixel, the fourth sub-pixel, and the sixth sub-pixel is electrically connected with the 2i-th scan signal line, the 2i-th light emitting signal line, the 2i-th reset signal line, the 2i-th first initial signal line, and the 2i-th second initial signal line, respectively; the first sub-pixel is further electrically connected with the (6j-4)-th data signal line and the (4j-2)-th first power supply line; the second sub-pixel is further electrically connected with the (6j-5)-th data signal line and the (4j-3)-th first power supply line; the third sub-pixel is further electrically connected with the (6j-2)-th data signal line and the (4j-1)-th first power supply line, respectively; the fourth sub-pixel is further electrically connected with the (6j-3)-th data signal line and the (4j-2)-th first power supply line, respectively; the fifth sub-pixel is further electrically connected with the 6j-th data signal line and the 4j-th first power supply line, respectively; and the sixth sub-pixel is further electrically connected with the (6j-1)-th data signal line and the (4j-1)-th first power supply line, respectively.

19. The display substrate according to claim 16, wherein orthographic projections of a first initial signal line, a second initial signal line, a reset signal line, a scan signal line, and a light emitting signal line connected with a same sub-pixel on the base substrate are sequentially arranged along the second direction; and
for at least one pixel unit, orthographic projections of two data signal lines connected with two sub-pixels arranged along the second direction on the base substrate are located between orthographic projections of two first power supply lines connected with the two sub-pixels on the base substrate.

20. The display substrate according to claim 16, wherein the at least one transistor comprises a node reset transistor, a drive transistor, and a compensation transistor; a second electrode of the node reset transistor and a first electrode of the compensation transistor are of an integral structure and are electrically connected with a gate electrode of the drive transistor; and the capacitor further comprises a third electrode plate, the third electrode plate is electrically connected with the second electrode plate and located on the fourth conductive layer;

for at least one sub-pixel, an orthographic projection of the third electrode plate on the base substrate is at least partially overlapped with an orthographic projection of the integral structure of the second electrode of the node reset transistor and the first electrode of the compensation transistor on the base substrate; and orthographic projections of third electrode plates of two sub-pixels arranged along the second direction on the base substrate are located between orthographic projections of two data signal lines connected with the two sub-pixels arranged along the second direction on the base substrate.

21. The display substrate according to claim 16, wherein the light emitting signal lines are located on the first conductive layer, the first initial signal lines and the second initial signal lines are located on the second conductive layer, the reset signal lines and the scan signal lines are located on the third conductive layer, and the data signal lines and the first power supply lines are located on the fourth conductive layer.

22. The display substrate according to claim 8, wherein for at least one pixel unit, the pixel drive circuit of the first sub-pixel, the pixel drive circuit of the second sub-pixel, the pixel drive circuit of the third sub-pixel, the pixel drive circuit of the fourth sub-pixel, the pixel drive circuit of the fifth sub-pixel, and the pixel drive circuit of the sixth sub-pixel are sequentially arranged along the first direction.

23. The display substrate according to claim 22, wherein the plurality of signal lines comprise 2M reset signal lines, 2M scan signal lines, 2M light emitting signal lines, M first initial signal lines, M second initial signal lines, 4N first power supply lines, and 6N data signal lines, wherein M is a total number of rows of pixel units, N is a total number of columns of pixel units;

at least one signal line of the reset signal lines, the scan signal lines, the light emitting signal lines, the first initial signal lines, and the second initial signal lines extends at least partially along the first direction; and at least one signal line of the first power supply lines and the data signal lines extends at least partially along the second direction; and
a pixel unit in an i-th row and a j-th column is electrically connected with a (2i-1)-th scan signal line, a 2i-th scan signal line, a (2i-1)-th reset signal line, a 2i-th reset signal line, a (2i-1)-th light emitting signal line, a 2i-th light emitting signal line, a i-th first initial signal line, a i-th second initial signal line, a (4j-3)-th first power supply line, a (4j-2)-th first power supply line, a (4j-1)-th first power supply line, a 4j-th first power supply line, a (6j-5)-th data signal line, a (6j-4)-th data signal line, a (6j-3)-th data signal line, a (6j-2)-th data signal line, a (6j-1)-th data signal line, and a 6j-th data signal line, respectively, wherein $1 \leq i \leq M$ and $1 \leq j \leq N$.

24. The display substrate according to claim 23, wherein for at least one pixel unit, pixel structures of pixel drive circuits of adjacent sub-pixels are at least partially symmetrical with respect to a virtual straight line extending along the second direction.

25. The display substrate according to claim 23, wherein in the pixel unit in the i-th row and the j-th column, at least one sub-pixel of the first sub-pixel to the sixth sub-pixel is electrically connected with the (2i-1)-th scan signal line, the 2i-th scan signal line, the (2i-1)-th reset signal line, the 2i-th reset signal line, the (2i-1)-th light emitting signal line, the 2i-th light emitting signal line, the i-th first initial signal line, and the i-th second initial signal line, respectively; the first sub-pixel is further electrically connected with the (6j-5)-th data signal line and the (4j-3)-th first power supply line, respectively; the second sub-pixel is further electrically connected with the (6j-4)-th data signal line and the (4j-2)-th first power supply line, respectively; the third sub-pixel is further electrically connected with the (6j-3)-th data signal line and the (4j-2)-th first power supply line, respectively; the fourth sub-pixel is further electrically connected with the (6j-2)-th data signal line and the (4j-1)-th first power supply line, respectively; the fifth sub-pixel is further electrically connected with the (6j-1)-th data signal line and the (4j-1)-th first power supply line, respectively; and the sixth sub-pixel is further electrically connected with the 6j-th data signal line and the 4j-th first power supply line, respectively.

26. The display substrate according to claim 23, wherein the at least one transistor comprises a first light emitting transistor, a second light emitting transistor, a node reset transistor, an anode reset transistor, a writing transistor, a compensation transistor, and a drive transistor;

the first light emitting transistor and the writing transistor are respectively electrically connected with a first electrode of the drive transistor; the second light emitting transistor is respectively electrically connected with a second electrode of the drive transistor and a first electrode of the light emitting device; the anode reset transistor is electrically connected with the first electrode of the light emitting device; the compensation transistor is respectively electrically connected with a gate electrode and a second electrode of the drive transistor; and the node reset transistor is electrically connected with the gate electrode of the drive transistor; and
for the pixel unit in the i-th row and the j-th column, a gate electrode of the first light emitting transistor in at least one sub-pixel is electrically connected with the (2i-1)-th light emitting signal line; a gate electrode of the second light emitting transistor is electrically connected with the 2i-th light emitting signal line; a gate electrode of the writing transistor is electrically connected with the (2i-1)-th scan signal line; a gate electrode of the compensation transistor is electrically connected with the 2i-th scan signal line, a gate electrode of the node reset transistor is electrically connected with the (2i-1)-th reset signal line; and a gate electrode of the anode reset transistor is electrically connected with the 2i-th reset signal line.

27. The display substrate according to claim 23, wherein for a pixel unit in the i-th row, orthographic projections of the (2i-1)-th light emitting signal line, the (2i-1)-th scan signal line, the 2i-th scan signal line, the (2j-1)-th reset signal line, the i-th first initial signal line, the 2i-th light emitting signal line, the 2i-th reset signal line, and the i-th second initial signal line on the base substrate are sequentially arranged along the second direction; and
for at least one pixel unit, orthographic projections of data signal lines connected with an x-th sub-pixel and an (x+1)-th sub-pixel on the base substrate are located between orthographic projections of first power supply lines connected with the x-th sub-pixel and the (x+1)-th sub-pixel on the base substrate, wherein 1≤x≤6 and x is an odd number.

28. The display substrate according to claim 23, wherein an odd-numbered scan signal line comprises a first sub-scan signal line and a second sub-scan signal line connected with each other; the first sub-scan signal line and the second sub-scan signal line extend along the first direction; and an orthographic projection of the first sub-scan signal line on the base substrate is at least partially overlapped with an orthographic projection of the second sub-scan signal line on the base substrate; and
the first sub-scan signal line is located on the first conductive layer, and the second sub-scan signal line is located on the third conductive layer.

29. The display substrate according to claim 23, wherein an even-numbered reset signal line comprises a first sub-reset signal line and a second sub-reset signal line connected with each other;
the first sub-reset signal line and the second sub-reset signal line extend along the first direction; and an orthographic projection of the first sub-reset signal line on the base substrate is at least partially overlapped with an orthographic projection of the second sub-reset signal line on the base substrate; and
the first sub-reset signal line is located on the first conductive layer, and the second sub-reset signal line is located on the third conductive layer.

30. The display substrate according to claim 23, wherein the light emitting signal lines are located on the first conductive layer, the first initial signal lines and the second initial signal lines are located on the second conductive layer, an even-numbered scan signal line and an odd-numbered reset signal line are located on the third conductive layer, and the data signal lines and the first power supply lines are located on the fourth conductive layer.

31. The display substrate according to claim 8, wherein the plurality of signal lines comprise a plurality of first initial signal lines and a plurality of second initial signal lines; and the display substrate further comprises at least one connection line of a first initial connection line and a second initial connection line;

the first initial connection line extends along the second direction and is located between adjacent pixel units, and the first initial connection line is electrically connected with the plurality of first initial signal lines; the second initial connection line extends along the second direction and is located between adjacent pixel units, and the second initial connection line is electrically connected with the plurality of second initial signal lines; and the first initial connection line and the second initial connection line are located on the fourth conductive layer or the fifth conductive layer.

32. The display substrate according to claim 2, further comprising a first multiplexing control signal line, a second multiplexing control signal line, 6N data signal lines, 3N data electrical power supply lines, and a data multiplexing circuit, wherein the data multiplexing circuit comprises N sub-multiplexing circuits, wherein N is a total number of columns of pixel units; and

an n-th sub-multiplexing circuit is electrically connected with three data electrical power supply lines, the first multiplexing control signal line, the second multiplexing control signal line, and six data signal lines connected with a pixel unit in an n-th column, respectively, and is configured to provide a signal of at least one data electrical power supply line to at least one data signal line under signal control of the first multiplexing control signal line and the second multiplexing control signal line, wherein 1≤n≤N.

33. The display substrate according to claim 32, wherein the n-th sub-multiplexing circuit comprises a first multiplexing transistor to a sixth multiplexing transistor;

a gate electrode of the first multiplexing transistor is electrically connected with the first multiplexing control signal line, a first electrode of the first multiplexing transistor is electrically connected with a data signal line connected with one sub-pixel of a first sub-pixel and a second sub-pixel in the pixel unit in the n-th column, and a second electrode of the first multiplexing transistor is electrically connected with a first data electrical power supply line of the three data electrical power supply lines connected with the n-th multiplexing sub-circuit;
a gate electrode of the second multiplexing transistor is electrically connected with the first multiplexing control signal line, a first electrode of the second multiplexing transistor is electrically connected with a data signal line connected with one of a third sub-pixel and a fourth sub-pixel in the pixel unit in the n-th column, and a second electrode of the second multiplexing transistor is electrically connected with a second data electrical power supply line of the three data electrical power supply lines connected with the n-th multiplexing sub-circuit;
a gate electrode of the third multiplexing transistor is electrically connected with the first multiplexing control signal line, a first electrode of the third multiplexing transistor is electrically connected with a data signal line connected with one of a fifth sub-pixel and a sixth sub-pixel in the pixel unit in the n-th column, and a second electrode of the third multiplexing transistor is electrically connected with a third data electrical power supply line of the three data electrical power supply lines connected with the n-th multiplexing sub-circuit;
a gate electrode of the fourth multiplexing transistor is electrically connected with the second multiplexing control signal line, a first electrode of the fourth multiplexing transistor is electrically connected with a data signal line connected with the other sub-pixel of the first sub-pixel and the second sub-pixel in the pixel unit in the n-th column, and a second electrode of the fourth multiplexing transistor is electrically connected with the first data electrical power supply line of the three data electrical power supply lines connected with the n-th multiplexing sub-circuit;
a gate electrode of the fifth multiplexing transistor is electrically connected with the second multiplexing control signal line, a first electrode of the fifth multiplexing transistor is electrically connected with a data signal line connected with the other sub-pixel of the third sub-pixel and the fourth sub-pixel in the pixel unit in the n-th column, and a second electrode of the fifth multiplexing transistor is electrically connected with the second data electrical power supply line of the three data electrical power supply lines connected with the n-th multiplexing sub-circuit; and
a gate electrode of the sixth multiplexing transistor is electrically connected with the second multiplexing control signal line, a first electrode of the sixth multiplexing transistor is electrically connected with a data signal line connected with the other sub-pixel of the fifth sub-pixel and the sixth sub-pixel in the pixel unit in the n-th column, and a second electrode of the sixth multiplexing transistor is electrically connected with the third data electrical power supply line of the three data electrical power supply lines connected with the n-th multiplexing sub-circuit.

34. A display apparatus, comprising a display substrate according to any one of claims 1 to 33.

FIG. 1A

FIG. 1B

FIG. 1C

FIG. 2

FIG. 3

FIG. 4

FIG. 5

FIG. 6

FIG. 7

FIG. 8

D1

D2

P1    P3    P5

INITL1(2i-1)
INITL2(2i-1)
RL(2i-1)

GL(2i-1)

C3

EL(2i-1)

INITL1(2i)

INITL2(2i)
RL(2i)

GL(2i-1)

EL(2i)

VDL(4j-3)
DL(6j-5)
P2
DL(6j-4)
VDL(4j-2)
DL(6j-3)
P4
DL(6j-2)
VDL(4j-1)
DL(6j-1)
P6
DL(6j)
VDL(4j)

FIG. 9

D1

D2

VDL(4j-3)
DL(6j-5)
DL(6j-4)
VDL(4j-2)
DL(6j-3)
DL(6j-2)
VDL(4j-1)
DL(6j-1)
DL(6j)
VDL(4j)

EL(2i-1)
GL1
GL(2i-1)

GL2

GL(2j)

RL(2j-1)
INITL1(i)
EL(2i)
RL1
RL(2i)
RL2
INITL2(i)

P1    P2    P3    P4    P5    P6

FIG. 10

SR    VR    SR    VR    SR    VR

610
620
530
510
520
300
200
100

531
521

600

500

400

L1    L2    L3    L4    L5    L6

FIG. 11A

FIG. 11B

FIG. 12A

P

DL1  DL2  DL3  DL4  DL5  DL6

MUX1  MT1  MT2  MT3

MUX2  MT4  MT5  MT6

DSL1  DSL2  DSL3

FIG. 12B

D1
D2

71  71-1  11-1  11-2  21-2  21-1  41-1  31-2/  61-1  31-1/  41-2/  51-2  61-2/  71-2  51-1

11  21  31  4l  61  5l

FIG. 13

FIG. 14

FIG. 15

FIG. 16

FIG. 17

D1

D2

12  72

22

42

32/C1

EL(2i-1)

62  52

72  12

22

42

32/C1

EL(2i)

52  62

FIG. 18

D1

D2

FIG. 19

FIG. 20

FIG. 21

FIG. 22

FIG. 23

D1

D2

INITL1(2i-1)

INITL2(2i-1)

C22

K1

C2

C21

K2

INITL1(2i)

INITL2(2i)

## FIG. 24

D1

D2

## FIG. 25

D1

D2

C2

K

INITL1(i)

INITL2(i)

**FIG. 26**

D1

D2

**FIG. 27**

FIG. 28

FIG. 29

H6 H5
H7
H13
H4
H15
H12
H3
H11
H2
H10
H1
H16
H8
H14
H9
H17

## FIG. 30

D1
D2

73 13

RL(2i-1)

43
GL(2i-1)
14/23
53C
53D
53A
53B
64/74 53

RL(2i)

GL(2i)

## FIG. 31

FIG. 32

FIG. 33

D1

D2

FIG. 34

D1

D2

53  43

54

GL2(2i-1)

33/44

VL

CL41

24/34/63

GL(2i)

14/23

RL(2i-1)

13

64/74

RL2(2i)

73

FIG. 35

D1

D2

FIG. 36

D1

D2

V17

V14

V15

V16

FIG. 37

FIG. 38

FIG. 39

D1

D2

VDL1(3j-2)  VDL1(3j-1)  VDL1(3j)  NL

CL

DL(3j-2)  DL(3j-1)  DL(3j)

FIG. 40

D1

D2

FIG. 41

FIG. 42

FIG. 43

FIG. 44

FIG. 45

FIG. 46

FIG. 47

V19
V18

FIG. 48

D1
D2

V20

V19
V18

FIG. 49

FIG. 50

FIG. 51

D1

D2

VDL2(3j-2)  VDL2(3j-1)  VDL2(3j)

AL1

AL3  AL5

AL2

AL4  AL6

FIG. 52

D1

D2

FIG. 53

FIG. 54

FIG. 55

FIG. 56

FIG. 57

FIG. 58

FIG. 59

FIG. 60

FIG. 61

FIG. 62

FIG. 63

D1

D2

AN2

AN1

AN3

AN4

AN5

AN6

FIG. 64

D1

D2

FIG. 65

FIG. 66

FIG. 67

FIG. 68

FIG. 69

D1

D2

FIG. 70

FIG. 71

FIG. 72

FIG. 73

FIG. 74

## INTERNATIONAL SEARCH REPORT

| International application No. |
| --- |
| **PCT/CN2023/128430** |

### A. CLASSIFICATION OF SUBJECT MATTER

H10K59/121(2023.01)i; H10K59/50(2023.01)i; H10K59/80(2023.01)i; G09F9/33(2006.01)i

According to International Patent Classification (IPC) or to both national classification and IPC

### B. FIELDS SEARCHED

Minimum documentation searched (classification system followed by classification symbols)

IPC: H10K G09F

Documentation searched other than minimum documentation to the extent that such documents are included in the fields searched

Electronic data base consulted during the international search (name of data base and, where practicable, search terms used)

CNABS, CNTXT, CNKI, VEN, USTXT, EPTXT, WOTXT: 显示, 像素, 防窥, 共享, 光线, 角度, 面积, 范围, 电极, display, pixel, privacy, peep, share, light, angle, area, range, electrode

### C. DOCUMENTS CONSIDERED TO BE RELEVANT

| Category* | Citation of document, with indication, where appropriate, of the relevant passages | Relevant to claim No. |
| --- | --- | --- |
| X | CN 116528623 A (BOE TECHNOLOGY GROUP CO., LTD.) 01 August 2023 (2023-08-01) description, paragraphs [0062]-[0145], and figures 1-14 | 1-3, 5-34 |
| X | CN 116828896 A (BOE TECHNOLOGY GROUP CO., LTD.) 29 September 2023 (2023-09-29) description, paragraphs [0102]-[0215], and figures 1-47 | 1-3, 5-34 |
| A | CN 116528623 A (BOE TECHNOLOGY GROUP CO., LTD.) 01 August 2023 (2023-08-01) description, paragraphs [0062]-[0145], and figures 1-14 | 4 |
| A | CN 116828896 A (BOE TECHNOLOGY GROUP CO., LTD.) 29 September 2023 (2023-09-29) description, paragraphs [0102]-[0215], and figures 1-47 | 4 |
| A | CN 115843199 A (HKC CO., LTD.) 24 March 2023 (2023-03-24) entire document | 1-34 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **27 June 2024** | **02 July 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/128430**

| Patent document cited in search report | | | Publication date (day/month/year) | Patent family member(s) | | | Publication date (day/month/year) |
|---|---|---|---|---|---|---|---|
| CN | 116528623 | A | 01 August 2023 | None | | | |
| CN | 116828896 | A | 29 September 2023 | None | | | |
| CN | 115843199 | A | 24 March 2023 | CN | 115843199 | B | 02 May 2023 |

Form PCT/ISA/210 (patent family annex) (July 2022)